# EUROPEAN PATENT APPLICATION

(11) **EP 1 777 736 A1**
(43) Date of publication of application: **25.04.2007**
(21) Application number: 06019257.2
(22) Date of filing: 21.02.2002
(51) Int. Cl.: H01L 21/306, H01L 21/00, C25F 7/00, B23H 5/08, C25D 17/00, C25D 7/12

(54) **Electrolytic processing device and substrate processing apparatus**

(30) Priority: 18.06.2001 JP 2001183822; 31.08.2001 JP 2001264368; 28.12.2001 JP 2001401436
(62) Divisional of application: 02700668.3
(71) Applicant: EBARA CORPORATION, Ohta-ku, Tokyo (JP)
(72) Inventor: Kobata, Itsuki, Ohta-ku Tokyo 144-8510 (JP); Shirakashi, Mitsuhiko, Ohta-ku Tokyo 144-8510 (JP); Kumekawa, Masayuki, Ohta-ku Tokyo 144-8510 (JP); Saito, Takayuki, Fujisawa-shi Kanagawa 251-8502 (JP); Toma, Yasushi, Fujisawa-shi Kanagawa 251-8502 (JP); Suzuki, Tsukuru, Fujisawa-shi Kanagawa 251-8502 (JP); Yamada, Kaoru, Fujisawa-shi Kanagawa 251-8502 (JP); Makita, Yuji, Fujisawa-shi Kanagawa 251-8502 (JP)
(74) Representative: Emde, Eric

(57) **Abstract**

There is provided an electrolytic processing device including: a processing electrode brought into contact with or close to a workpiece; a feeding electrode for supplying electricity to the workpiece; an ion exchanger disposed in at least one of the spaces between the workpiece and the processing electrode, and between the workpiece and the feeding electrode; a power source for applying a voltage between the processing electrode and the feeding electrode; and a liquid supply section for supplying a liquid to the space between the workpiece and at least one of the processing electrode and the feeding electrode, in which the ion exchanger is present. A substrate processing apparatus having the electrolytic processing device is also provided.

## Description

### Technical Field

This invention relates to an electrolytic processing device and a substrate processing apparatus provided with the electrolytic processing device, and more particularly to an electrolytic processing device useful for processing a conductive material present in the surface of a substrate, especially a semiconductor wafer, or for removing impurities adhering to the surface of a substrate, and a substrate processing apparatus provided with the electrolytic processing device.

### Background Art

In recent years, instead of using aluminum or aluminum alloys as a material for forming interconnection circuits on a substrate such as a semiconductor wafer, there is an eminent movement towards using copper (Cu) which has a low electric resistance and high electromigration resistance. Copper interconnects are generally formed by filling copper into fine recesses formed in the surface of a substrate. There are known various techniques for forming such copper interconnects, including CVD, sputtering, and plating. According to any such technique, a copper film is formed in the substantially entire surface of a substrate, followed by removal of unnecessary copper by chemical mechanical polishing (CMP).

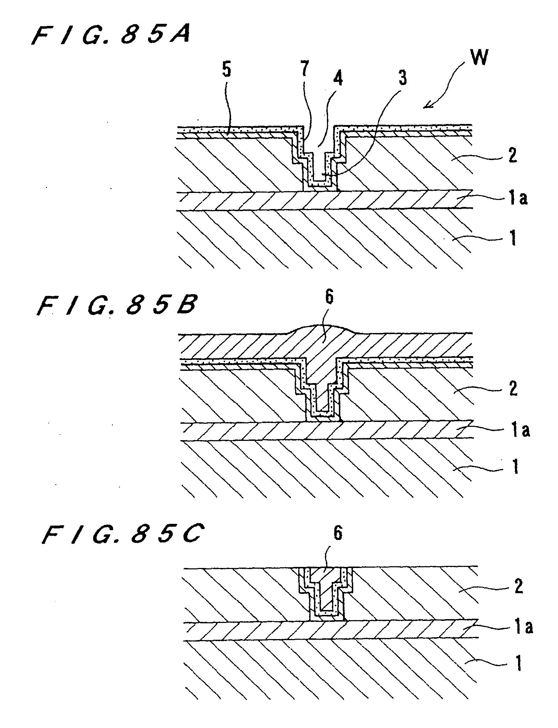

FIGS. 85A through 85C illustrate, in sequence of process steps, an example of forming such a substrate W having copper interconnects. As shown in FIG. 85A, an insulating film 2, such as a silicon oxide film/a film of silicon oxide (SiO₂) or a film of low-k material, is deposited on a conductive layer 1a in which electronic devices are formed, which is formed on a semiconductor base 1. A contact hole 3 and a trench 4 for interconnects are formed in the insulating film 2 by the lithography and etching technique. Thereafter, a barrier layer 5 of TaN or the like is formed on the entire surface, and a seed layer 7 as an electric supply layer for electroplating is formed on the barrier layer 5.

Then, as shown in FIG. 85B, copper plating is performed onto the surface of the substrate W to fill the contact hole 3 and the trench 4 with copper and, at the same time, deposit a copper film 6 on the insulating film 2. Thereafter, the copper film 6 on the insulating film 2 is removed by chemical mechanical polishing (CMP) so as to make the surface of the copper film 6 filled in the contact hole 3 and the trench 4 for interconnects and the surface of the insulating film 2 lie substantially on the same plane. An interconnection composed of the copper film 6 as shown in FIG. 85C is thus formed.

Components in various types of equipments have recently become finer and have required higher accuracy. As sub-micro manufacturing technology has commonly been used, the properties of materials are largely influenced by the processing method. Under these circumstances, in such a conventional machining method that a desired portion in a workpiece is physically destroyed and removed from the surface thereof by a tool, a large number of defects may be produced to deteriorate the properties of the workpiece. Therefore, it becomes important to perform processing without deteriorating the properties of the materials.

Some processing methods, such as chemical polishing, electrolytic processing, and electrolytic polishing, have been developed in order to solve this problem. In contrast with the conventional physical processing, these methods perform removal processing or the like through chemical dissolution reaction. Therefore, these methods do not suffer from defects, such as formation of an altered layer and dislocation, due to plastic deformation, so that processing can be performed without deteriorating the properties of the materials.

Chemical mechanical polishing (CMP), for example, generally necessitates a complicated operation and control, and needs a considerably long processing time. In addition, a sufficient cleaning of a substrate must be conducted after the polishing treatment. This also imposes a considerable load on the slurry or cleaning liquid waste disposal. Accordingly, there is a strong demand for omitting CMP entirely or reducing a load upon CMP. Also in this connection, it is to be pointed out that though a low-k material, which has a low dielectric constant, is expected to be predominantly used in the future as a material for the insulating film of a semiconductor substrate, the low-k material has a low mechanical strength and therefore is hard to endure the stress applied during CMP processing. Thus, also from this standpoint, there is a demand for a technique that enables the flattering of a substrate without giving any stress thereto.

Further, a method has been reported which performs CMP processing simultaneously with plating, viz. chemical mechanical electrolytic polishing. According to this method, the mechanical processing is carried out to the growing surface of a plating film, causing the problem of denaturing of the resulting film.

In the case of the above-mentioned electrolytic processing or electrolytic polishing, the process proceeds through an electrochemical interaction between a workpiece and an electrolytic solution (aqueous solution of NaCl, NaNO₃, HF, HCl, HNO₃, NaOH, etc.). Since an electrolytic solution containing such an electrolyte must be used, contamination of a workpiece with the electrolyte cannot be avoided.

### Disclosure of Invention

The present invention has been made in view of the above situation in the related art. It is therefore an object of the present invention to provide an electrolytic processing device which, while omitting a CMP treatment entirely or reducing a load upon a CMP treatment to the least possible extent, can process a conductive material formed in the surface of a substrate to flatten the material, or can remove (clean) extraneous matter adhering to the surface of a workpiece such as a substrate, and also to provide a substrate processing apparatus in which the electrolytic processing device is incorporated.

In order to achieve the above obj ect, the present invention provides an electrolytic processing device, comprising: a processing electrode brought into contact with or close to a workpiece; a feeding electrode for supplying electricity to the workpiece; an ion exchanger disposed in at least one of the spaces between the workpiece and the processing electrode, and between the workpiece and the feeding electrode; a power source for applying a voltage between the processing electrode and the feeding electrode; and a liquid supply section for supplying a liquid to the space between the workpiece and at least one of the processing electrode and the feeding electrode, in which the ion exchanger is present.

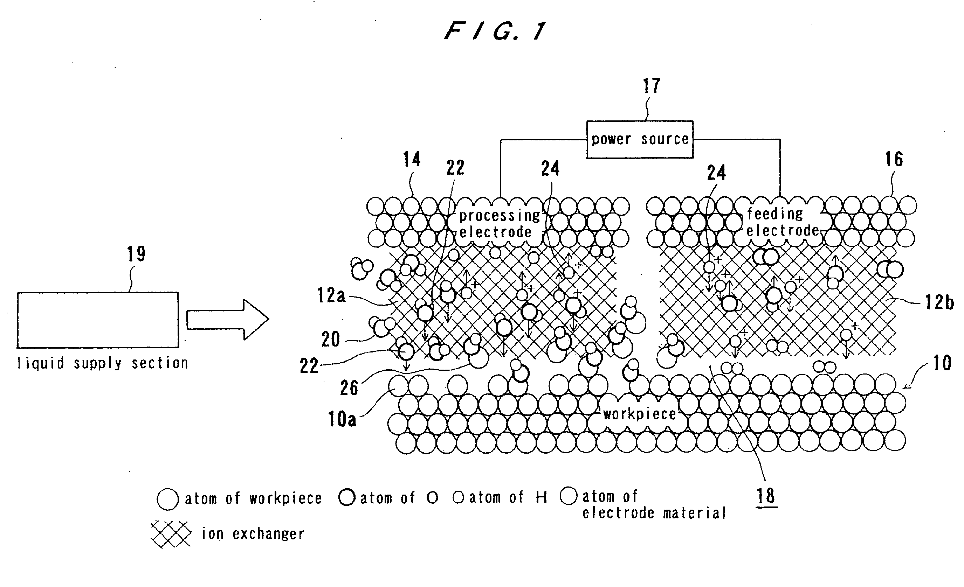

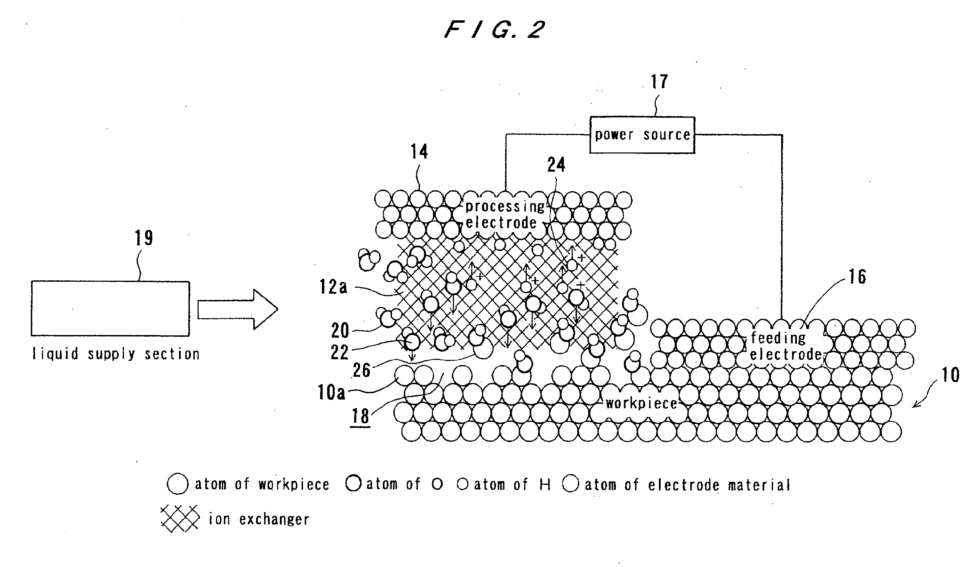

FIGS. 1 and 2 illustrate the principle of electrolytic processing effected in the above electrolytic processing device. FIG. 1 shows the ionic state in the electrolytic processing device when a ion exchanger 12a mounted on a processing electrode 14 and a ion exchanger 12b mounted on a feeding electrode 16 are brought into contact with or close to a surface of a workpiece 10, while a voltage is applied via a power source 17 between the processing electrode 14 and the feeding electrode 16, and a liquid 18, e.g. ultrapure water, is supplied from a liquid supply section 19 between the processing electrode 14, the feeding electrode 16 and the workpiece 10. FIG. 2 shows the ionic state in the electrolytic processing device when the ion exchanger 12a mounted on the processing electrode 14 is brought into contact with or close to the surface of the workpiece 10 and the feeding electrode 16 is directly contacted with the workpiece 10, while a voltage is applied via the power source 17 between the processing electrode 14 and the feeding electrode 16, and the liquid 18, such as ultrapure water, is supplied from the liquid supply section 19 between the processing electrode 14 and the workpiece 10.

When a liquid like ultrapure water that in itself has a large resistivity is used, it is preferred to bring the ion exchanger 12a into contact with the surface of the workpiece 10. This can lower the electric resistance, lower the requisite voltage and reduce the power consumption. The "contact" in the present electrolytic processing does not imply "press" for giving a physical energy (stress) to a workpiece as in CMP.

Water molecules 20 in the liquid 18 such as ultrapure water are dissociated by the ion exchangers 12a, 12b into hydroxide ions 22 and hydrogen ions 24. The hydroxide ions 22 thus produced, for example, are carried, by the electric field between the workpiece 10 and the processing electrode 14 and by the flow of the liquid 18, to the surface of the workpiece 10 opposite to the processing electrode 14 whereby the density of the hydroxide ions 22 in the vicinity of the workpiece 10 is enhanced, and the hydroxide ions 22 are reacted with the atoms 10a of the workpiece 10. The reaction product 26 produced by this reaction is dissolved in the liquid 18, and removed from the workpiece 10 by the flow of the liquid 18 along the surface of the workpiece 10. Removal processing of the surface of the workpiece 10 is thus effected.

As will be appreciated from the above, the removal processing according to the present invention is effected purely by the electrochemical interaction between the reactant ions and the workpiece. The present electrolytic processing thus clearly differs in the processing principle from CMP according to which processing is effected by the combination of the physical interaction between an abrasive and a workpiece, and the chemical interaction between a chemical species in a polishing liquid and the workpiece.

According to the above-described method, the portion of the workpiece 10 facing the processing electrode 14 is processed. Therefore, by moving the processing electrode 14, the workpiece 10 can be processed into a desired surface configuration.

As described above, the removal processing in the electrolytic processing device of the present invention is effected solely by the dissolution reaction due to the electrochemical interaction, and is clearly distinct in the processing principle from CMP in which processing is effected by the combination of the physical interaction between an abrasive and a workpiece, and the chemical interaction between a chemical species in a polishing liquid and the workpiece. Accordingly, the electrolytic processing device of the present invention can conduct removal processing of the surface of a workpiece without impairing the properties of the material of the workpiece. Even when the material of a workpiece is of a low mechanical strength, such as the above-described low-k material, removal processing of the surface of the workpiece can be effected without any physical damage to the workpiece. Further, as compared to conventional electrolytic processing devices, the electrolytic processing device of the present invention, due to the use of a processing liquid having an electric conductivity of not more than 500 µS/cm, preferably pure water, more preferably ultrapure water, can remarkably reduce contamination of the surface of a workpiece with impurities and can facilitate disposal of waste liquid after the processing.

The liquid may be pure water, a liquid having an electric conductivity (referring herein to that at 25°C, 1 atm) of not more than 500 µS/cm, or an electrolytic solution.

Pure water may be a water having an electric conductivity of not more than 10 µS/cm. The use of pure water in electrolytic processing enables a clean processing without leaving impurities on the processed surface of a workpiece, whereby a cleaning step after the electrolytic processing can be simplified. Specifically, one or two-stages of cleaning may suffice after the electrolytic processing.

It is also possible to use a liquid obtained by adding an additive, such as a surfactant, to pure water or ultrapure water, and having an electric conductivity of not more than 500 µS/cm, preferably not more than 50 µS/cm, more preferably not more than 0.1 µS/cm (resistivity of not less than 10 MΩ · cm). Such a liquid can form a layer, which functions to inhibit ionmigration evenly, at the interface between a workpiece (e.g. substrate) and an ion exchanger, thereby moderating concentration of ion exchange (metal dissolution) to enhance the flatness of the processed surface.

The additive plays a role to prevent local concentration of ions (e.g. hydroxide ions (OH⁻)). It is noted in this regard that "an equal processing (removal) rate at various points over the entire processing surface" is an important factor for providing a flat processed surface. When a single electrochemical removal reaction is in progress, a local difference in the processing removal rate may be produced by a local concentration of reactant ions. The local concentration of reactant ions may be caused mainly by a deviation in the electric field intensity between the processing electrode and the feeding electrode, and a deviation in the distribution of reactant ions in the vicinity of the surface of a workpiece. The local concentration of reactant ions can be prevented by allowing the additive, which plays a role to prevent local concentration of ions (e.g. hydroxide ions), to exist between a workpiece and an ion exchanger.

An aqueous solution of a neutral salt such as NaCl or Na₂SO₄, an acid such as HCl or H₂SO₄, or an alkali such as ammonia may be used as the electrolytic solution, and may be properly selected according to the properties of a workpiece. When using electrolytic solution, it is better to use the low concentration electrolytic solution which electric conductivity is not more than 500 µS/cm, to avoid much contamination.

In one embodiment of the electrolytic processing device of the present invention, the ion exchanger is disposed separately in the space between the processing electrode and a workpiece, and in the space between the feeding electrode and a workpiece. This prevents the occurrence of "the so-called short circuit" between the processing,electrode and the feeding electrode, and ensures a high processing efficiency.

According to another embodiment, the ion exchanger is disposed, as an integrated structure, in both of the spaces between the processing electrode and a workpiece, and between the feeding electrode and a workpiece. This facilitates the production of the processing electrode and the feeding electrode, and can further lower the electric resistance.

According to still another embodiment, the ion exchanger covers the surface, to be processed, of a workpiece, and is disposed in both of the spaces between the processing electrode and the workpiece, and between the feeding electrode and the workpiece. This makes it possible to easily and quickly change the ion exchanger covering the processing surface of a workpiece when, for example, the ion exchanger is stained.

In the above embodiments, the ion exchanger may be stretched between a supply shaft and a rewind shaft, and taken up sequentially. This makes it possible to change the ion exchanger by taking it up by a one-time use length when, for example, the ion exchanger is stained, whereby the change operation can be conducted in a successive manner.

In the case of the ion exchanger of this embodiment, the processing electrode and the feeding electrode may be mounted alternately on the ion exchanger at a given pitch along the length of the ion exchanger. This eliminates the need to provide electrode sections for supplying electricity separately, and thus can simplify the device.

The ion exchanger may have water-absorbing properties. This allows a liquid such as ultrapure water to flow within the ion exchanger.

The ion exchanger may have one or both of an anion-exchange ability and a cation-exchange ability. An ion exchanger having an anion-exchange ability and an ion exchanger having a cation-exchange ability can be used selectively according to a workpiece. The use of an ion-exchanger having both of anion-and cation-exchange abilities can broaden the range of processible materials and, in addition, can prevent the formation of impurities due to the polarity.

The ion exchanger may be covered with a porous body. This can provide a workpiece with a flatter processed surface. In this case, the ion exchanger itself may be composed of a porous body.

According to a preferred embodiment, the electrolytic processing device further comprises a regeneration section for regenerating the ion exchanger. By regenerating the ion exchanger during processing or in an interval of processing to remove extraneous matter, such as copper, from the ion exchanger, contamination of a new workpiece with the matter coming from the ion exchanger can be prevented, and furthermore, lowering of the processing efficiency and accuracy can be avoided.

The present invention also provides an electrolytic processing device comprising: a processing electrode brought into contact with or close to a workpiece; a feeding electrode for supplying electricity to the workpiece; a power source for applying a voltage between the processing electrode and the feeding electrode; and a liquid supply section for supplying pure water or a liquid having an electric conductivity of not more than 500 µS/cm between the workpiece and the processing electrode.

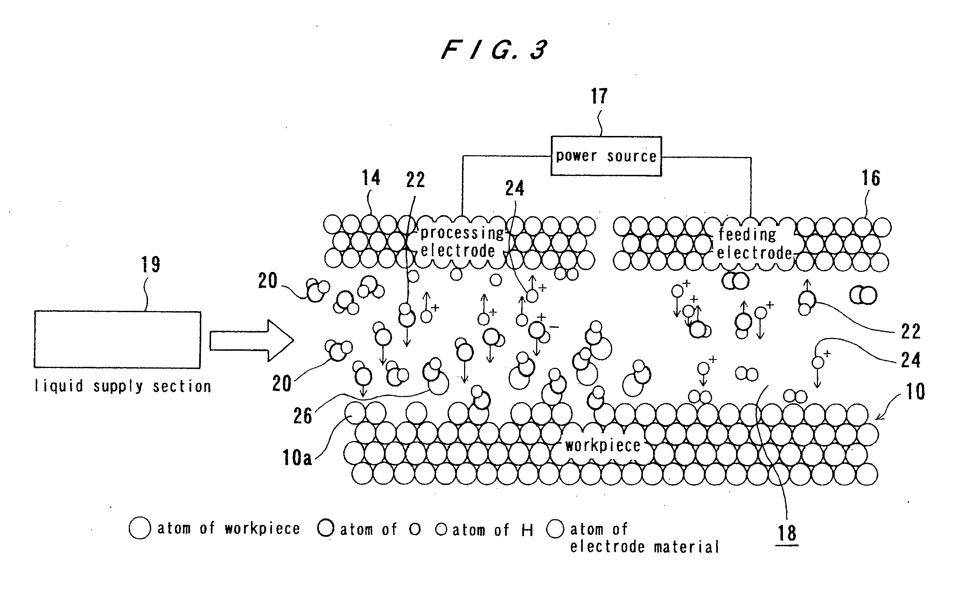

FIG. 3 illustrates the principle of electrolytic processing effected in this electrolytic processing device. FIG. 3 shows the ionic state in the electrolytic processing device when a processing electrode 14 and a feeding electrode 16 are brought close to a surface of a workpiece 10, while a voltage is applied via a power supply source 17 between the processing electrode 14 and the feeding electrode 16, and the liquid 18, such as ultrapure water, is supplied from a liquid supply section 19 between the processing electrode 14, the feeding electrode 16 and the workpiece 10.

Water molecules 20 in the liquid 18 such as ultrapure water are dissociated into hydroxide ions 22 and hydrogen ions 24. The hydroxide ions 22 thus produced are carried, by the electric field between the workpiece 10 and the processing electrode 14 and by the flow of the liquid 18, to the surface of the workpiece 10 opposite to the processing electrode 14 whereby the density of the hydroxide ions 22 in the vicinity of the workpiece 10 is enhanced, and the hydroxide ions 22 are reacted with the atoms 10a of the workpiece 10. The reaction product 26 is dissolved in the liquid 18, and removed from the workpiece 10 by the flow of the liquid 18 along the surface of the workpiece 10. Removal processing of the surface of the workpiece 10 is thus effected.

Ultrapure water is preferably used as the liquid. By "ultrapure water" is herein meant a water having an electric conductivity of not more than 0.1 µS/cm. The use of ultrapure water enables a cleaner processing without leaving impurities on the processed surface of a workpiece.

In the above-described electrolytic processing devices, according to one embodiment of the present invention, at least one of the processing electrode and the feeding electrode is in the shape of a flat rectangular plate.

According to another embodiment, at least one of the processing electrode and the feeding electrode is in the shape of a column, and is disposed such that the central axis thereof is parallel to the surface, to be processed, of a workpiece. This allows that at least one of the processing electrode and the feeding electrode to linearly contact or get close to a workpiece, thereby enhancing the flatness of the processed surface of the workpiece.

According to still another embodiment, at least one of the processing electrode and the feeding electrode is in a spherical or oval spherical shape. This enables processing at a point and processing of a curved surface.

According to yet another embodiment, at least one of the processing electrode and the feeding electrode has a depressed portion or a raised portion conforming to the configuration of a workpiece, and processing of the workpiece is conducted by allowing the workpiece to face the depressed or raised portion. For example, the processing electrode may have a depressed portion conforming to the configuration of a peripheral portion of a substrate. Processing of the substrate can be conducted by allowing the peripheral portion of the substrate to be positioned in the depressed portion, thereby removing a material, to be processed, formed on or adhering to the peripheral portion (bevel portion or edge portion). Thus, in this case, the electrolytic processing device is utilized as a bevel-etching device for the substrate.

The above-described electrolytic processing devices of the present invention may be constructed so that at least one of between the processing electrodes and the workpiece, and between the feeding electrodes and the workpiece can make a relative movement. This can produce a flow of the liquid, such as ultrapure water, between a workpiece and at least one of the processing and feeding electrodes, thereby effectively expelling unnecessary products, whereby the flatness of the processed surface of the workpiece can be enhanced.

The relative movement may be rotation, reciprocation, eccentric rotation or scroll movement, or a combination thereof.

Further according to the present invention, the processing electrode and the feeding electrode may be disposed such that one of the electrodes surrounds the other. This allows all of the electric currents to flow from the feeding electrode to the processing electrode through the shortest routes, thereby enhancing the electric current efficiency and reducing the electric power consumption.

According to another embodiment, at least one of the processing electrode and the feeding electrode is in the shape of a fan. This allows the processing electrode to face a workpiece for a constant time in the radial direction, whereby the electrolytic processing rate can be made constant.

According to yet another embodiment, at least one of the processing electrode and the feeding electrode is disposed linearly or in a circle.

The present invention provides a substrate processing apparatus, comprising: a substrate carry-in and carry-out section for carrying in and carrying out a substrate; an electrolytic processing device; and a transport device for transporting the substrate between the substrate carry-in and carry-out section and the electrolytic processing device; wherein the electrolytic processing device comprises a processing electrode brought into contact with or close to a workpiece, a feeding electrode for supplying electricity to the workpiece, an ion exchanger disposed in at least one of a spaces between the workpiece and the processing electrode, and between the workpiece and the feeding electrode, a power source for applying a voltage between the processing electrode and the feeding electrode, and a liquid supply section for supplying a liquid to the space between the workpiece and at least one of the processing electrode and the feeding electrode, in which the ion exchanger is present.

The present invention also provides a substrate processing apparatus, comprising: a substrate carry-in and carry-out section for carrying in and carrying out a substrate; an electrolytic processing device; and a transport device for transporting the substrate between the substrate carry-in and carry-out section and the electrolytic processing device; wherein the electrolytic processing device comprises a processing electrode brought into contact with or close to a workpiece, a feeding electrode for supplying electricity to the workpiece, a power source for applying a voltage between the processing electrode and the feeding electrode, and a liquid supply section for supplying pure water or a liquid having an electric conductivity of not more than 500 µS/cm between the workpiece and the processing electrode.

In a preferred embodiment, the substrate processing apparatus further comprises a cleaning device for cleaning the processed substrate by the electrolytic processing device.

In another embodiment, the substrate processing apparatus further comprises a CMP device for chemical mechanical polishing the surface of a substrate. In this case, the substrate processing apparatus may further comprise a cleaning device for cleaning the polished substrate by the CMP device.

In still another embodiment, the substrate processing apparatus further comprises a film-forming device for forming a film as a portion to be processed in the surface of a substrate. In this case, the substrate processing apparatus may further comprise at least one of a cleaning device for cleaning the portion to be processed having been formed in the film-forming device and an annealing device for annealing the portion to be processed.

Also in this case, the substrate processing apparatus may further comprise a bevel-etching device for etching the portion to be processed formed in or adhering to a peripheral portion of the substrate. In the bevel-etching device, the etching of the portion to be processed may be effected by electrolytic processing.

The substrate processing apparatus may further comprise a film thickness-measuring section for measuring the film thickness of the portion to be processed during or after the polishing in the CMP device. Moreover, the substrate processing apparatus may further comprise a film thickness-measuring section for measuring the film thickness of the portion to be processed during or after the film formation in the film-forming device.

The film formation in the film-forming device may be conducted by plating.

In yet another embodiment, the substrate processing apparatus further comprises a monitor for monitoring at least one of electrolytic current and electrolytic voltage when the voltage is applied between the feeding electrode and the processing electrode.

According to yet another embodiment, the substrate processing apparatus further comprises a drying device for finally drying the processed substrate. This can realize the so-called "dry-in, dry-out".

According to yet another embodiment, the substrate processing apparatus monitors a change in the state of the substrate being processed and detects the end point of processing. By the "end point of processing" is herein meant a point at which a desired processing amount is attained for a specified region in a surface to be processed, or a point at which an amount corresponding to a desired processing amount is attained in terms of a parameter correlated with a processing amount for a specified region in a surface to be processed. By thus arbitrarily setting and detecting the end point of processing even in the middle of processing, it becomes possible to conduct a multi-step electrolytic processing.

According to yet another embodiment, the substrate processing apparatus further comprises a film-thickness detection section for detecting the end point of processing.

The above and other objects, features, and advantages of the present invention will be apparent from the following description when taken in conjunction with the accompanying drawings which illustrates preferred embodiments of the present invention by way of example.

### Brief Description of Drawings

FIG. 1 is a diagram illustrating the principle of electrolytic processing effected in an electrolytic processing device in accordance with the present invention when an ion exchanger is mounted on both of a processing electrode and a feeding electrode, and a liquid is supplied between the processing electrode, the feeding electrode and a substrate (workpiece) ;
FIG. 2 is a diagram illustrating the principle of electrolytic processing effected in an electrolytic processing device in accordance with the present invention when an ion exchanger is mounted only on a processing electrode, and a liquid is supplied between the processing electrode and a substrate (workpiece);
FIG. 3 is a diagram illustrating the principle of electrolytic processing effected in an electrolytic processing device in accordance with the present invention when a processing electrode and a feeding electrode are brought close to a substrate, and pure water or a liquid having an electric conductivity of not more than 500 µS/cm is supplied between the processing electrode, the feeding electrode and the substrate (workpiece) ;
FIGS. 4A and 4B are plan views showing the layout of a substrate processing apparatus according to a first embodiment of the present invention;
FIG. 5 is a vertical sectional front view of an electrolytic processing device according to one embodiment of the present invention, which is provided in the substrate processing apparatus of FIG. 4;
FIG. 6 is a plan view of the electrolytic processing device of FIG. 5;
FIG. 7 is a plan view of an electrode plate provided in the electrolytic processing device of FIG. 4;
FIG. 8 is a cross-sectional view of another ion exchanger;
FIGS. 9A and 9B are plan views of other electrode plates;
FIGS. 10A and 10B are plan views of still other electrode plates;
FIGS. 11A and 11B are plan views of yet other electrode plates;
FIG. 12 is a plan view of yet another electrode plate;
FIG. 13 is a plan view of yet another electrode plate;
FIGS. 14A and 14B are graphs showing the relationship between the electric current and time, and the relationship between the voltage applied and time, respectively, in electrolytic processing conducted to the surface of a substrate in which a laminated film of two different materials is formed;
FIG. 15 is a plan view showing a variation of the electrolytic processing device of FIG. 5;
FIG. 16 is a plan view showing the layout of a substrate processing apparatus according to another embodiment of the present invention;
FIG. 17 is a cross-sectional view of an electrolytic processing device according to another embodiment of the present invention, which is provided in the substrate processing apparatus of FIG. 16;
FIG. 18 is a plan view of the electrolytic processing device of FIG. 17;
FIG. 19A is a plan view showing the relationship between the substrate holder and the electrode section of the electrolytic processing device of FIG. 17, and FIG. 19B is a cross-sectional view taken along the line A-A of FIG. 19A;
FIG. 20 is a plan view of an electrode plate used in a variation of the electrolytic processing device of FIG. 17;
FIG. 21 is a vertical sectional front view of the electrode plate of FIG. 20;
FIG. 22 is a cross-sectional view of an electrolytic processing device according to yet another embodiment of the present invention;
FIG. 23 is a plan view of the electrolytic processing device of FIG. 22;
FIG. 24 is a cross-sectional view of an electrolytic processing device according to yet another embodiment of the present invention;
FIG. 25 is a plan view of the electrolytic processing device of FIG. 24;
FIG. 26 is a cross-sectional view of an electrolytic processing device according to yet another embodiment of the present invention;
FIG. 27 is a plan view of the electrolytic processing device of FIG. 26;
FIG. 28 is a cross-sectional view of an electrolytic processing device according to yet another embodiment of the present invention;
FIG. 29 is a plan view of the electrolytic processing device of FIG. 28;
FIG. 30 is a cross-sectional view of an electrolytic processing device according to yet another embodiment of the present invention;
FIG. 31 is a plan view showing the layout of a substrate processing apparatus according to yet another embodiment of the present invention;
FIG. 32 is a schematic sectional view of a CMP device;
FIG. 33 is a plan view showing the layout of a substrate processing apparatus according to yet another embodiment of the present invention;
FIG. 34 is a plan view showing the layout of a substrate processing apparatus according to yet another embodiment of the present invention;
FIG. 35 is a plan view showing the layout of a substrate processing apparatus according to yet another embodiment of the present invention;
FIG. 36 is a schematic sectional view of a plating device;
FIG. 37 is a vertical sectional view of an annealing device;
FIG. 38 is a horizontal sectional view of the annealing device;
FIG. 39 is a plan view showing the layout of a substrate processing apparatus according to yet another embodiment of the present invention in which a bevel-etching device is incorporated;
FIG. 40 is a schematic view of an electrolytic processing device according to yet another embodiment of the present invention, which is utilized as a bevel-etching device;
FIG. 41 is an enlarged sectional view of the main portion of an electrolytic processing device according to yet another embodiment of the present invention, which is utilized as a bevel-etching device;
FIG. 42 is a cross-sectional view of an electrolytic processing device according to yet another embodiment of the present invention, which is utilized as a bevel-etching device;
FIG. 43 is a plan view of the bevel-etching device of FIG. 42;
FIG. 44 is a plan view showing the layout of a substrate processing apparatus according to yet another embodiment of the present invention;
FIG. 45 is a schematic plan view of an electrolytic processing device according to yet another embodiment of the present invention;
FIG. 46 is a schematic perspective view showing the processing electrode and the feeding electrode of the electrolytic processing device of FIG. 45;
FIG. 47 is a schematic front view showing the processing electrode and the feeding electrode of the electrolytic processing device of FIG. 45;
FIGS. 48A and 48B are respectively perspective and front views illustrating a case of mounting an ion exchanger on a rectangular electrode;
FIGS. 49A and 49B are respectively perspective and front views illustrating a case of mounting an ion exchanger on a column-shaped electrode;
FIG. 50 is a schematic front view of other processing and feeding electrodes;
FIG. 51 is a schematic front view of yet other processing and feeding electrodes;
FIG. 52 is a schematic front view of yet other processing and feeding electrodes;
FIG. 53 is a schematic front view of yet other processing and feeding electrodes;
FIGS. 54A and 54B are diagrams illustrating different arrangements of processing and feeding electrodes relative to a substrate;
FIG. 55 is a schematic front view of other processing electrode, feeding electrode and ion exchanger;
FIG. 56 is a schematic front view of yet other processing electrode, feeding electrode and ion exchanger;
FIG. 57 is a cross-sectional view of an electrolytic processing device according to yet another embodiment of the present invention;
FIG. 58 is a plan view of the electrolytic processing device of FIG. 57;
FIG. 59 is a perspective view of yet another ion exchanger;
FIG. 60 is a front view of the ion exchanger of FIG. 59;
FIGS. 61A and 61B are respectively front and perspective views showing yet another arrangement of processing and feeding electrodes;
FIG. 62 is a plan view showing yet another arrangement of processing and feeding electrodes;
FIG. 63 is a plan view showing yet another arrangement of processing and feeding electrodes;
FIG. 64 is a schematic perspective view of an electrolytic processing device according to yet another embodiment of the present invention;
FIG. 65 is a schematic side view of the electrolytic processing device of FIG. 64;
FIG. 66 is a cross-sectional view of an electrolytic processing device according to yet another embodiment of the present invention;
FIG. 67 is a plan view of the electrolytic processing device of FIG. 66;
FIG. 68 is a schematic front view of an electrolytic processing device according to yet another embodiment of the present invention;
FIG. 69 is a schematic front view of an electrolytic processing device according to yet another embodiment of the present invention;
FIG. 70 is a vertical sectional view of an electrolytic processing device according to yet another embodiment of the present invention;
FIG. 71 is a plan view of the electrolytic processing device of FIG. 70;
FIG. 72 is a schematic perspective view of an electrolytic processing device according to yet another embodiment of the present invention, which is utilized as a bevel-etching device;
FIG. 73 is a schematic perspective view of an electrolytic processing device according to yet another embodiment of the present invention, which is utilized as a bevel-etching device;
FIG. 74 is a diagram illustrating the state of a substrate after undergoing electrolytic processing in the electrolytic processing device (bevel-etching device) of FIG. 72 or of FIG. 73;
FIG. 75 is a cross-sectional view of an electrolytic processing device according to yet another embodiment of the present invention, which is utilized as a bevel-etching device;
FIG. 76 is a plan view of the electrolytic processing device of FIG. 75;
FIG. 77 is a plan view showing a variation of the electrolytic processing device of FIG. 75;
FIG. 78 is a schematic front view of an electrolytic processing device according to yet another embodiment of the present invention;
FIG. 79 is a schematic perspective view of an electrolytic processing device according to yet another embodiment of the present invention;
FIG. 80 is a schematic front view of the electrolytic processing device of FIG. 79;
FIG. 81 is a schematic front view of an electrolytic processing device according to yet another embodiment of the present invention;
FIG. 82 is a schematic front view of the electrolytic processing device of FIG. 81;
FIG. 83 is a schematic front view of an electrolytic processing device according to yet another embodiment of the present invention;
FIG. 84 is a schematic front view of the electrolytic processing device of FIG. 83; and
FIGS. 85A through 85C are diagrams illustrating, in sequence of process steps, for forming of copper interconnects.

### Best Mode for Carrying Out the Invention

Preferred embodiments of the present invention will now be described with reference to the drawings.

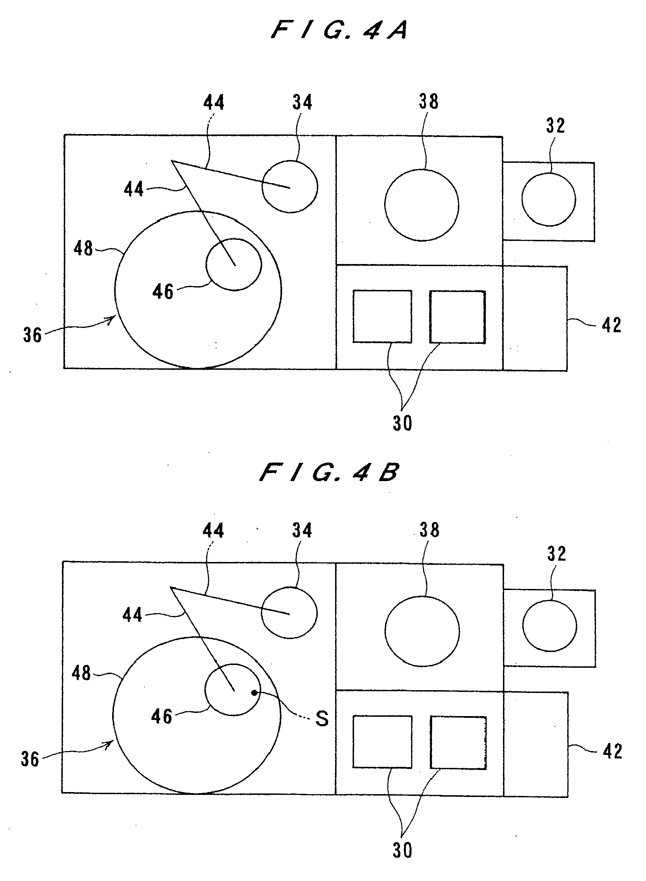

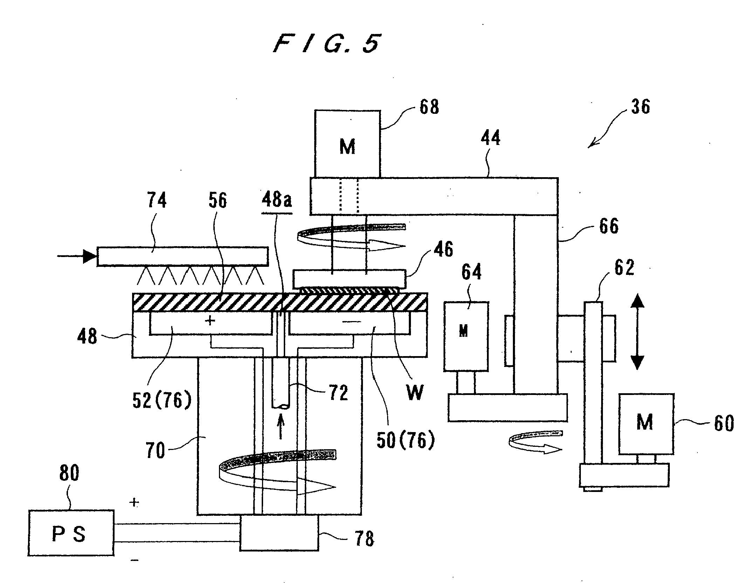

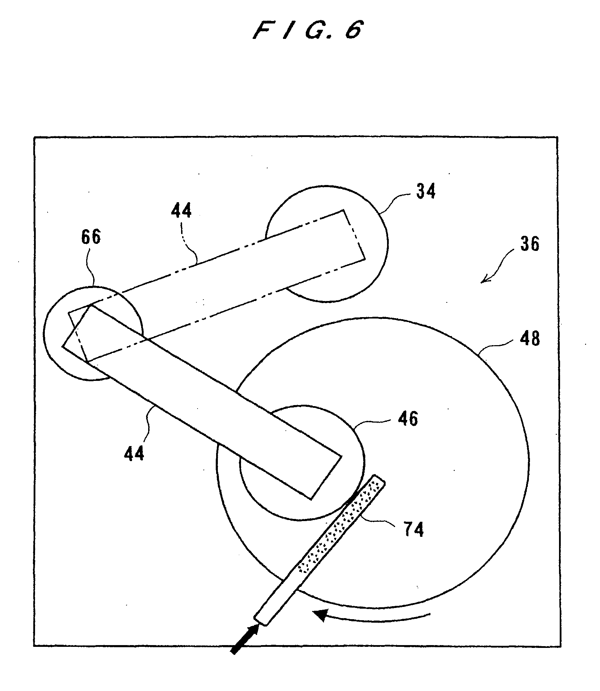

FIG. 4A shows a plan view of a substrate processing apparatus according to a first embodiment of the present invention. FIGS. 5 through 7 show an electrolytic processing device according to a first embodiment of the present invention which is used in the substrate processing apparatus. Though this embodiment uses a substrate as a workpiece to be processed by the electrolytic processing device, a workpiece other than a substrate can, of course, also be employed.

As shown in FIG. 4A, the substrate processing apparatus comprises a pair of loading/unloading units 30 as a carry-in and carry-out section for carrying in and carrying out a cassette housing a substrate W, e.g. a substrate W as shown in FIG. 85B, which has in its surface a copper film 6 as a conductor film (portion to be processed) , a reversing machine 32 for reversing the substrate W, a pusher 34 for transferring the substrate W, and an electrolytic processing device 36. A fixed-type transport robot 38 is provided in between the loading/unloading units 30, the reversing machine 32 and the pusher 34 as a transport device for transporting the substrate W therebetween. The substrate processing apparatus is also provided with a monitor 42 for monitoring a voltage applied between the below-described processing electrodes 50 and feeding electrodes 52 upon electrolytic processing in the electrolytic processing device 36, or an electric current flowing therebetween.

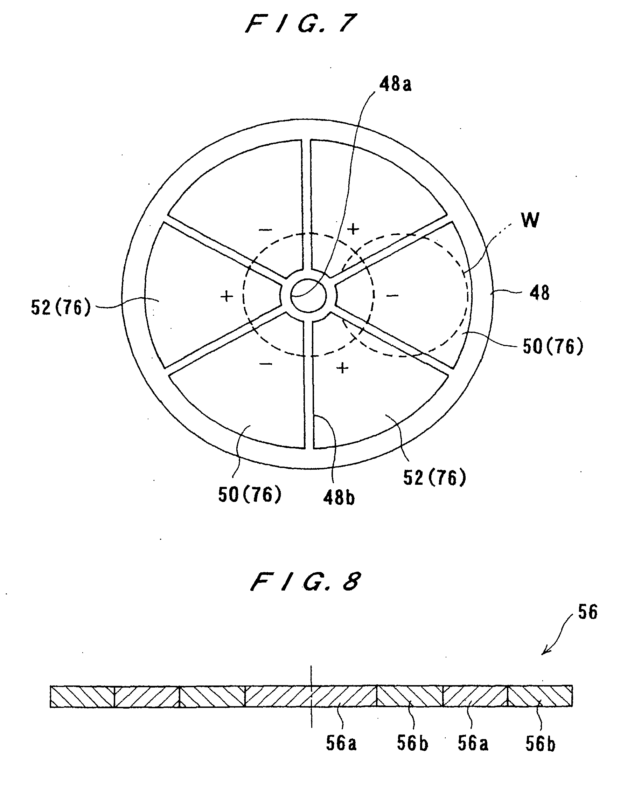

As shown in FIG. 5, the electrolytic processing device 36 includes a substrate holder 46, supported at the free end of a swingable arm 44 that can swing horizontally, for attracting and holding the substrate W with its front surface downward (so-called "face down" manner), and, positioned beneath the substrate holder 46, a disc-shaped electrode section 48 made of an insulating material. As shown in FIG. 7, the electrode section 48 has, embedded therein, fan-shaped processing electrodes 50 and feeding electrodes 52 that are disposed alternately with their surfaces (upper faces) exposed. A film-like ion exchanger 56 is mounted on the upper surface of the electrode section 48 so as to cover the surfaces of the processing electrodes 50 and the feeding electrodes 52.

This embodiment uses, merely as an example of the electrode section 48 having the processing electrodes 50 and the feeding electrodes 52, such one that has a diameter more than twice that of the substrate W so that the entire surface of the substrate W may undergo electrolytic processing.

The ion exchanger 56 may be a nonwoven fabric which has an anion-exchange ability or a cation-exchange ability. A cation exchanger preferably carries a strongly acidic cation-exchange group (sulfonic acid group) ; however, a cation exchanger carrying a weakly acidic cation-exchange group (carboxyl group) may also be used. Though an anion exchanger preferably carries a strongly basic anion-exchange group (quaternary ammonium group), an anion exchanger carrying a weakly basic anion-exchange group (tertiary or lower amino group) may also be used.

The nonwoven fabric carrying a strongly basic anion-exchange group can be prepared by, for example, the following method: A polyolefin nonwoven fabric having a fiber diameter of 20-50 µm and a porosity of about 90 % is subjected to the so-called radiation graft polymerization, comprising γ -ray irradiation onto the nonwoven fabric and the subsequent graft polymerization, thereby introducing graft chains; and the graft chains thus introduced are then aminated to introduce quaternary ammonium groups thereinto. The capacity of the ion-exchange groups introduced can be determined by the amount of the graft chains introduced. The graft polymerization may be conducted by the use of a monomer such as acrylic acid, styrene, glicidyl methacrylate, sodium styrenesulfonate or chloromethylstyrene. The amount of the graft chains can be controlled by adjusting the monomer concentration, the reaction temperature and the reaction time. Thus, the degree of grafting, i.e. the ratio of the weight of the nonwoven fabric after graft polymerization to the weight of the nonwoven fabric before graft polymerization, can be made 500 % at its maximum. Consequently, the capacity of the ion-exchange groups introduced after graft polymerization can be made 5 meq/g at its maximum.

The nonwoven fabric carrying a strongly acidic cation-exchange group can be prepared by the following method: As in the case of the nonwoven fabric carrying a strongly basic anion-exchange group, a polyolefin nonwoven fabric having a fiber diameter of 20-50 µm and a porosity of about 90 % is subjected to the so-called radiation graft polymerization comprising γ-ray irradiation onto the nonwoven fabric and the subsequent graft polymerization, thereby introducing graft chains; and the graft chains thus introduced are then treated with a heated sulfuric acid to introduce sulfonic acid groups thereinto. If the graft chains are treated with a heated phosphoric acid, phosphate groups can be introduced. The degree of grafting can reach 500 % at its maximum, and the capacity of the ion-exchange groups thus introduced after graft polymerization can reach 5 meq/g at its maximum.

The base material of the ion-exchanger 56 may be a polyolefin such as polyethylene or polypropylene, or any other organic polymer. Further, besides the form of a nonwoven fabric, the ion-exchanger may be in the form of a woven fabric, a sheet, a porous material, short fibers, etc.

When polyethylene or polypropylene is used as the base material, graft polymerization can be effected by first irradiating radioactive rays (γ-rays or electron beam) onto the base material (pre-irradiation) to thereby generate a radical, and then reacting the radical with a monomer, whereby uniform graft chains with few impurities can be obtained. When an organic polymer other than polyolefin is used as the base material, on the other hand, radical polymerization can be effected by impregnating the base material with a monomer and irradiating radioactive rays (γ-rays, electron beam or UV-rays) onto the base material (simultaneous irradiation) . Though this method fails to provide uniform graft chains, it is applicable to a wide variety of base materials.

By using as the ion exchanger 56 a nonwoven fabric having an anion-exchange ability or a cation-exchange ability, it becomes possible that pure water or ultrapure water, or a liquid such as an electrolytic solution can freely move within the nonwoven fabric and easily arrive at the active points in the nonwoven fabric having a catalytic activity for water dissociation, so that many water molecules are dissociated into hydrogen ions and hydroxide ions. Further, by the movement of pure water or ultrapure water, or a liquid such as an electrolytic solution, the hydroxide ions produced by the water dissociation can be efficiently carried to the surface of the processing electrode 50, whereby a high electric current can be obtained even with a low voltage applied.

When the ion exchanger 56 has only one of anion-exchange ability and cation-exchange ability, a limitation is imposed on electrolytically processible materials and, in addition, impurities are likely to form due to the polarity. In order to solve this problem, the ion exchanger 56 may have such a structure as shown in FIG. 8 wherein anion-exchangers 56a having an anion-exchange ability and cation-exchangers 56b having a cation-exchange ability are concentrically disposed to constitute an integral structure. The anion exchangers and the cation exchangers may be superimposed on the surface, to be processed, of a substrate. It may also be possible to make the anion-exchangers and the cation-exchangers each in the shape of a fan, and dispose them alternately. Alternatively, the above problem can be solved by using, as the ion exchanger 56, an ion-exchanger which in itself carries both of an anion-exchange group and a cation-exchange group. Such an ion exchanger may include an amphoteric ion exchanger in which anion-exchange groups and cation-exchange groups are distributed randomly, a bipolar ion exchanger in which anion-exchange groups and cation-exchange groups are present in layers, and a mosaic ion exchanger in which portions containing anion-exchange groups and portions containing cation-exchange groups are present in parallel in the thickness direction. Incidentally, it is of course possible to selectively use, as the ion exchange 56, one having an anion-exchange ability or one having a cation-exchange ability according to the material to be processed.

As shown in FIG. 5, the swingable arm 44, which moves up and down via a ball screw 62 by the actuation of a motor 60 for vertical movement, is connected to the upper end of a shaft 66 that rotates by the actuation of a motor 64 for swinging. The substrate holder 46 is connected to a motor 68 for rotation that is mounted on the free end of the swingable arm 44, and is allowed to rotate by the actuation of the motor 68 for rotation.

The electrode section 48 is connected directly to a hollow motor 70, and is allowed to rotate by the actuation of the hollow motor 70. A through-hole 48a as a pure water supply section for supplying pure water, preferably ultrapure water, is formed in the central portion of the electrode section 48. The through-hole 48a is connected to a pure water supply pipe 72 that vertically extends inside the hollow motor 70. Pure water or ultrapure water is supplied through the through-hole 48a, and via the ion exchanger 56, is supplied to the entire processing surface of the substrate W. A plurality of through-holes 48a, each communicating with the pure water supply pipe 72, may be provided to facilitate the processing liquid reaching over the entire processing surface of the substrate W.

Further, a pure water nozzle 74 as a pure water supply section for supplying pure water or ultrapure water, extending in the radial direction of the electrode section 48 and having a plurality of supply ports, is disposed above the electrode section 48. Pure water or ultrapure water is thus supplied to the surface of the substrate W from above and beneath the substrate W. Pure water herein refers to a water having an electric conductivity of not more than 10 µS/cm, and ultrapure water refers to a water having an electric conductivity of not more than 0.1 µS/cm. Instead of pure water, a liquid having an electric conductivity of not more than 500 µS/cm or any electrolytic solution may be used. By supplying such a processing liquid during processing, the instability factors of processing, such as process products and dissolved gases, can be removed, and processing can be effected uniformly with good reproducibility.

According to this embodiment, as shown in FIG. 5 and FIG. 7, fan-shaped electrode plates 76 are disposed in the electrode section 48, and the cathode and anode of a power source 80 are alternately connected, via a slip ring 78, to the electrode plates 76. The electrode plates 76 connected to the cathode of the power source 80 become the processing electrodes 50 and the electrode plates 76 connected to the anode become the feeding electrodes 52. This applies to processing of e.g. copper, because electrolytic processing of copper proceeds on the cathode side. Depending upon a material to be processed, the cathode side can be a feeding electrode and the anode side can be a processing electrode. More specifically, when the material to be processed is copper, molybdenum, iron or the like, electrolytic processing proceeds on the cathode side, and therefore the electrode plates 76 connected to the cathode of the power source 80 should be the processing electrodes 50 and the electrode plates 76 connected to the anode should be the feeding electrodes 52. In the case of aluminum, silicon or the like, on the other hand, electrolytic processing proceeds on the anode side. Accordingly, the electrode plates connected to the anode of the power source should be the processing electrodes and the electrode plates connected to the cathode should be the feeding electrodes.

Though this embodiment shows a case in which fan-shaped electrode plates 76 are separated from one another by the ribs 48b of the electrode section 48 which is composed of an insulating material. The ribs 48b may also be formed as a separate body of another insulating material so that pure water or the like can be supplied through interspaces between the insulating materials.

By thus disposing the processing electrodes 50 and the feeding electrodes 52 separately and alternately in the circumferential direction of the electrode section 48, fixed feeding portions to supply electricity to a conductive film (portion to be processed) of the substrate is not needed, and processing can be effected to the entire surface of the substrate. Further, be changing the positive and negative in a pulse manner, an electrolysis product can be dissolved and the flatness of the processed surface can be enhanced by the multiplex repetition of processing.

With respect to the processing electrode 50 and the feeding electrode 52, oxidation or dissolution thereof due to an electrolytic reaction is generally a problem. In view of this, it is preferred to use, as a base material of the feeding electrode 52, carbon, a noble metal that is relatively inactive, a conductive oxide or a conductive ceramics, rather than a metal or metal compound widely used for electrodes. A noble metal-based electrode may, for example, be one obtained by plating or coating platinum or iridium onto a titanium electrode, and then sintering the coated electrode at a high temperature to stabilize and strengthen the electrode. Ceramics products are generally obtained by heat-treating inorganic raw materials, and ceramics products having various properties are produced from various raw materials including oxides, carbides and nitrides of metals and nonmetals. Among them there are ceramics having an electric conductivity. When an electrode is oxidized, the value of the electric resistance generally increases to cause an increase of applied voltage. However, by protecting the surface of an electrode with a non-oxidative material such as platinum or with a conductive oxide such as an iridium oxide, the decrease of electric conductivity due to oxidation of the base material of an electrode can be prevented.

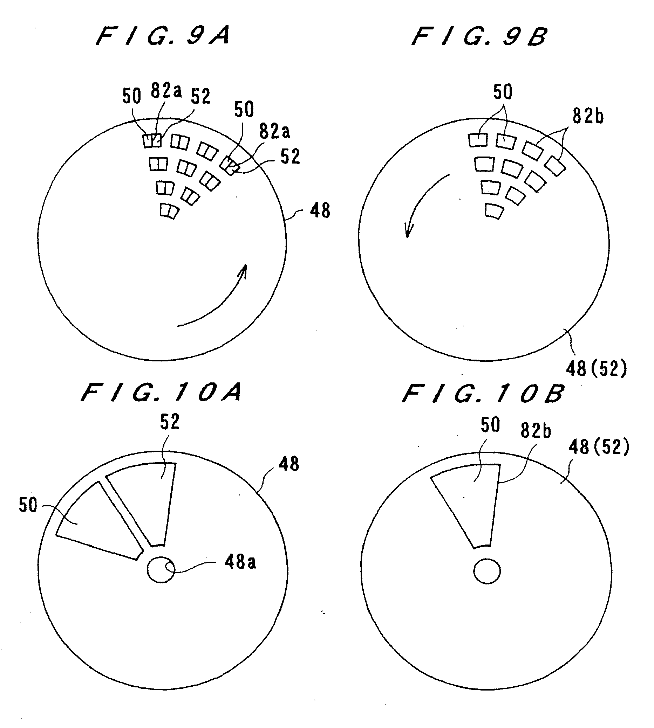

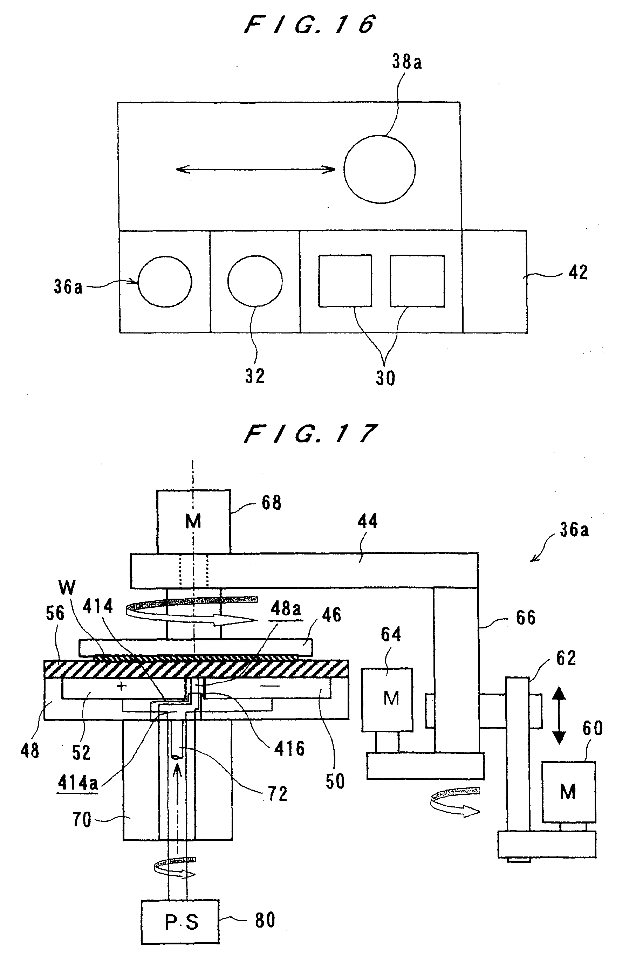

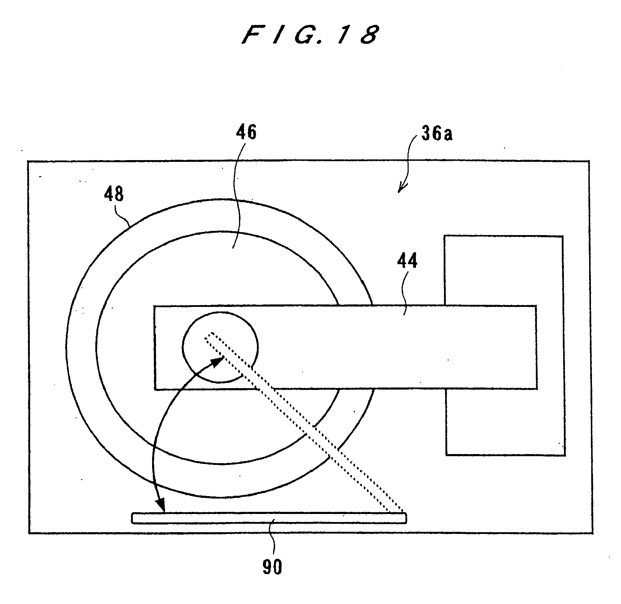

The processing electrodes 50 and the feeding electrodes 52 may be disposed as shown in FIG. 9A: Pairs of the processing electrodes 50 and the feeding electrodes 52, each pair sandwiching an insulator 82a, are disposed, within the electrode section 48, in a fan-shaped region ranging from the center to the periphery of the electrode section 48 so that the number of the pairs gradually increases from the center to the periphery of the electrode section 48. With this arrangement, the electrode section 48 and the substrate W are rotated, an electric current per unit area, i.e. current density, becomes even between a central portion of the electrode section 48 where the relative speed to the substrate W is low and a peripheral portion of the electrode section 48 where the relative speed to the substrate W is high, whereby the electrolytic processing rate can be made constant over the entire surface of the substrate W. This arrangement is adapted not only to this embodiment in which the substrate W is positioned on one side across the center of the electrode section 48, but also to a case in which the electrode portion 48, which is slightly larger than the substrate, is allowed to rotate about the center of the substrate W (see FIG. 17 and FIG. 18).

As a modification of the above electrode arrangement, as shown in FIG. 9B, it is possible to make the electrode section 48 of a conductive material so that the electrode section 48 itself can function as the feeding electrode 52 (or the processing electrode 50), and embed the processing electrodes 50 (or the feeding electrodes 52), which are separated by the insulator 82b, in the inside of the electrode section 48. This can reduce the number of wires.

Alternatively, as shown in FIG. 10A, one processing electrode 50 and one feeding electrode 52, adj acent to each other and each in the shape of a fan extending from the center towards the periphery of the electrode section 48, may be disposed in the inside of the electrode section 48. Also in this case, as shown in FIG. 10B, it is possible to make the electrode section 48 of a conductive material so that the electrode section 48 itself can function as the feeding electrode 52 (or the processing electrode 50), and embed the processing electrode 50 (or the feeding electrode 52), which is separated by the insulator 82b, in the inside of the electrode section 48.

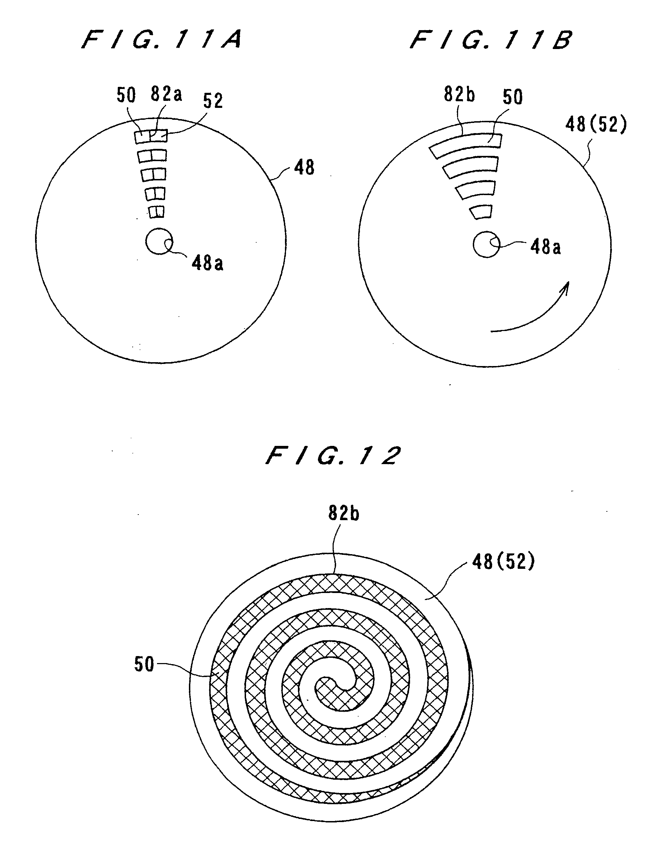

Alternatively, as shown in FIG. 11A, pairs of the processing electrodes 50 and the feeding electrodes 52, each pair sandwiching the insulator 82a, may be disposed in the inside of the electrode section 48 such that the length of the processing electrode 50 and that of the feeding electrode 52 in the circumferential direction gradually increases from the center to the periphery of the electrode section 48. Also in this case, as shown in FIG. 11B, it is possible to make the electrode section 48 of a conductive material so that the electrode section 48 itself can function as the feeding electrode 52 (or the processing electrode 50) , and embed the processing electrodes 50 (or the feeding electrodes 52), which are separated by the insulator 82b, in the inside of the electrode section 48.

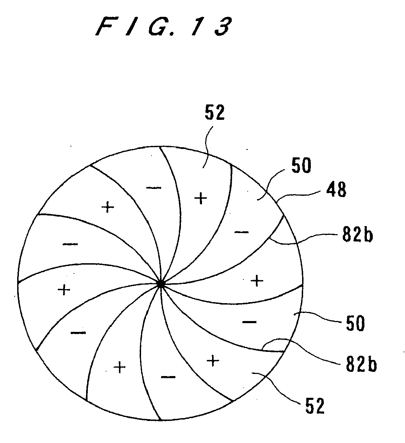

Alternatively, as shown in FIG. 12, it is possible to make the electrode section 48 of a conductive material so that the electrode section 48 itself can function as the feeding electrode 52 (or the processing electrode 50) , and embed the processing electrode 50, which is separated by the insulator 82b and extends spirally continuously, in the inside of the electrode section 48. Further, as shown in FIG. 13, the processing electrodes 50 and the feeding electrodes 52, extending like a screw from the center to the periphery of the electrode section 48, may be disposed in the inside of the electrode section 48 alternately, with the insulators 82b being sandwiched.

Furthermore, though not figured, it is of course possible to distribute or dot the processing electrodes and the feeding electrodes uniformly in the inside of the electrode section 48.

Next, substrate processing (electrolytic processing) by the substrate processing apparatus will be described by referring to FIG. 4A.

First, a substrate W, e.g. a substrate W as shown in FIG. 85B which has in its surface a copper film 6 as a conductor film (portion to be processed), is taken by the transport robot 38 out of the cassette housing substrates and set in the loading/unloading unit 30. If necessary, the substrate W is transported to the reversing machine 32 to reverse the substrate so that the front surface of the substrate W having the conductor film faces downward. The substrate W, its front surface faces downward, is then transported by the transport robot 38 to the pusher 34 to place the substrate W on the pusher 34.

The substrate W on the pusher 34 is attracted and held by the substrate holder 46 of the electrolytic processing device 36, and the substrate holder 46 is moved by the swingable arm 44 to a processing position right above the electrode section 48. The substrate holder 46 is then lowered by the actuation of the motor 60 for vertical movement, so that the substrate W held by the substrate holder 46 contacts or gets close to the surface of the ion exchanger 56 mounted on the upper surface of the electrode section 48.

It is to be noted here that when a liquid like ultrapure water which itself has a large resistivity is used, the electric resistance can be lowered by bringing the ion exchanger 56 into contact with the substrate W, whereby the requisite voltage can also be lowered and hence the power consumption can be reduced. The "contact" does not imply "press" for giving a physical energy (stress) to a workpiece as in CMP. Accordingly, the electrolytic processing device of this embodiment employs the vertical-movement motor 60 for bringing the substrate W into contact with or close to the electrode section 48, and does not have such a press mechanism as usually employed in a CMP device that presses a substrate against a polishing member. This holds also for the below-described embodiments.

In this regard, according to a CMP device, a substrate is pressed against a polishing surface generally at a pressure of about 20-50 kPa, whereas in the electrolytic processing device of this embodiment, the substrate W may be contacted with the ion exchanger 56 at a pressure of less than 20 kPa. Even at a pressure less than 10 kPa, a sufficient removal processing effect can be achieved.

Next, a given voltage is applied from the power source 80 (see FIG. 5) between the processing electrodes 50 and the feeding electrodes 52, while the substrate holder 46 and the electrode section 48 are rotated. At the same time, pure water or ultrapure water is supplied, through the through-hole 48a, from beneath the electrode section 48 to the upper surface thereof, and simultaneously, pure water or ultrapure water is supplied, through the pure water nozzle 74, from above the electrode section 48 to the upper surface thereof, thereby filling pure water or ultrapure water into the space between the processing and feeding electrodes 50, 52 and the substrate W. Thereby, electrolytic processing of the conductor film (copper film 6) formed on the substrate W is effected by hydrogen ions or hydroxide ions produced in the ion exchanger 56. According to the above electrolytic processing device, a large amount of hydrogen ions or hydroxide ions can be produced by allowing pure water or ultrapure water to flow within the ion exchanger 56, and the large amount of such ions can be supplied to the surface of the substrate W, whereby the electrolytic processing can be conducted efficiently.

More specifically, by allowing pure water or ultrapure water to flow within the ion exchanger 56, a sufficient amount of water can be supplied to a functional group (sulfonic acid group in the case of an ion exchanger carrying a strongly acidic cation-exchange group) thereby to increase the amount of dissociated water molecules, and the process product (including a gas) formed by the reaction between the conductor film (copper film 6) and hydroxide ions (or OH radicals) can be removed by the flow of water, whereby the processing efficiency can be enhanced. The flow of pure water or ultrapure water is thus necessary, and the flow of water should desirably be constant and uniform. The constancy and uniformity of the flow of water leads to constancy and uniformity in the supply of ions and the removal of the process product, which in turn leads to constancy and uniformity in the processing. This embodiment is not a soak type. Compared with the soak type apparatus, the not-soak type apparatus is simple in an arrangement because there isn't the necessity to control contamination of the liquid in the container.

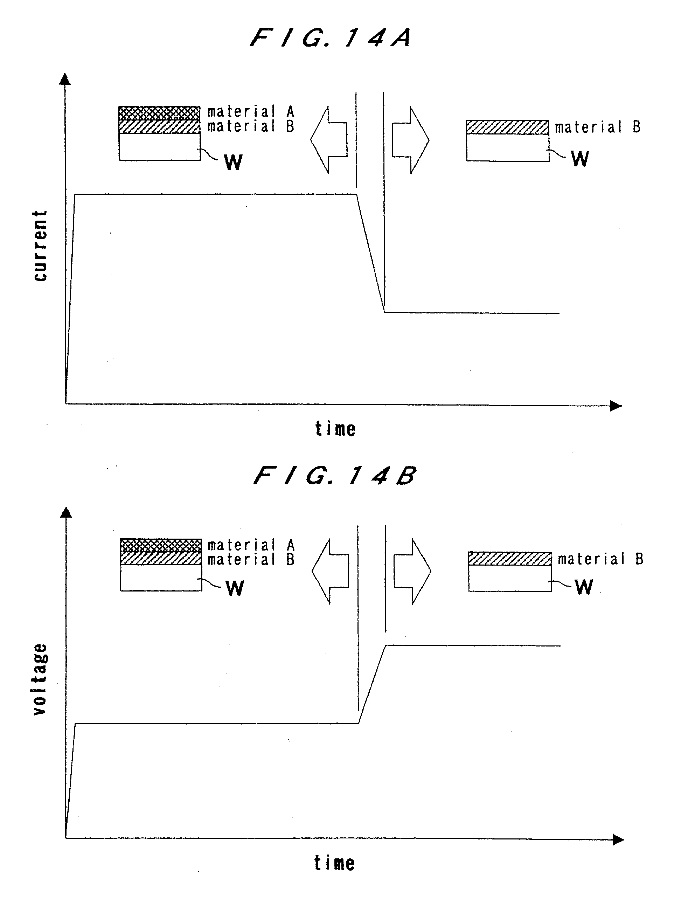

The monitor 42 monitors the voltage applied between the processing electrodes 50 and the feeding electrodes 52 or the electric current flowing therebetween to detect the end point (terminal of processing). It is noted in this connection that in electrolytic processing an electric current (applied voltage) varies, depending upon the material to be processed, even with the same voltage (electric current) . For example, as shown in FIG. 14A, when an electric current is monitored in electrolytic processing of the surface of a substrate W to which a film of material B and a film of material A are laminated in this order, a constant electric current is observed during the processing of material A, but it changes upon the shift to the processing of the different material B. Likewise, as shown in FIG. 14B, though a constant voltage is applied between the processing electrodes 50 and the feeding electrodes 52 during the processing of material A, the voltage applied changes upon the shift to the processing of the different material B. FIG. 14A illustrates, by way of example, a case in which an electric current is harder to flow in electrolytic processing of material B compared to electrolytic processing of material A, and FIG. 14B illustrates a case in which the applied voltage becomes higher in electrolytic processing of material B compared to electrolytic processing of material A. As will be appreciated from the above-described example, the monitoring of changes in electric current or in voltage can surely detect the end point.

Though this embodiment shows the case where the monitor 42 monitors the voltage applied between the processing electrodes 50 and the feeding electrodes 52, or the electric current flowing therebetween to detect the end point of processing, it is also possible to allow the monitor 42 to monitor a change in the state of the substrate being processed to detect an arbitrarily set end point of processing. In this case, the end point of processing refers to a point at which a desired processing amount is attained for a specified region in a surface to be processed, or a point at which an amount corresponding to a desired processing amount is attained in terms of a parameter correlated with a processing amount for a specified region in a surface to be processed. By thus arbitrarily setting and detecting the end point of processing even in the middle of processing, it becomes possible to conduct a multi-step electrolytic processing. This holds also for the below-described embodiments.

In this connection, as shown in FIG. 4B, it is possible to form a window extending through the electrode section 48 for transmitting a light therethrough and provide beneath the electrode section 48 a film-thickness sensor (film-thickness detection section) S having a light-emitting section for emitting a light and a light-receiving section for receiving a light. The film-thickness sensor S can measure the film thickness of a portion, to be processed, being processed in situ based on the detected change in the intensity of the reflected light. The end point of processing can be detected based on the results of the film-thickness measurement.

After completion of the electrolytic processing, the power source 80 is disconnected, and the rotation of the substrate holder 46 and of the electrode section 48 is stopped. Thereafter, the substrate holder 46 is raised, and is carried to the pusher 34 by the swingable arm 44 to place the substrate W on the pusher 34. The transport robot 38 takes the substrate W from the pusher 34 and, if necessary, transports the substrate to the reversing machine 32 for reversing it, and then returns the substrate W to the cassette in the loading/unloading unit 30.

When electrolytic processing of a workpiece is conducted without interposing an ion exchanger between the processing electrode and the workpiece, the electric resistance is proportional to "the distance between the workpiece and the processing electrode (electrode-to-electrode distance)". This is because as the distance of ion migration becomes smaller, the less energy is required for ion migration. In the presence of ultrapure water, for example, the electric resistance is 18.25 MΩ (0.54 µA at a voltage of 10 V) at the electrode-to-electrode distance of 1 cm, and 1.825 KΩ (5.4 mA at a voltage of 10 V) at the electrode-to-electrode distance of 1 µm.

In the case where an ion exchanger is interposed between the processing electrode and the workpiece, when the ion exchanger is brought close to the workpiece, but not into contract with it, the electric resistance is basically proportional to the "distance between the workpiece and the surface of the ion exchanger" as in the above case. When the ion exchanger is contacted with the workpiece, however, the electric resistance decreases to a further degree. This is ascribable to a large difference in ion concentration between the inside and outside of the ion exchanger.

More especially, in the inside of the ion exchanger, electrolytic dissociation of ultrapure water is promoted by the catalytic action whereby the concentration of ions (H⁺ and OH⁻) increases. Thus, the inside of the ion exchanger, due to the presence of an ion-exchange group, becomes a special field in which a high concentration of ions is (or can be) accumulated. In the outside of the ion exchanger, on the other hand, due to the absence of an ion-exchange group, the ions tend to return to the original state (H₂O) whereby the ion concentration is remarkably lower.

Accordingly, by bringing the ion exchanger into contact with the workpiece, the electric resistance can be kept at a certain low level irrespective of the distance between the workpiece and the processing electrode when the ion exchanger is in contact with the workpiece.

This embodiment shows the case of supplying pure water, preferably ultrapure water, between the electrode section 48 and the substrate W. The use of pure water or ultrapure water containing no electrolyte upon electrolytic processing can prevent impurities such as an electrolyte from adhering to and remaining on the surface of the substrate W. Further, copper ions or the like dissolved during electrolytic processing are immediately caught by the ion exchanger 56 through the ion-exchange reaction. This can prevent the dissolved copper ions or the like from re-precipitating on the other portions of the substrate W, or from being oxidized to become fine particles which contaminate the surface of the substrate W.

Ultrapure water has a high resistivity, and therefore an electric current is hard to flow therethrough. A lowering of the electric resistance is made by making the distance between the electrode and a workpiece as small as possible, or by interposing the ion exchanger between the electrode and a workpiece. Further, an electrolytic solution, when used in combination with ultrapure water, can further lower the electric resistance and reduce the power consumption. When electrolytic processing is conducted by using an electrolytic solution, the portion of a workpiece that undergoes processing ranges over a slightly wider area than the area of the processing electrode. In the case of the combined use of ultrapure water and the ion exchanger, on the other hand, since almost no electric current flows through ultrapure water, electric processing is effected only within the area of a workpiece that is equal to the area of the processing electrode and the ion exchanger.

It is possible to use, instead of pure water or ultrapure water, an electrolytic solution obtained by adding an electrolyte to pure water or ultrapure water. The use of such an electrolytic solution can further lower the electric resistance and reduce the power consumption. A solution of a neutral salt such as NaCl or Na₂SO₄, a solution of an acid such as HCl or H₂SO₄, or a solution of an alkali such as ammonia, may be used as the electrolytic solution, and these solutions may be selectively used according to the properties of the workpiece. When the electrolytic solution is used, it is preferred to provide a slight interspace between the substrate W and the ion exchanger 56 so that they are not in contact with each other. To avoid contamination of the wafer induced by an electrolytic solution, it is better to use a dilute electrolytic solution which electric conductivity is not more than 500 µs/cm. Therefore, the cleanliness of the processed workpiece can be increased.

Further, it is also possible to use, instead of pure water or ultrapure water, a liquid obtained by adding a surfactant to pure water or ultrapure water, and having an electric conductivity of not more than 500 µS/cm, preferably not more than 50 µS/cm, more preferably not more than 0.1 µS/cm (resistivity of not less than 10 MΩ·cm). Due to the presence of a surfactant, the liquid can form a layer, which functions to inhibit ion migration evenly, at the interface between the substrate W and the ion exchanger 56, thereby moderating concentration of ion exchange (metal dissolution) to enhance the flatness of the processed surface. The surfactant concentration is desirably not more than 100 ppm. When the value of the electric conductivity is too high, the current efficiency is lowered and the processing rate is decreased. The use of the liquid having an electric conductivity of not more than 500 µS/cm, preferably not more than 50 µS/cm, more preferably not more than 0.1 µS/cm, can attain a desired processing rate.

According to the present invention, the processing rate can be considerably enhanced by interposing the ion exchanger 56 between the substrate W and the processing and feeding electrodes 50, 52. In this regard, electrochemical processing using ultrapure water is effected by a chemical interaction between hydroxide ions in ultrapure water and a material to be processed. However, the amount of the hydroxide ions acting as reactant in ultrapure water is as small as 10⁻⁷ mol/L under normal temperature and pressure conditions, so that the removal processing efficiency can decrease due to reactions (such as an oxide film-forming reaction) other than the reaction for' removal processing. It is therefore necessary to increase hydroxide ions in order to conduct removal processing efficiently. A method for increasing hydroxide ions is to promote the dissociation reaction of ultrapure water by using a catalytic material, and an ion exchanger can be effectively used as such a catalytic material. More specifically, the activation energy relating to water-molecule dissociation reaction is lowered by the interaction between functional groups in an ion exchanger and water molecules, whereby the dissociation of water is promoted to thereby enhance the processing rate.

It may be possible to omit the ion exchanger 56, and supply pure water or ultrapure water between the substrate W and the processing and feeding electrodes 50, 52. Though the processing rate is lowered by the omission of the ion exchanger 56, the electrolytic processing is effective especially for removing an extremely thin film. Moreover, this excludes the possibility that extra impurities such as an electrolyte will adhere to and remain on the surface of the substrate W.

Further, according to this embodiment, the ion exchanger 56 is brought into contact with or close to the substrate W upon electrolytic processing. When the ion exchanger 56 is positioned close to the substrate W, though depending on the distance therebetween, the electric resistance is large to some degree and, therefore, a somewhat large voltage is necessary to provide a requisite electric current density. However on the other hand, because of the non-contact relation, it is easy to form flow of pure water or ultrapure water along the surface of the substrate W, whereby the reaction product produced on the substrate surface can be efficiently removed. In the case where the ion exchanger 56 is brought into contact with the substrate W, the electric resistance becomes very small and therefore only a small voltage needs to be applied, whereby the power consumption can be reduced.

If a voltage is raised to increase the current density in order to enhance the processing rate, an electric discharge can occur when the electric resistance between the electrode and the substrate (workpiece) is large. The occurrence of electric discharge causes pitching on the surface of the workpiece, thus failing to form an even and flat processed surface. To the contrary, since the electric resistance is very small when the ion exchanger 56 is in contact with the substrate W, the occurrence of an electric discharge can be avoided.

When electrolytic processing of copper is conducted by using, as the ion exchanger 56, an ion exchanger having a cation-exchange group, the ion-exchange group of the ion exchanger (cation exchanger) 56 is saturated with copper after the processing, whereby the processing efficiency of the next processing is lowered. When electrolytic processing of copper is conducted by using, as the ion exchanger 56, an ion exchanger having an anion-exchange group, fine particles of a copper oxide can be produced and adhere to the surface of the ion exchanger (anion exchanger) 56, which particles can contaminate the surface of a next substrate to be processed.

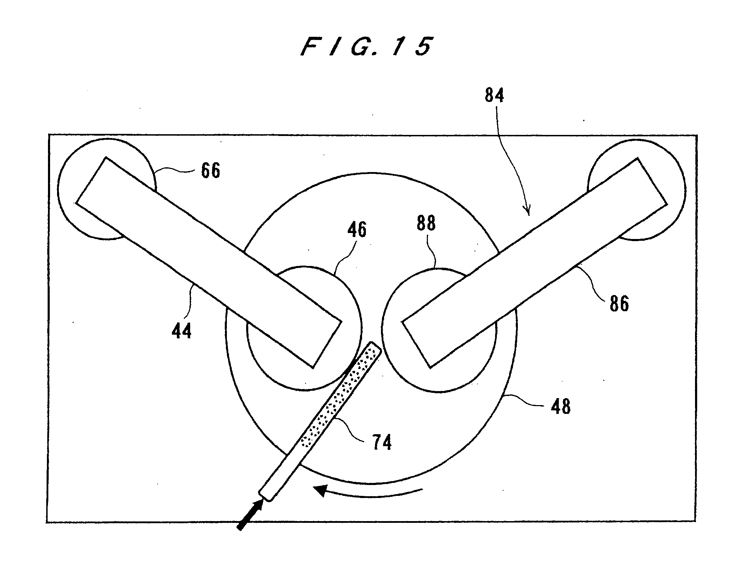

In order to obviate such drawbacks, as shown in FIG. 15, a regeneration section 84 for regenerating the ion exchanger 56 is provided, and the regeneration of the ion exchanger 56 can be effected during electrolytic processing. The regeneration section 84 comprises a swingable arm 86 having a structure similar to the swingable arm 44 that holds the substrate holder 46 and positioned at the opposite side to the swingable arm 44 across the electrode section 48, and a regeneration head 88 held by the swingable arm 86 at the free end thereof. In operation, the reverse electric potential to that for processing is given to the ion exchanger 56 from the power source 80, thereby promoting dissolution of extraneous matter such as copper adhering to the ion exchanger 56. The regeneration of the ion exchanger 56 during processing can thus be effected. The regenerated ion exchanger 56 is rinsed by pure water or ultrapure water supplied to the upper surface of the electrode section 48.

FIG. 16 shows the layout of a substrate processing apparatus according to another embodiment of the present invention. FIGS. 17 through 19 show an electrolytic processing device according to another embodiment of the present invention provided with the substrate processing apparatus. In the description given below, the same members as in the above-described embodiment are given the same reference numerals, and the description thereof is partly omitted. This holds for all of the below-described embodiments.

As shown in FIG. 16, the substrate processing apparatus comprises a pair of the loading/unloading units 30 as a carry-in and carry-out section for carrying in and carrying out a substrate W, the reversing machine 32 for reversing the substrate W, and an electrolytic processing device 36a, which are disposed in series. A transport robot 38a as a transport device is provided which can move parallel to these devices for transporting and transferring the substrate W therebetween. The substrate processing apparatus is also provided with the monitor 42 for monitoring a voltage applied between the processing electrode 50 and the feeding electrode 52 upon electrolytic processing in the electrolytic processing device 36a, or an electric current flowing therebetween.

In the electrolytic processing device 36a, the electrode section 48, in which the processing electrodes 50 and the feeding electrodes 52 are embedded, is designed to have a slightly larger diameter than that of the substrate W to be held by the substrate holder 46. By the actuation of the hollow motor 70, the electrode section 48 makes a revolutionary movement with the distance between the central axis of the hollow motor 70 and the central axis of the electrode section 48 as radius, without rotation about its own axis, i.e. the so-called scroll movement (translational rotation).

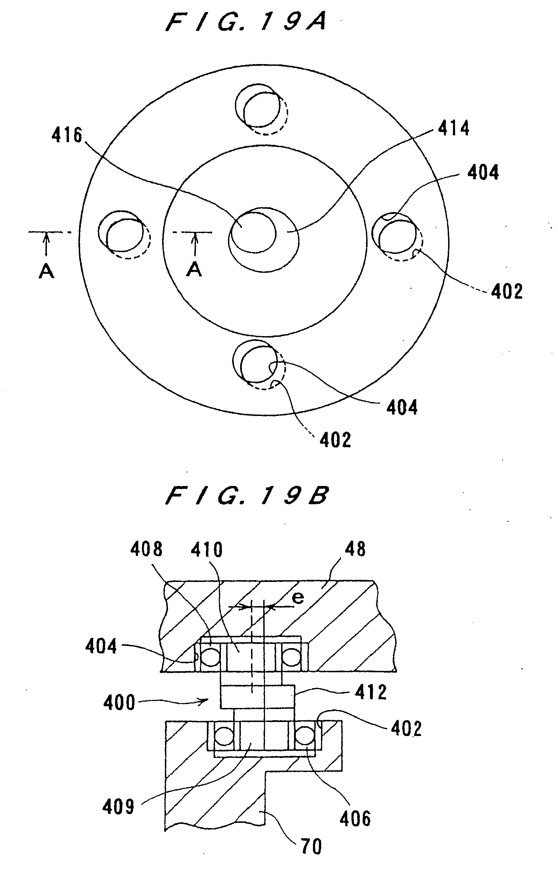

In this regard, as shown in FIGS. 19A and 19B, three or more (four in FIG. 19A) of rotation-prevention mechanisms 400 are provided in the circumferential direction between the electrode section 48 and the hollow motor 70. In particular, a plurality of depressions 402 and 404 are formed at equal intervals in the circumferential direction at the corresponding positions in the upper surface of the hollow motor 70 and in the lower surface of the electrode 48. Bearings 406 and 408 are fixed in each depression 402 and depression 404, respectively. As shown in FIG. 19B, a connecting member 412, which has two shafts 409, 410 that are eccentric to each other by eccentricity "e" , is coupled to each pair of the bearings 406, 408 by inserting the respective ends of the shafts 409, 410 into the bearings 406, 408. Further, a drive end 416, formed at the upper end portion of the main shaft 414 of the hollow motor 70 and arranged eccentrically position to the center of the main shaft, is rotatably connected, via a bearing (not shown), to a lower central portion of the electrode section 48. The eccentricity is also "e". Accordingly, the electrode section 48 is allowed to make a translational movement along a circle with radius "e".

According to this embodiment, it is not possible to supply pure water or ultrapure water to the upper surface of the electrode section 48 from above the electrode section 48 during electrolytic processing. Thus, as shown in FIG. 17, pure water or ultrapure water is supplied to the upper surface of the electrode section 48 only through a through-hole 414a formed in the main shaft 414 and the through-hole 48a formed in the electrode section 48. Further, since the electrode section 48 does not rotate about its own axis, the slip ring 78 is omitted. Furthermore, as shown in FIG. 18, a ultrapure water-spray nozzle 90 as a regeneration section is retreatably provided beside the electrode section 48, which sprays ultrapure water onto the ion exchanger 56 after the electrolytic processing, thereby regenerating the ion exchanger 56. The other construction is the same as the first embodiment.

According to the electrolytic processing device 36a, electrolytic processing of the surface of the substrate W is carried out by rotating, via the substrate holder 46, the substrate W which is in contact with or close to the ion exchanger 56, and, at the same time, allowing the electrode section 48 to make a scroll movement by the actuation of the hollow motor 70, while supplying pure water or ultrapure water to the upper surface of the electrode section 48 and applying a given voltage between the processing electrodes 50 and the feeding electrodes 52.

The flow of the substrate W in handling thereof in the substrate processing apparatus of this embodiment is the same as in the'above-described embodiment shown in FIG. 4, except that the substrate W is transferred directly between the transport robot 38a and the electrolytic processing device 36a (i.e. not via the pusher) , and therefore the description thereof is omitted here.

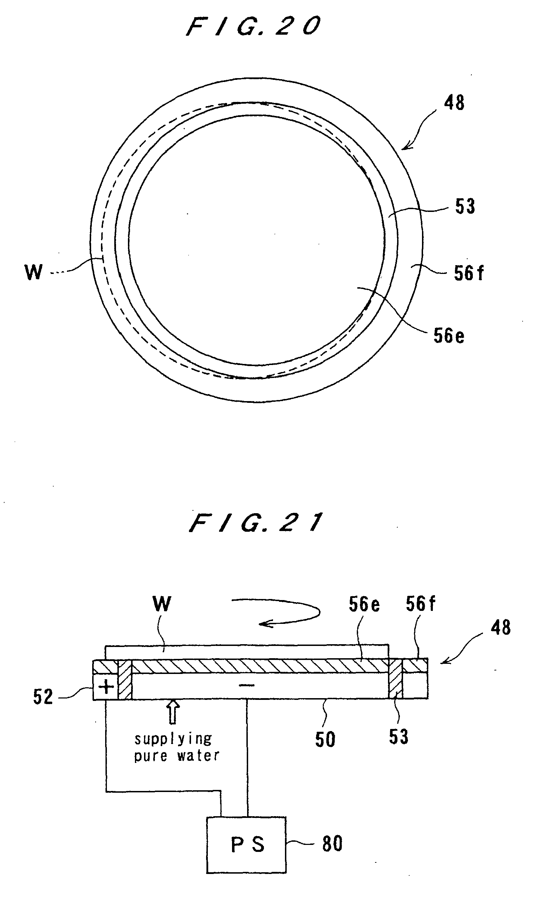

FIGS. 20 and 21 show a variation of the electrolytic processing device 36a. In this electrolytic processing device 36a, the electrode section 48, which makes a scroll movement, comprises a disc-shaped processing electrode 50 and a ring-shaped feeding electrode 52 that surrounds the outer periphery of the processing electrode 50, which are separated by a ring-shaped insulator 53. Further, the upper surface of the processing electrode 50 is covered with an ion exchanger 56e and the upper surface of the feeding electrode 52 is covered with an ion-exchanger 56f, the respective ion exchangers 56e, 56f being separated by the insulator 53. When rotating the substrate W, which is in contact with or close to the ion exchangers 56e, 56f, and, at the same time, allowing the electrode section 48 to make a scroll movement as described above, part of the substrate W is always positioned above the feeding electrode 52, so that the substrate W can receive electricity therefrom. The other construction is the same as in the electrolytic processing device shown in FIGS. 16 through 19. According to this embodiment, the current efficiency is enhanced by surrounding the processing electrode 50 with the feeding electrode 52, and a uniform processing can be conducted over the substantially entire surface of the substrate W.

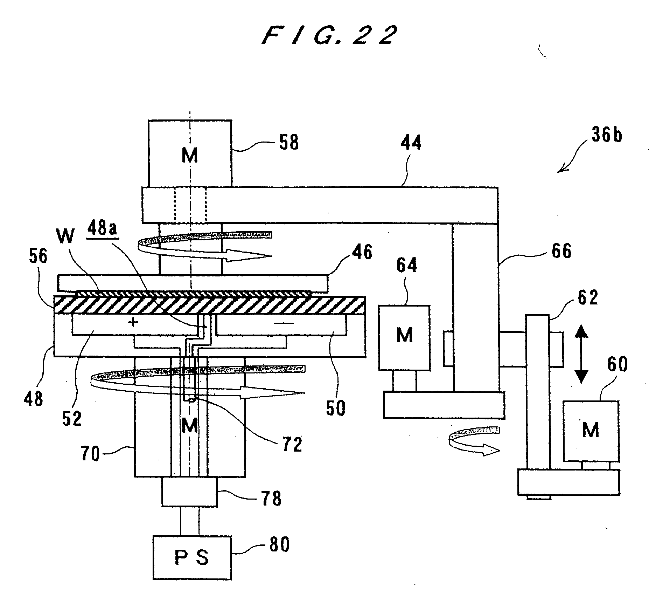

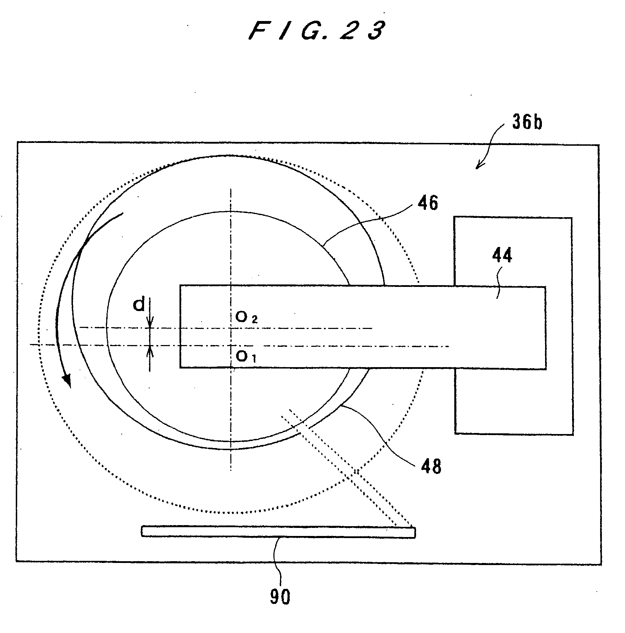

FIGS. 22 and 23 show an electrolytic processing device 36b according to another embodiment of the present invention. In this electrolytic processing device 36b, the rotational center O₁ of the electrode section 48 is distant from the rotational center O₂ of the substrate holder 46 by a distance d; and the electrode section 48 rotates about the rotational center O₁ and the substrate holder 46 rotates about the rotational center O₂. Further, the processing electrodes 50 and the feeding electrodes 52 are connected to the power source 80 via the slip ring 78. The other construction is the same as in the embodiment shown in FIGS. 18 and 19, and hence the description thereof is omitted here.

According to the electrolytic processing device 36b, electrolytic processing of the surface of the substrate W is carried out by rotating the substrate W via the substrate holder 46 and, at the same, rotating the electrode section 48 by the actuation of the hollow motor 70, while supplying pure water or ultrapure water to the upper surface of the electrode section 48 and applying a given voltage between the processing electrodes 50 and the feeding electrodes 52.

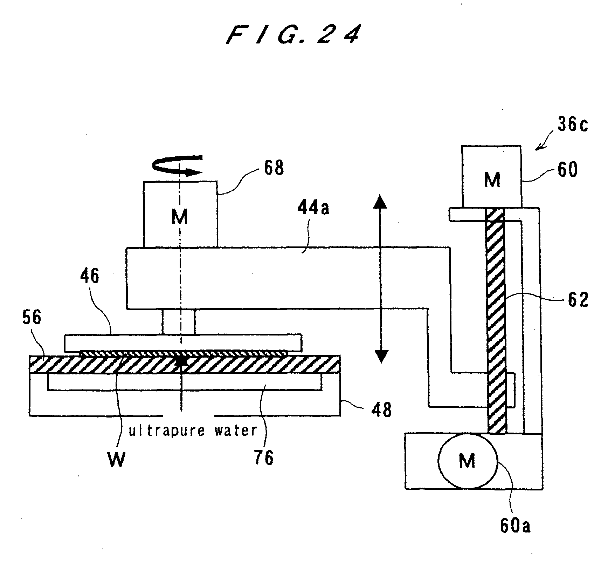

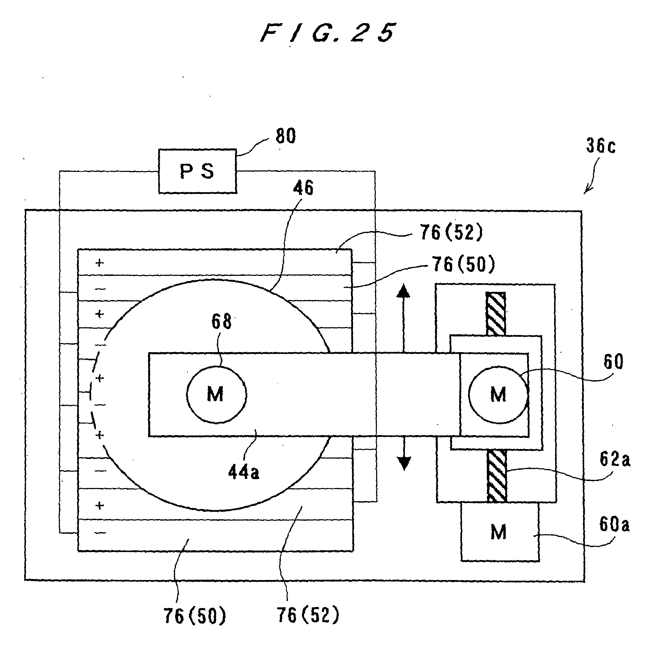

FIGS. 24 and 25 show an electrolytic processing device 36c according to yet another embodiment of the present invention. This electrolytic processing device 36c employs a rectangular fixed-type electrode section 48 and a substrate holder 46 that can move up and down, does not swing, and makes a reciprocating movement in a horizontal direction. More specifically, electrode plates 76, extending in the width direction of the rectangular electrode 48 over the entire length thereof, are disposed in parallel in the upper surface of the electrode section 48, and the cathode and the anode of the power source 80 are alternately connected to the electrode plates 76, so that the electrode plates 76 connected to the cathode becomes the processing electrodes 50 or, adversely, the electrode plates 76 connected to the anode becomes the feeding electrodes 52. The substrate holder 46, on the other hand, is secured to the free end of a lifting arm 44a that moves vertically via the ball screw 62 by the actuation of the motor 60 for vertical movement, is allowed to rotate about its own axis by the actuation of the motor 68 for rotation, and is also allowed to reciprocate together with the lifting arm 44a, via a ball screw 62a by the actuation of a motor 60a for reciprocation, in the orthogonal direction relative to the electrode plates 76.

According to the electrolytic processing device 36c, electrolytic processing of the surface of the substrate W is carried out by rotating, via the substrate holder 46, the substrate W which is in contact with or close to the ion exchanger 56 and, at the same time, reciprocating the substrate holder 46 by the actuation of the motor 60a for reciprocation, while supplying pure water or ultrapure water to the upper surface of the electrode section 48 and applying a given voltage between the processing electrodes 50 and the feeding electrodes 52.

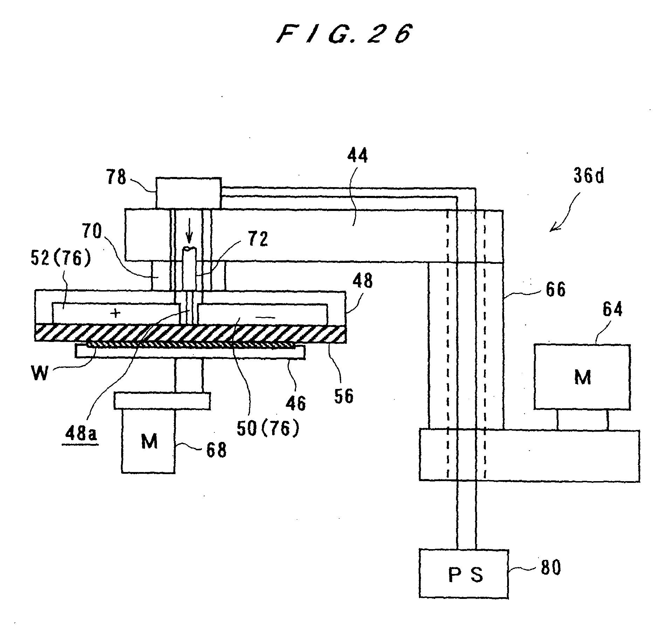

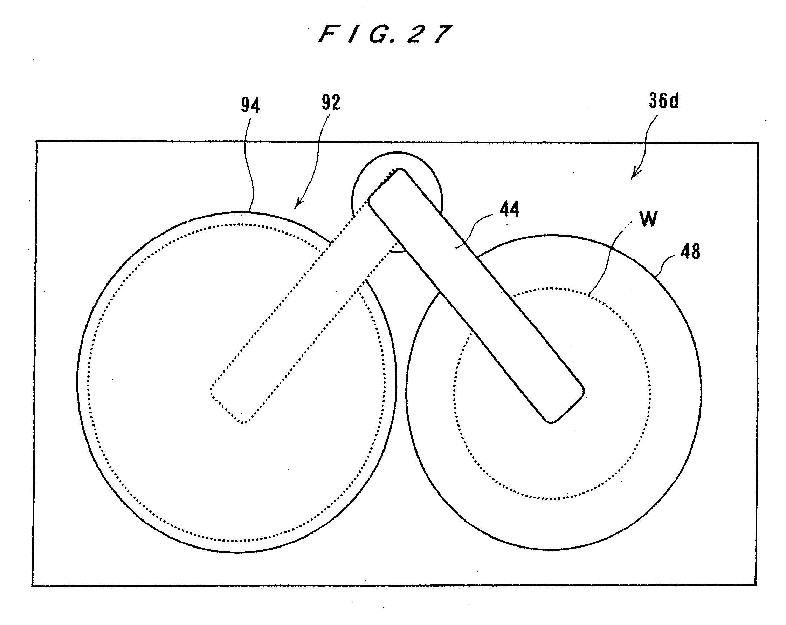

FIGS. 26 and 27 show an electrolytic processing device 36d according to yet another embodiment of the present invention. In this electrolytic processing device 36d, the positional relationship between the substrate holder 46 and the electrode section 48 in the preceding embodiments is reversed, and the substrate W is held with its front surface upward (so-called "face-up" manner) so that electrolytic processing is conducted to the upper surface of the substrate. Thus, the substrate holder 46 is disposed beneath the electrode section 48, holds the substrate W with its front surface upward, and rotates about its own axis by the actuation of the motor 68 for rotation. On the other hand, the electrode section 48, which has the processing electrodes 50 and the feeding electrodes 52 that are covered with the ion exchanger 56, is disposed above the substrate holder 46, is held with its front surface downward by the swingable arm 44 at the free end thereof, and rotates about its own axis by the actuation of the hollow motor 70. Further, wires extending from the power source 80 pass through a hollow portion formed in the shaft 66 for swinging and reach the slip ring 78, and further pass through the hollow portion of the hollow motor 70 and reach the processing electrodes 50 and the feeding electrodes 52 to apply a voltage therebetween.

Pure water or ultrapure water is supplied from the pure water supply pipe 72, via the through-hole 48a formed in the central portion of the electrode section 48, to the front surface (upper surface) of the substrate W.

A regeneration section 92 for regenerating the ion exchanger 56 mounted on the electrode section 48 is disposed beside the substrate holder 46. The regeneration section 92 includes a regeneration tank 94 filled with e.g. a dilute acid solution. In operation, the electrode section 48 is moved by the swingable arm 44 to a position right above the regeneration tank 94, and is then lowered so that at least the ion exchanger 56 of the electrode section 48 is immersed in the acid solution in the regeneration tank 94. Thereafter, the reverse electric potential to that for processing is given to the electrode plates 76, i.e. by connecting the processing electrodes 50 to the anode of the power source 80 and connecting the feeding electrodes 52 to the cathode, thereby promoting dissolution of extraneous matter such as copper adhering to the ion exchanger 56 to thereby regenerate the ion exchanger 56. The regenerated ion exchanger 56 is rinsed by e.g. ultrapure water.

Further, according to this embodiment, the electrode section 48 is designed to have a sufficiently larger diameter than the substrate W held by the substrate holder 48. Electrolytic processing of the surface of the substrate W is conducted by lowering the electrode section 48 so that the ion exchanger 56 contacts or gets close to the substrate W held by the substrate holder 46, then rotating the substrate holder 46 and the electrode section 48 and, at the same time, swinging the swingable arm 44 to move the electrode section 48 along the upper surface of the substrate W, while supplying pure water or ultrapure water to the upper surface of the substrate and applying a given voltage between the processing electrode 50 and the feeding electrode 52.

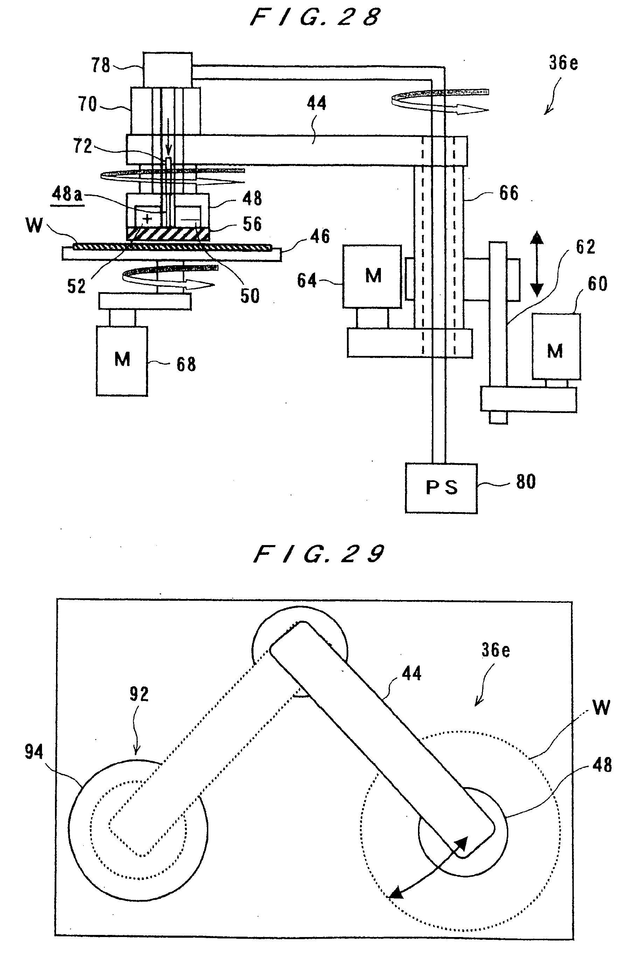

FIGS. 28 and 29 show an electrolytic processing device 36e according to yet another embodiment of the present invention. This electrolytic processing device 36e employs, as the electrode section 48, such one that has a sufficiently smaller diameter than that of the substrate W held by the substrate holder 46 so that the surface of the substrate may not be entirely covered with the electrode section 48. The other construction is the same as in the embodiment shown in FIGS. 26 and 27. The above construction can make the electrode section small and compact, and, in addition, can prevent a generated gas from adhering to the substrate.

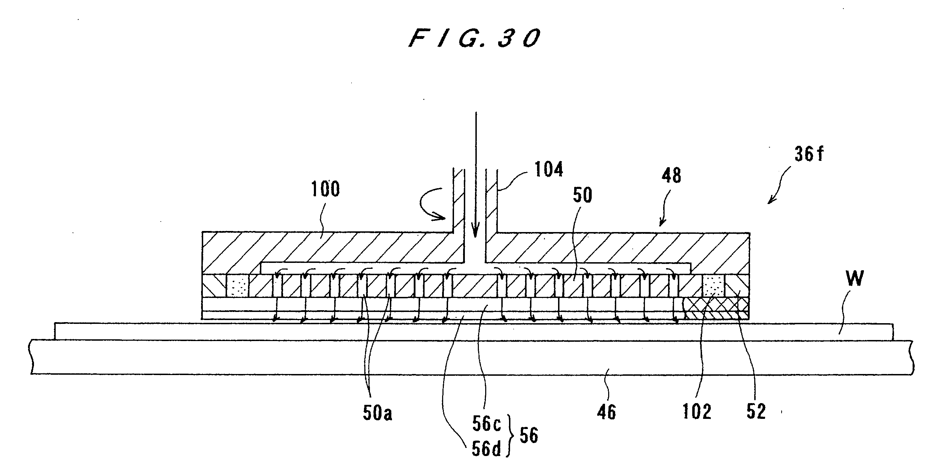

FIG. 30 shows an electrolytic processing device 36f according to yet another embodiment of the present invention. In this electrolytic processing device 36f, the electrode section 48 is disposed above the substrate holder 46 that holds the substrate W with its front surface upward. The electrode section 48 comprises a disk-shaped base 100 composed of insulating material, a disc-shaped processing electrode 50 having through-holes 50a for supplying pure water or ultrapure water, and a ring-shaped feeding electrode 52, which are separated by a ring-shaped insulator 102. The processing electrode 50 and the feeding electrode 52 are mounted on the lower surface of the base 100 in the same plane. Further, on the lower surface of the processing electrode 50 and the feeding electrode 52 is mounted an ion exchanger 56 which is composed of e.g. fibers containing a strongly acidic cation-exchange group and promotes the dissociation reaction of pure water or ultrapure water. The base 100 is rotatable, and is connected to the lower end of a hollow rotating shaft 104. Pure water or ultrapure water is supplied through the hollow portion of the rotating shaft 104 to the inside of the base 100. Further in this embodiment, an ion exchanger having a two-layer structure of a soft exchanger 56c and a hard exchanger 56d, both having the same level of resistivity, is employed as the ion exchanger 56.

By thus making the ion exchanger 56 a multi-layer structure consisting of laminated layers of ion-exchange materials, such as a nonwoven fabric, a woven fabric and a porous membrane, it is possible to increase the total ion exchange capacity whereby formation of an oxide, for example in removal (polishing) processing of copper, can be restrained to thereby avoid the oxide adversely affecting the processing rate. In this regard, when the total ion exchange capacity of an ion exchanger is smaller than the amount of copper ions taken in the ion exchanger during removal processing, the oxide should inevitably be formed on the surface or in the inside of the ion exchanger, which adversely affects the processing rate. Thus, the formation of the oxide is governed by the ion exchange capacity of an ion exchanger, and copper ions exceeding the capacity should become the oxide. The formation of an oxide can thus be effectively restrained by using, as the ion exchanger 56, a multi-layer ion exchanger composed of laminated layers of ion-exchange materials which has enhanced total ion exchange capacity. Incidentally, the formation of an oxide can also be restrained by regenerating an ion exchanger so as to suppress accumulation of copper ions within the ion exchanger.

Further, when an interconnect pattern, for example an interconnect pattern composed of copper film 6 as shown in FIG. 85, is formed by removal (polishing) processing, the copper film 6 filled into the trench is likely to be hollowed out or peeled off after the processing. This may be influenced by the hardness and form of an outermost ion exchanger (ion-exchange material) to be contacted with the copper film 6. It is then considered that the above defects may be obviated by making the ion exchanger 56 a multi-layer structure, as in this embodiment, and using the ion exchanger (ion-exchange material) which meets the requirements of ① good surface smoothness, ② hard material and ③ water-permeable, such as a porous membrane or a woven fabric, as the outermost ion exchanger.

According to this embodiment, pure water or ultrapure water fed through a feed line into the rotating shaft 104 is allowed to flow, under centrifugal force due to rotation of the base 100, through the through-holes 50a formed in the processing electrode 50 and supplied to the ion exchanger 56. The pure water or ultrapure water supplied dissociates by the catalytic action of the ion exchanger 56 to produce hydroxide ions. Since the processing electrode 50 and the feeding electrode 52 are separated by the insulator 102, migration of the hydroxide ions is intercepted by the insulator 102. Further, when the substrate W is in an electrically insulated state, the portion of the substrate W facing the processing electrode (e. g. cathode) 50 functions as an anode, and the portion of the substrate W facing the feeding electrode (e.g. anode) 52 functions as a cathode. Accordingly, electrochemical dissolution occurs in the anode portion of the substrate W facing the processing electrode 50.

In the case where an ion exchanger is contacted with the substrate W, the ion exchanger can deteriorate due to the sliding movement. Such deterioration can, however, be avoided by making the ion exchanger a two-layer structure in which the outer layer to be contacted with the substrate W is composed of e.g. a woven fabric or a porous membrane, as described above, or by using such material as a pad having an ion-exchange ability to enhance the mechanical strength.

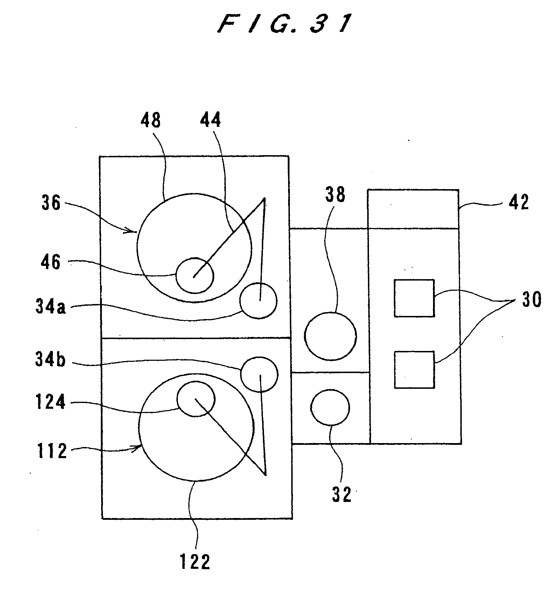

FIG. 31 shows a substrate processing apparatus according to yet another embodiment of the present invention provided with the electrolytic processing device 36. This substrate processing apparatus comprises a pair of the loading/unloading units 30 as a carry-in and carry-out section for carrying in and carrying out a cassette housing a substrate W, the reversing machine 32, pushers 34a, 34b for transferring the substrate W, the electrolytic processing device 36, and a CMP device 112. The fixed-type transport robot 38 is provided in between the loading/unloading units 30, the reversing machine 32 and the pushers 34a, 34b as a transport device for transporting and transferring the substrate W therebetween. The substrate processing apparatus is also provided with the monitor 42 for monitoring a voltage applied between the processing electrode 50 and the feeding electrode 52 upon electrolytic processing in the electrolytic processing device 36, or an electric current flowing therebetween.

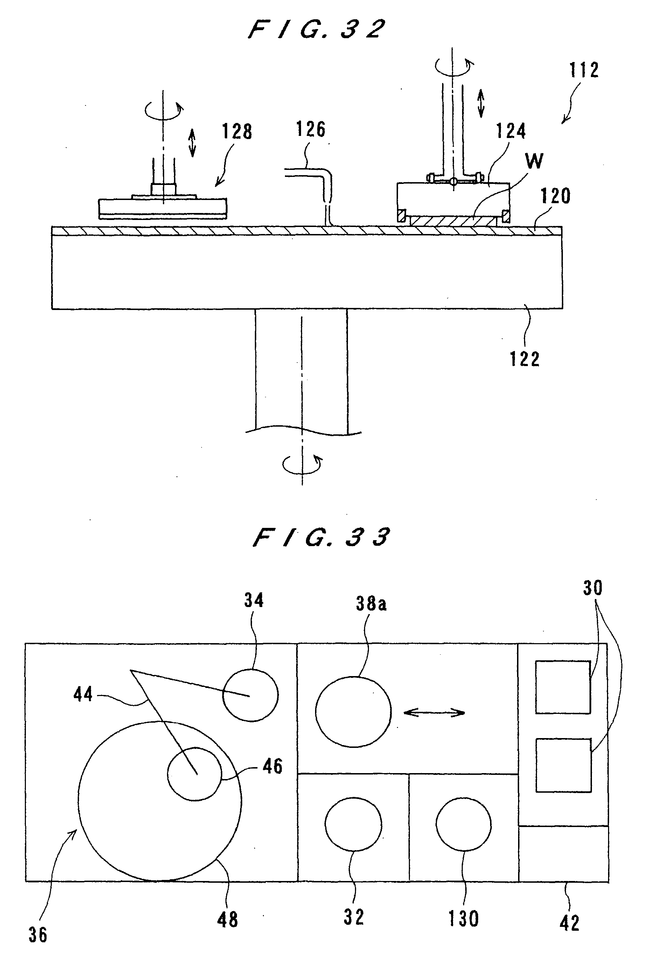

FIG. 32 shows an example of the CMP device 112. The CMP device 112 comprises a polishing table 122 having a polishing surface composed of a polishing cloth (polishing pad) which is attached to the upper surface of the polishing table 122, and a top ring 124 for holding a substrate W with its surface to be polished facing the polishing table 122. Polishing of the surface of the substrate W is carried out by rotating the polishing table 122 and the top ring 124 respectively, and supplying an abrasive liquid from an abrasive liquid nozzle 126 disposed above the polishing table 122, while pressing the substrate W against the polishing cloth 120 of the polishing table 122 at a given pressure by the top ring 124. As the abrasive liquid supplied from the abrasive liquid nozzle 126, a suspension of abrasive particles, such as fine particles of silica, in an alkali solution may be used. By the combination of chemical polishing by an alkali and mechanical polishing by abrasive particles, i.e. chemical mechanical polishing, the substrate W can be polished into a flat mirror surface.

The polishing power of the polishing surface of the polishing cloth 120 decreases with a continuous polishing operation. In order to restore the polishing power, a dresser 128 is provided to conduct dressing of the polishing cloth 120, for example at the time of changing the substrate W. In the dressing treatment, while rotating the dresser 128 and the polishing table 122 respectively, the dressing surface (dressing member) of the dresser 128 is pressed against the polishing cloth 120 of the polishing table 122, thereby removing the abrasive liquid and chips adhering to the polishing surface and, at the same time, flattening and dressing the polishing surface, whereby the polishing surface is regenerated.

According to this substrate processing apparatus, a substrate W is taken by the transport robot 38 out of the cassette set in the loading/unloading unit 30. The substrate W is transported to the reversing machine 32, according to necessity, to reverse the substrate W, and is then transported by the transport robot 38 to the pusher 34a beside the electrolytic processing device 36. The substrate W is transferred from the pusher 34a to the substrate holder 46 of the electrolytic processing device 36. Rough cutting (etching) by electrolytic processing of the surface of the substrate W is conducted in the electrolytic processing device 36. After completion of the processing, the substrate W is returned to the pusher 34a. Thereafter, the substrate W on the pusher 34a is transported by the transport robot 38 to the pusher 34b beside the CMP device 112, and is then transferred to the top ring 124 of the CMP device 112. Finishing by CMP polishing of the substrate W is conducted in the CMP device 112. After completion of the CMP polishing, the substrate W is returned to the pusher 34b. Thereafter, the transport robot 38 takes the substrate W from the pusher 34b and, after transporting the substrate W to the reversing machine 32, according to necessity, to reverse the substrate, returns the substrate W to the cassette in the loading/unloading unit 30.

Though in this embodiment rough cutting of the substrate W is conducted by electrolytic processing in the electrolytic processing device 36 and finishing of the substrate W is conducted by CMP polishing in the CMP device 112, it is possible to conduct rough cutting of the substrate W by CMP polishing in the CMP device 112 and conduct finishing of the substrate W by electrolytic processing in the electrolytic processing device 36. A load upon CMP processing can thus be reduced.

FIG. 33 shows a substrate processing apparatus according to yet another embodiment of the present invention provided with the electrolytic processing device 36. This substrate processing apparatus comprises a pair of the loading/unloading units 30 as a carry-in and carry-out section for carrying in and carrying out a cassette housing a substrate W, the reversing machine 32, the pusher 34 for transferring the substrate W, the electrolytic processing device 36, and a cleaning device 130 for cleaning and drying the processed substrate W. A movable transport robot 38a is provided in a region between the loading/unloading units 30, the reversing machine 32 and the pusher 34 as a transport device for transporting and transferring the substrate W therebetween. The substrate processing apparatus is also provided with the monitor 42 for monitoring a voltage applied between the processing electrode 50 and the feeding electrode 52 upon electrolytic processing in the electrolytic processing device 36, or an electric current flowing therebetween.

According to this substrate processing apparatus, the substrate W having been carried in a dry state and undergone electrolytic processing in the electrolytic processing device 36 is reversed, according to necessity, and transported to the cleaning device 130 where the substrate is cleaned and dried, and the substrate can then be returned, in a dry state, to the cassette in the loading/unloading unit 30 (dry-in/dry-out).

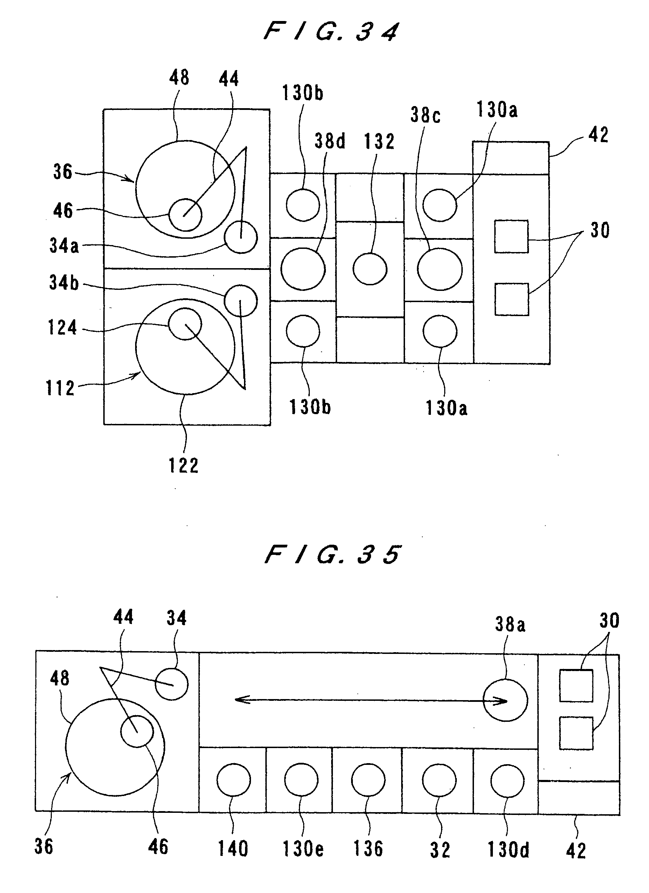

FIG. 34 shows a substrate processing apparatus according to yet another embodiment of the present invention provided with the electrolytic processing device 36. This substrate processing apparatus comprises, as the same in the above-described embodiment shown in FIG. 31, a pair of the loading/unloading units 30 as a carry-in and carry-out section for carrying in and carrying out a cassette housing a substrate W, the pushers 34a and 34b, the electrolytic processing device 36 and the CMP device 112, and further comprises a couple of first cleaning devices 130a and a couple of second cleaning devices 130b. Further, a temporary storage table 132 that has a function of traversing a substrate is provided between the first cleaning devices 130a and the second cleaning devices 130b. A first transport robot 38c is provided at a certain place between the loading/unloading units 30, the first cleaning devices 130a and the temporary storage table 132 as a transport device for transporting and transferring the substrate W therebetween; and a second transport robot 38d is provided at a certain place between the temporary storage table 132, the second cleaning devices 130b and the pushers 34a, 34b as a transport device for transporting and transferring the substrate W therebetween. The substrate processing apparatus is also provided with the monitor 42 for monitoring a voltage applied between the processing electrodes 50 and the feeding electrodes 52 upon electrolytic processing in the electrolytic processing device 36.

According to this substrate processing apparatus, the substrate W which has undergone rough cutting, for example, by electrolytic processing in the electrolytic processing device 36 and finishing by CMP polishing in the CMP device 112, as in the above-described embodiment shown in FIG. 31, is transported to the second cleaning device 130b for rough cleaning and is then temporarily stored on the temporary storage table 132 where the substrate is reversed, if necessary. Thereafter, the substrate W is transported to the first cleaning device 130a for finish cleaning and drying, and then can be returned, in a dry state, to the cassette in the loading/unloading section 30.

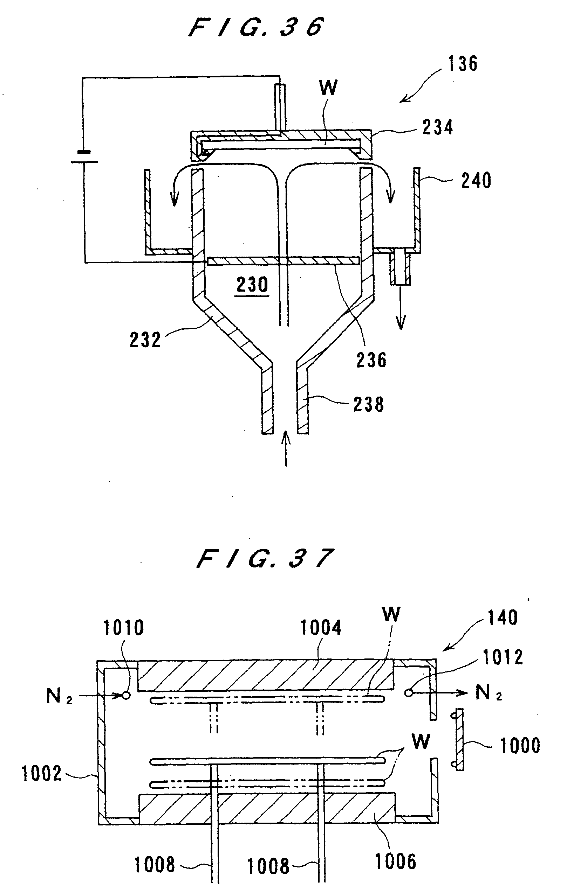

FIG. 35 shows a substrate processing apparatus according to yet another embodiment of the present invention provided with the electrolytic processing device 36. This substrate processing apparatus comprises a pair of the loading/unloading units 30 as a carry-in and carry-out section for carrying in and carrying out a cassette housing a substrate W, the pusher 34, and the electrolytic processing device 36. The substrate processing apparatus also comprises a cleaning device 130d for cleaning the processed substrate, the reversing machine 32, a plating device 136 for plating the surface of the substrate W, a cleaning device 130e for cleaning the plated substrate, and an annealing device 140 for annealing the plated substrate, which are disposed in series. A transport robot 38a as a transport device is provided which can move parallel to these devices for transporting and transferring the substrate W therebetween. The substrate processing apparatus is also provided the monitor 42 for monitoring a voltage applied between the processing electrodes 50 and the feeding electrodes 52 upon electrolytic processing in the electrolytic processing device 36.

FIG. 36 shows an example of the plating device 136. The plating device 136 includes a top-opened cylindrical plating tank 232 for containing a plating liquid 230, and a substrate holder 234 for detachably holding the substrate W with its front surface downward in such a position that the substrate W covers the top opening of the plating tank 232. In the inside of the plating tank 232, an anode plate 236 in a flat plate shape, which becomes an anode electrode when immersed in the plating liquid 230 with the substrate as a cathode, is disposed horizontally. The center portion of the bottom of the plating tank 232 communicates with a plating liquid ejecting pipe 238 for forming an ejecting flow of the plating liquid upwardly. Further, a plating liquid receiver 240 is provided around the upper outer periphery of the plating tank 232.

In operation, the substrate W held with its front surface downward by the substrate holder 234 is positioned above the plating tank 232 and a given voltage is applied between the anode plate 236 (anode) and the substrate W (cathode) while the plating liquid 230 is ejected upwardly from the plating liquid ejecting pipe 238 so that the ejecting flow of the plating liquid 230 hits against the lower surface (surface to be plated) of the substrate W, whereby a plating current is allowed to flow between the anode plate 236 and the substrate W, and a plated film is thus formed on the lower surface of the substrate W.

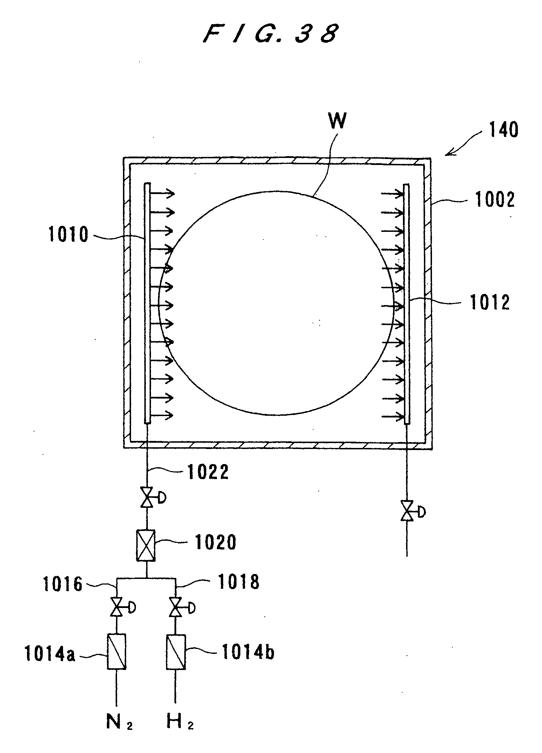

FIGS. 37 and 38 show an example of the annealing device 140. The annealing device 140 comprises a chamber 1002 having a gate 1000 for carrying in and carrying out the substrate W, a hot plate 1004 disposed in the chamber 1002 for heating the substrate W to e.g. 400°C, and a cool plate 1006 disposed beneath the hot plate 1004 in the chamber 1002 for cooling the substrate W by, for example, flowing a cooling water inside the hot plate 1004. The annealing device 140 also has a plurality of vertically movable elevating pins 1008 penetrating the cool plate 1006 and extending upward and downward therefrom for placing and holding the substrate W on the upper ends thereof. The annealing device 140 further includes a gas introduction pipe 1010 for introducing an antioxidant gas between the substrate W and the hot plate 1004 during annealing, and a gas discharge pipe 1012 for discharging the gas that has been introduced from the gas introduction pipe 1010 and flowed between the substrate W and the hot plate 1004. The pipes 1010 and 1012 are disposed on the opposite sides across the hot plate 1004.

The gas introduction pipe 1010 is connected to a mixed gas introduction line 1022 which in turn is connected to a mixer 1020 where a N₂ gas introduced through a N₂ gas introduction line 1016 containing a filter 1014a, and a H₂ gas introduced through a H₂ gas introduction line 1018 containing a filter 1014b, are mixed to form a mixed gas which flows through the mixed gas introduction line 1022 into the gas introduction pipe 1010.

In operation, the substrate W, which has been carried in the chamber 1002 through the gate 1000, is held on the lifting pins 1008 and the lifting pins 1008 are raised up to a position at which the distance between the substrate W held on the lifting pins 1008 and the hot plate 1004 becomes e.g. 0.1-1.0 mm. The substrate W is then heated to e.g. 400°C through the hot plate 1004 and, at the same time, the antioxidant gas is introduced from the gas introduction pipe 1010 and the gas is allowed to flow between the substrate W and the hot plate 1004 while the gas is discharged from the gas discharge pipe 1012, thereby annealing the substrate W while preventing its oxidation. The annealing treatment may be completed in about several tens of seconds to 60 seconds. The heating temperature of the substrate W may arbitrarily be selected in the range of 100-600°C.

After completion of the annealing, the lifting pins 1008 are lowered down to a position at which the distance between the substrate W held on the lifting pins 1008 and the cool plate 1006 becomes e.g. 0-0.5 mm. By introducing a cooling water into the cool plate 1006, the substrate W is cooled by the cool plate 1006 to a temperature of 100°C or lower in e.g. 10-60 seconds. The cooled substrate W is sent to the next step.

Though in this embodiment a mixed gas of N₂ gas with several % of H₂ gas is used as the above antioxidant gas, N₂ gas may be used singly.

According to the substrate processing apparatus of this embodiment, a substrate W, for example, having a seed layer 7 formed in the surface (see FIG. 85A) is taken, one at a time, by the transport robot 38a out of a cassette set in the loading/unloading section 30 and, after reversing the substrate W by the reversing machine 32 according to necessity, is carried into the plating device 136. Electrolytic copper plating, for example, is performed in the plating device 136 to form a copper film 6 (see FIG. 85B) as a conductor film (portion to be processed) on the surface of the substrate W. The substrate W after the plating treatment (the substrate having a conductor film such as the copper film) is transported to the cleaning device 130e for cleaning and drying, and is then transported to the annealing device 140, where the substrate W is annealed by heat treatment, and the annealed substrate is transported to the electrolytic processing device 36. Electrolytic processing of the surface (plated surface) of the substrate W is conducted in the electrolytic processing device 36 to remove unnecessary copper film 6 formed in the surface of the substrate, thereby forming copper interconnects composed of copper film 6 (see FIG. 85C). The substrate W after the electrolytic processing is reversed by the reversing machine 32, according to necessity, and is transported to the cleaning device 130d for cleaning and drying. The cleaned substrate W is reversed by the reversing machine 32, according to necessity, and returned to the cassette in the loading/unloading unit 30.

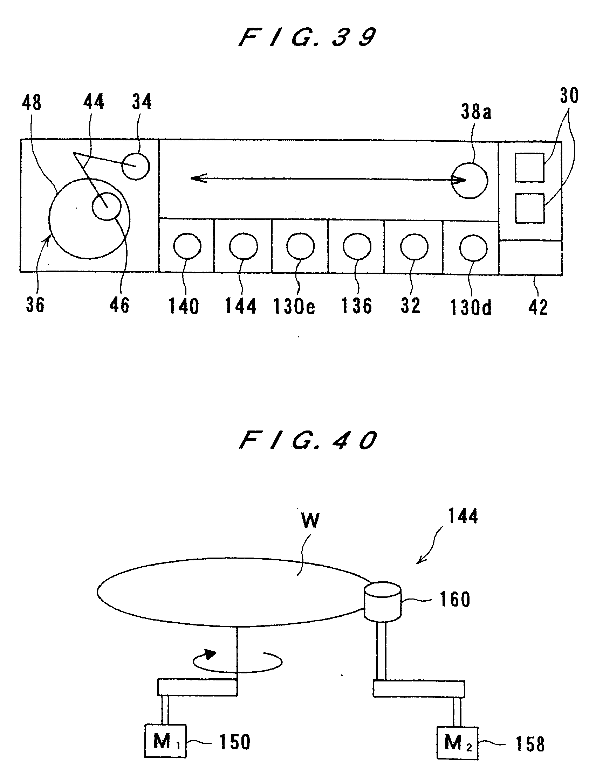

FIG. 39 shows a substrate processing apparatus according to yet another embodiment of the present invention provided with the electrolytic processing device 36. According to this embodiment, between the cleaning device 130e and the annealing device 140, both used also in the above-described embodiment shown in FIG. 35, is provided a bevel-etching device 144 for removing a material, to be processed, formed in or adhering to a peripheral portion (bevel portion and edge portion) of the substrate. The other construction is the same as in the embodiment shown in FIG. 35.

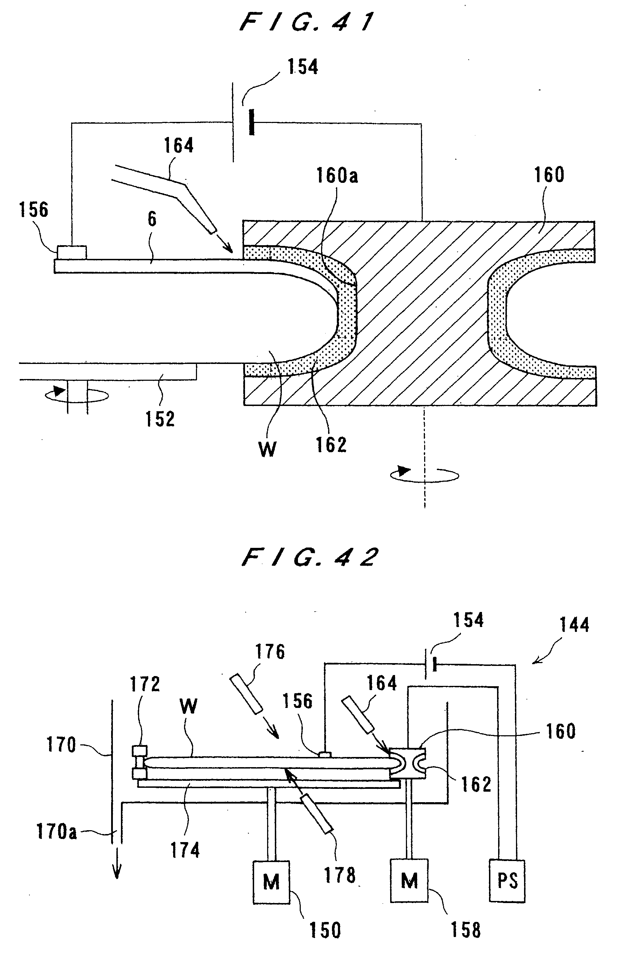

FIGS. 40 and 41 show an example of the bevel-etching device 144. The bevel-etching device 144 comprises a substrate holder 152 which attracts and holds the substrate W with its front surface upward and rotates by the actuation of a motor 150, a feeding electrode 156 which is connected to an anode of a power source 154, and contacts a conductor film (portion to be processed) such as the copper film 6 formed in the surface of the substrate W to pass electricity thereto, and a column-shaped processing electrode 160 which is connected to a cathode of the power source 154, and rotates by the actuation of a motor 158. The processing electrode 160 is disposed beside the substrate W held by the substrate holder 152, and can contact and detach the substrate W. Further, a groove 160a generally in the shape of a half circle in cross section, conforming to the peripheral configuration of the substrate W, is formed in the processing electrode 160, and an ion exchanger 162, as described above, is mounted on the surface of the groove 160a so that the surface of the ion exchanger 162 contacts or gets close to a peripheral portion of the substrate W. Furthermore, a pure water nozzle 164 is disposed near the processing electrode 160 as a pure water supply section for supplying pure water or ultrapure water between the processing electrode 160 and the peripheral portion of the substrate W.

The removal by electrolytic processing of a material to be processed, such as copper, formed in or adhering to the peripheral portion (bevel portion and edge portion) of the substrate W is effected by bringing the ion exchanger 162 mounted on the processing electrode 160 into contact with or close to the peripheral portion of the substrate W held by the substrate holder 152, and rotating the substrate holder 152 to thereby rotate the substrate W and, at the same time, rotating the processing electrode 160, while supplying pure water or ultrapure water from the pure water nozzle 164 between the processing electrode 160 and the peripheral portion of the substrate W, and applying a given voltage between the processing electrode 160 and the feeding electrode 156.

According to this substrate processing apparatus, immediately after the plating treatment is conducted onto the surface of the substrate W in the plating device 136, the material, to be processed, such as copper formed in or adhering to the peripheral portion (bevel portion and edge portion) of the substrate W, in which a conductor film (portion to be processed) such as the copper film 6 (see FIG. 85B) has been formed, can be removed in the bevel-etching device 144, and the bevel-etched substrate W can then be transported to the electrolytic processing device 36.

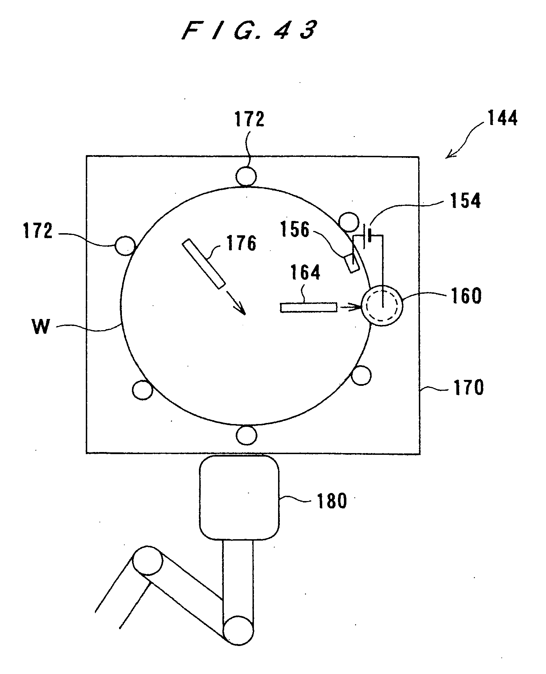

FIGS. 42 and 43 show another example of the bevel-etching device 144, which can remove by electrolytic processing a material, to be processed, such as copper formed in or adhering to a peripheral portion (bevel portion and edge portion) of the substrate W and, at the same time, can rinse (clean) the front and back surfaces of the substrate W with pure water. The bevel-etching device 144 comprises a bottomed, cylindrical waterproof cover 170 having a drain 170a and, provided in its inside, a substrate holder 174 for holding the substrate W by spin chucks 172 which engage the substrate W at certain points in the peripheral region of the substrate and rotating the substrate W horizontally with its front surface upward, a front surface nozzle 176 which is oriented towards almost the center of the front surface of the substrate W held by the substrate holder 174, and a back surface nozzle 178 which is oriented towards almost the center of the back surface of the substrate W. According to this embodiment, the substrate holder 174 is connected directly to the motor 150, and the processing electrode 160 is connected directly to the motor 158. Further, the substrate W is loaded and unloaded by a substrate transport arm 180. The other construction is the same as in the above-described embodiment shown in FIGS. 40 and 41.

According to this embodiment, the removed by electrolytic processing of a material, to be processed, such as copper formed in or adhering to a peripheral portion (bevel portion and edge portion) of the substrate W is effected by rotating the substrate holder 174 to thereby rotate the substrate W and, at the same, rotating the processing electrode 160, while supplying pure water or ultrapure water from the pure water nozzle 164 between the processing electrode 160 and the peripheral portion of the substrate W, and applying a given voltage between the processing electrode 160 and the feeding electrode 156; and simultaneously therewith, rinsing (cleaning) of the front and back surfaces of the substrate W can be conducted by supplying pure water from the front surface nozzle 176 to the front surface of the substrate, and from the back surface nozzle 178 to the back surface.

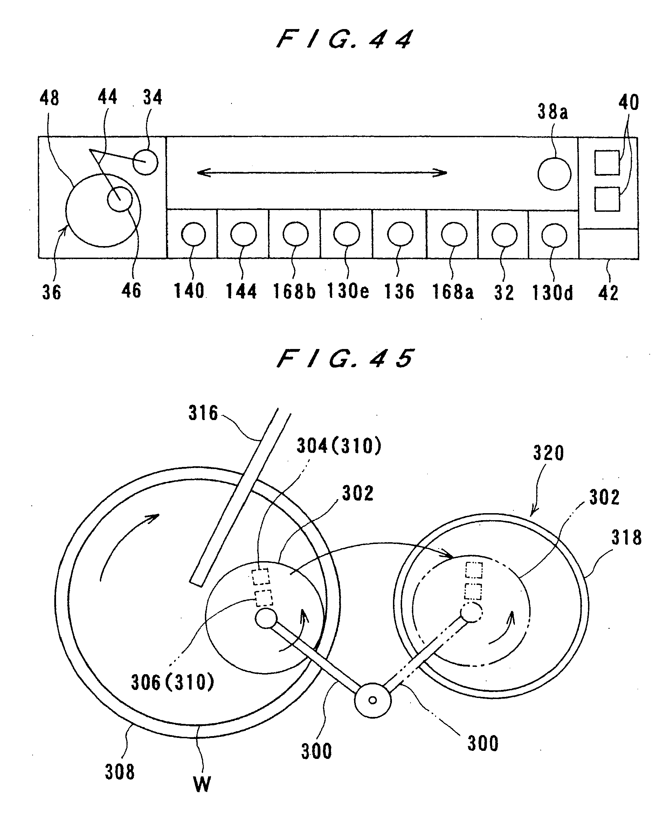

FIG. 44 shows a substrate processing apparatus according to yet another embodiment of the present invention provided with the electrolytic processing device 36. In this substrate processing apparatus, a first film thickness-measuring section 168a for measuring the film thickness of a conductor film (portion to be processed) after the processing is provided between the reversing machine 32 and the plating device 136, both used also in the embodiment shown in FIG. 39, and a second film thickness-measuring section 168b for measuring the film thickness of the conductor film (portion to be processed) such as copper film 6 (see FIG. 85B) after the plating is provided between the cleaning device 130e and the bevel-etching device 144. The other construction is the same as shown in FIG. 39.

According to this substrate processing apparatus, the film thickness of a conductor film such as the copper film 6 (see FIG. 85B), which has been deposited on the surface of the substrate W by the plating treatment in the plating device 136, is measured with the second film thickness-measuring section 168b, and the film thickness of the conductor film after the electrolytic processing in the electrolytic processing device 36 is measured with the first film thickness-measuring section 168a. By feeding back the results of measurement, it becomes possible to adjust the plating time and the processing time, or conduct an additional plating or electrolytic processing, whereby the film thickness of the conductor film such as copper film 6 can be made more uniform.

FIGS. 45 through 47 show an electrolytic processing device according to yet another embodiment of the present invention. In this electrolytic processing device, an electrode section 302 is rotatably held to the end of a swingable arm 300 which is swingable and vertically movable. Electrolytic processing of the surface of a substrate W, which is held on the upper surface of a substrate holder 308, is effected by a processing electrode 304 and a feeding electrode 306, both disposed inside the electrode section 302. Also in this embodiment, a workpiece to be processed is of course not limited to a substrate.

In this electrolytic processing device, a pair of electrodes 310, both in the shape of a rectangular flat plate, is fixed in the electrode section 302 so that the electrodes 310 face, in parallel, the substrate W held by the substrate holder 308. One electrode plate 310 connected to the cathode of a power source 312 becomes the processing electrode 304, and the other electrode plate 310 connected to the anode of the power source becomes the feeding electrode 306. This applies to processing of e.g. copper, because electrolytic processing of copper proceeds on the cathode side. As described above, depending upon a material to be processed, the cathode side can be a feeding electrode and the anode side can be a processing electrode. The surfaces of the processing electrode (cathode) 304 and the feeding electrode (anode) 306 are respectively covered with an ion exchanger 314a, 314b both as described above. Further, a pure water nozzle 316 is provided as a liquid supply section for supplying pure water or ultrapure water between the substrate W held by the substrate holder 308 and the processing and feeding electrodes 304, 306.

According to this embodiment, the ion exchanger 314a on the processing electrode side and the ion exchanger 314b on the feeding electrode side are spaced, and contact the substrate W respectively. By thus disposing the ion exchangers 314a, 314b separately in the space between the processing electrode 304 and the substrate (workpiece) Wand between the feeding electrode 306 and the substrate (workpiece) W, and using ultrapure water as a processing liquid, the processing efficiency can be best enhanced.

In this connection, when an ion exchanger of an integral type, i.e. a processing electrode 304 and a feeding electrode 306 are mounted to one ion exchanger, is used in electrolytic processing, the so-called short (virtually a flow of ions) between a processing electrode 304 and a feeding electrode 306 will occur, resulting in a decrease in the amount of ions that act on the surface of a workpiece, thereby lowering the processing efficiency. In using such an integral type of ion exchanger, the "short" may be reduced by making the distance between the processing electrode and the feeding electrode larger. However, the portion of the ion exchanger not participating in processing becomes larger, whereby a uniform processing rate over the entire processing surface area is obtained with difficulty.

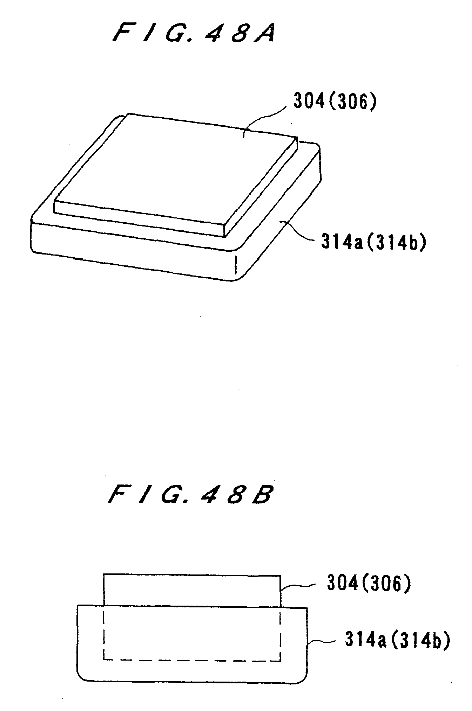

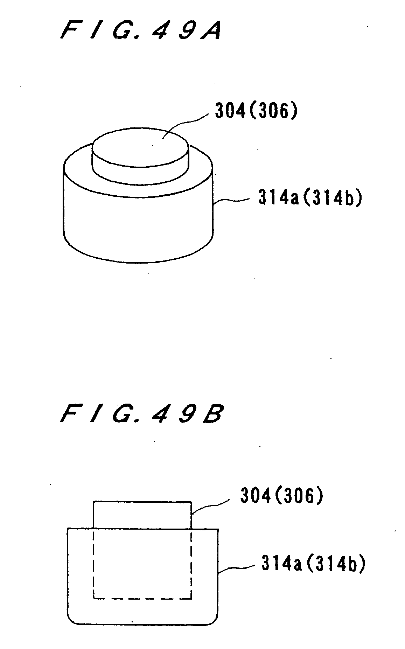

The base material of the ion exchangers 314a, 314b may be a nonwoven fabric, a woven fabric, a sheet or a porous material. As shown in FIG. 48, the ion exchanger 314a or the ion exchanger 314b may be mounted on the rectangular processing electrode 304 or feeding electrode 306 by wrapping the ion exchanger around the lower portion of the electrode. Also in a case where the processing electrode 304 and feeding electrode 306 are in a column shape, as shown in FIG. 49, the ion exchangers 314a, 314b, which are composed of e.g. a nonwoven fabric, a woven fabric, a sheet or a porous material, may be each mounted on the respective electrodes by wrapping the ion exchanger around the electrode.

It is preferred to supply ultrapure water from the pure water nozzle 316 rather than pure water. Further, as described above, use may be made of an electrolytic solution obtained by adding an electrolyte to pure water or ultrapure water, or a liquid having an electric conductivity of not more than 500 µS/cm obtained by adding an additive such as a surfactant to pure water or ultrapure water.

According to this embodiment, a substrate W, e.g. a substrate having an its surface a conductor film (portion to be processed) such as the copper film 6 shown in FIG. 85B, is held with its front surface upward by the substrate holder 308, and the ion exchangers 314a, 314b, respectively covering the surface of the processing electrode 304 and the surface of the feeding electrode 306 of the electrode section 302, are brought into contact with or close to the surface of the substrate W. While rotating the substrate W via the substrate holder 308 and, at the same time, rotating the electrode section 302, pure water or ultrapure water is supplied between the substrate W and the processing and feeding electrodes 304, 306, and a given voltage is applied between the processing electrode 304 and the feeding electrode 306, thereby conducting electrolytic processing of the conductor film such as copper film 6 just under the processing electrode (cathode) 304.

In the electrolytic processing device of this embodiment, as in the above-described embodiment shown in FIGS. 28 and 29, a regeneration section 320 is provided beside the substrate holder 30, which includes a regeneration tank 318 filled with e.g. a dilute acid solution, and regenerates the ion exchangers 314a, 314b mounted on the lower surface of the electrode section 302 such that they respectively cover the surface of the processing electrode 304 and the surface of the feeding electrode 306.

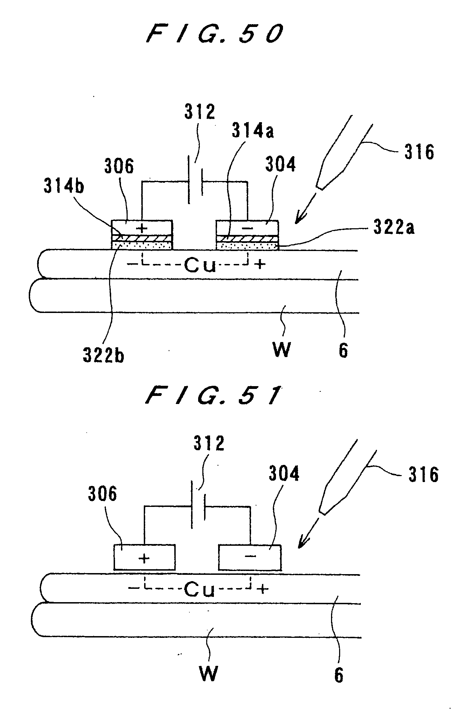

As shown in FIG. 50, it is possible to adhere or laminate porous bodies 322a, 322b, which are in the form of e.g. a film and excellent in flatness, to the respective surfaces (lower surfaces) of the ion exchangers 314a, 314b. A woven fabric may be used instead of the porous bodies 322a, 322b. The lamination of such a material can further enhance the flatness of the processed surface of the substrate W. The porous bodies 322a, 322b and the woven fabric may be ion exchangers.

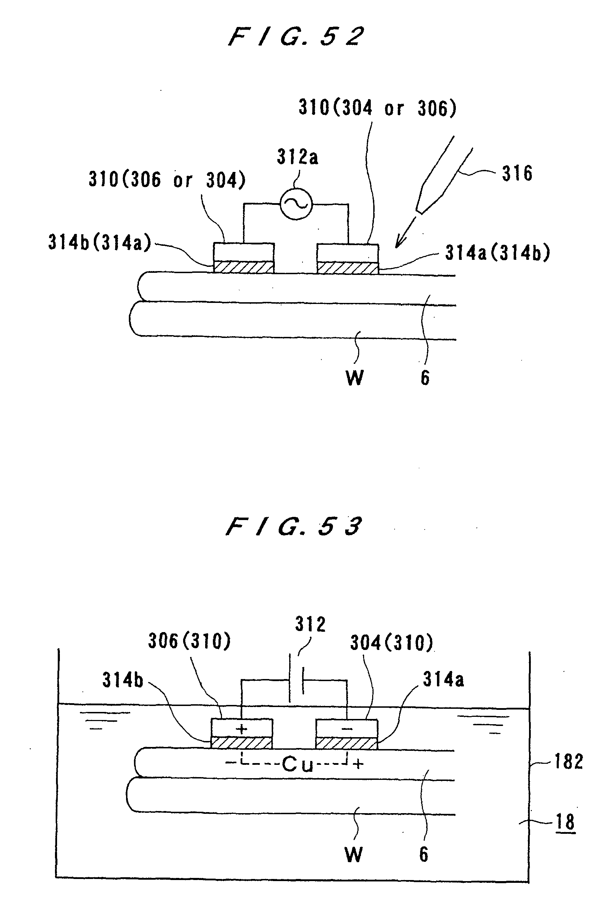

As shown in FIG. 51, it is possible to conduct electrolytic processing by bringing the processing electrode 304 and the feeding electrode 306, which are not covered with the ion exchangers 314a, 314b, close to the substrate W, and supplying pure water or ultrapure water, or a liquid having an electric conductivity of not more than 500 µS/cm between the processing and feeding electrodes 304, 306 and the substrate W.

Further, as shown in FIG. 52, it is possible to use an AC power source 312a so that the pair of the electrode plates 310 can alternate between the processing electrode 304 and the feeding electrode 306. Moreover, as shown in FIG. 53, it is possible to conduct electrolytic processing of a conductor film by filling a water tank 182 with a liquid 18 such as pure water or ultrapure water, immersing a substrate W, e.g. a substrate having in its surface a conductor film such as the copper film 6 shown in FIG. 85B, with its front surface upward, in the liquid 18, and bringing the processing electrode 304 and the feeding electrode 306 close to the substrate W.

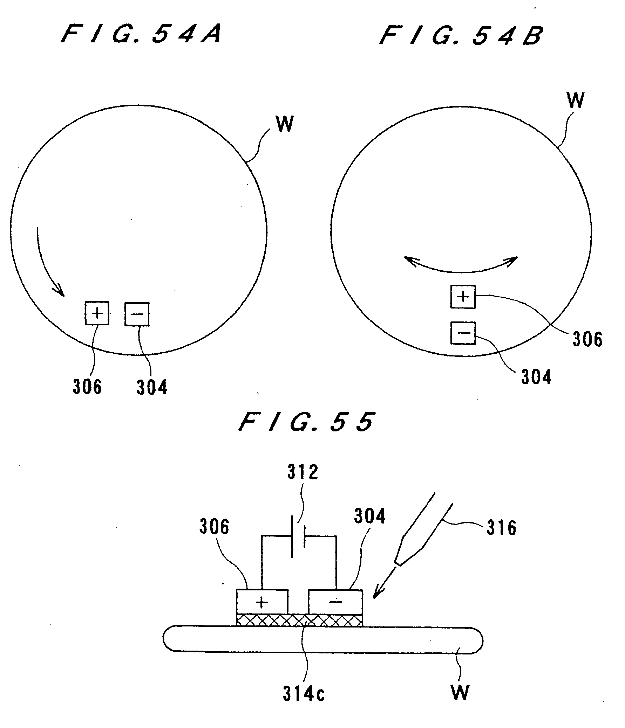

As described above, in the electrolytic processing of copper, for example, the processing proceeds on the surface (lower surface) of the processing electrode 304 as a cathode. Accordingly, when the processing electrode (cathode) 304 and the feeding electrode (anode) 306 are disposed in the chord direction of the substrate W, as shown in FIG. 54A, and the substrate W is rotated, it is necessary to locate the feeding electrode (anode) 306 on the upstream side in the rotating direction of the substrate. This is because if the portion of the substrate surface facing the processing electrode (cathode) 304 is electrolytically processed to remove the conductor film, it becomes impossible to supply electricity from the feeding electrode 306. It will be understood that there is no such restriction in the case of disposing the processing electrode (cathode) 304 and the feeding electrode (anode) 306 in the radial direction of the substrate as shown in FIG. 54B, and in the case of using an AC power source as shown in FIG. 52.

As shown in FIG. 55, it is possible to integrally cover the surface of the processing electrode 304 and the surface of the feeding electrode 306 with one ion exchanger 314c. This can facilitate the production of the processing electrode 304 and the feeding electrode 306, and can further lower the electric resistance.

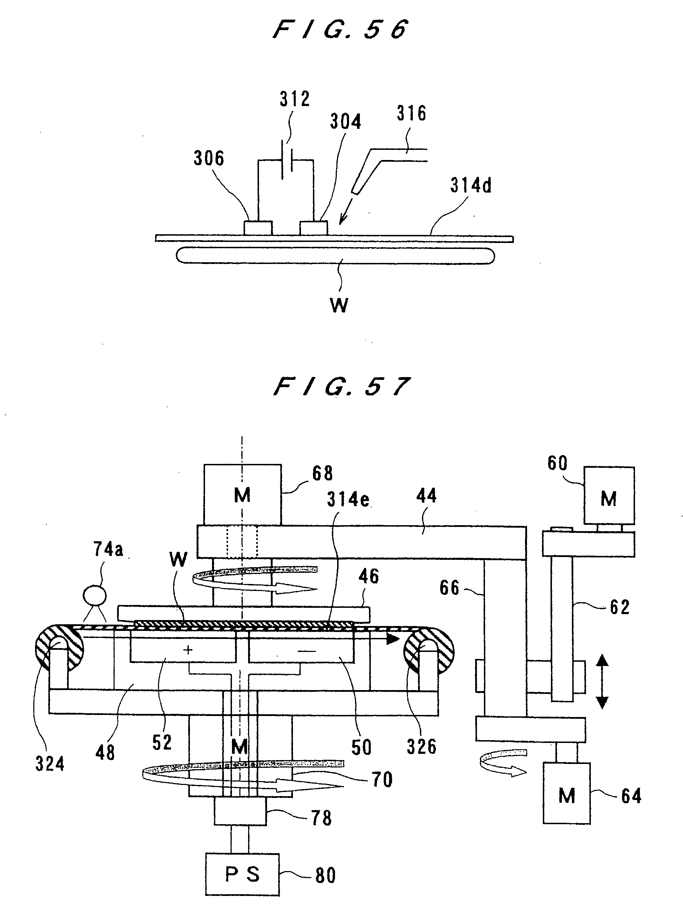

Alternatively, electrolytic processing may be carried out by disposing an ion exchanger 314d above a substrate W such that it covers the entire surface of the substrate W, as shown in FIG. 56, and either supplying pure water or ultrapure water from the pure water nozzle 316 to the ion exchanger 314d so as to impregnate the ion exchanger 314d with pure water or ultrapure water, or continuously immerse the ion exchanger 314d in pure water or ultrapure water, and placing the processing electrode 304 and the feeding electrode 306 on the upper surface of the ion exchanger 314d. This makes it possible to change with ease the ion exchanger 314d when it is stained after the electrolytic processing. Though not figured, it is also possible to dispose an ion exchange so that it covers part of the surface of the substrate, and place the processing electrode 304 and the feeding electrode 306 on the upper surface of the ion exchanger.

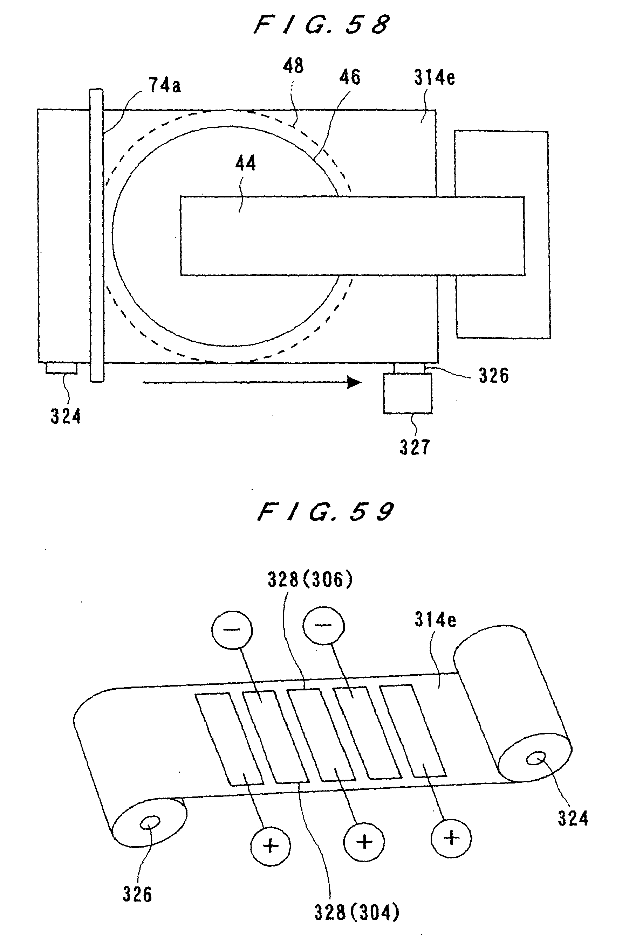

In this case, as shown in FIGS. 57 and 58, it is possible to stretch a long sheet form of an ion exchanger 314e between a supply shaft 324 and a rewind shaft 326, both disposed on the opposite sides across the substrate holder 308, and rewind the ion exchanger 314e sequentially by rotating the rewind shaft 326 through a rewind motor 327. This makes it possible to change the ion exchanger in a successive manner. This embodiment shows a case in which an electrolytic processing device having a similar construction to that of FIG. 5, but the substrate holder 46 and the electrode section 48 having substantially the same diameter, is used and a pure water nozzle 74a, extending in the width direction of the ion exchanger 314e, over the entire length thereof, is disposed upstream of the electrode section 48 in the flow direction of the ion exchanger 314e. In this embodiment shown in FIGS 57 and 58, the ion exchanger 314e may be taken up intermittently at a low speed. Alternatively, it is possible to fix the ion exchanger 314e to the electrode section 48 during processing, and rewind the ion exchanger by a given length when it is worn or when impurities accumulate on it, thereby providing a fresh processing surface.

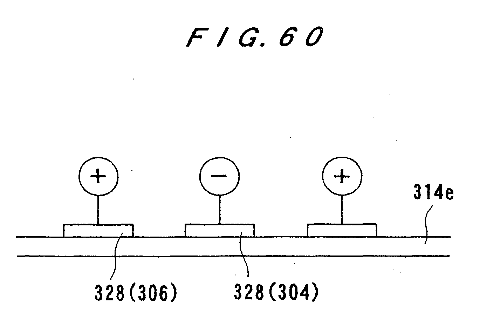

Further, as shown in FIGS. 59 and 60, it is possible to mount rectangular electrode portions 328 on the ion exchanger 314e of a long sheet form by printing or lamination at a given pitch in the long direction of the ion exchanger so that when the ion exchanger 314e is taken up by one-time use length, one of two adjacent electrode portions 328 may be connected to the cathode of the power source 312 (see FIG. 55) to become the processing electrode 304, and the other one may be connected to the anode to become the feeding electrode 306. This eliminates the need to provide electrode sections separately, and thus can simplify the device.

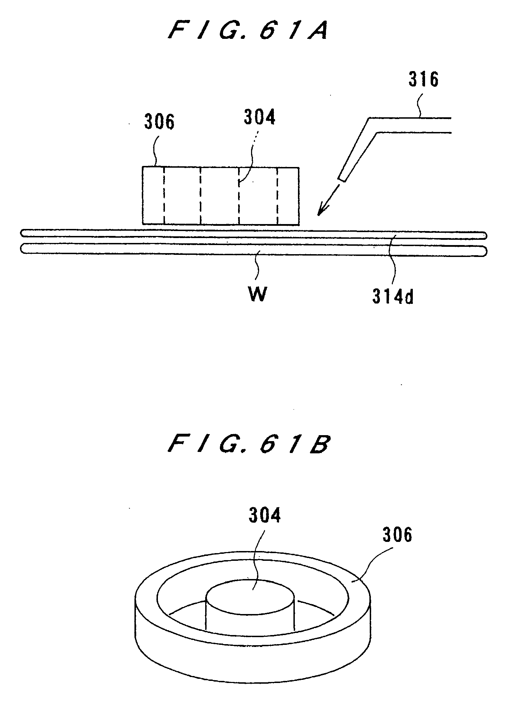

Further, as shown in FIG. 61, the processing electrode 304 may be in the shape of a column, and may be surrounded by a ring-shaped feeding electrode 306. In the case of copper, for example, the electrolytic processing thereof proceeds just under the cathode. Accordingly, it is preferred to dispose the processing electrode 304 and the feeding electrode 306 so that the electric current can flow between the electrodes 304, 306 through the shortest route. By disposing the electrodes such that the feeding electrode 306 surrounds the processing electrode 304, all the electric currents can flow from the feeding electrode 306 to the processing electrode 304 through the shortest routes, whereby the current efficiency can be enhanced and the power consumption can be reduced. Further, though not figured, it is also possible to surround a column-shaped feeding electrode with a ring-shaped processing electrode. This holds also for the below-described embodiments.

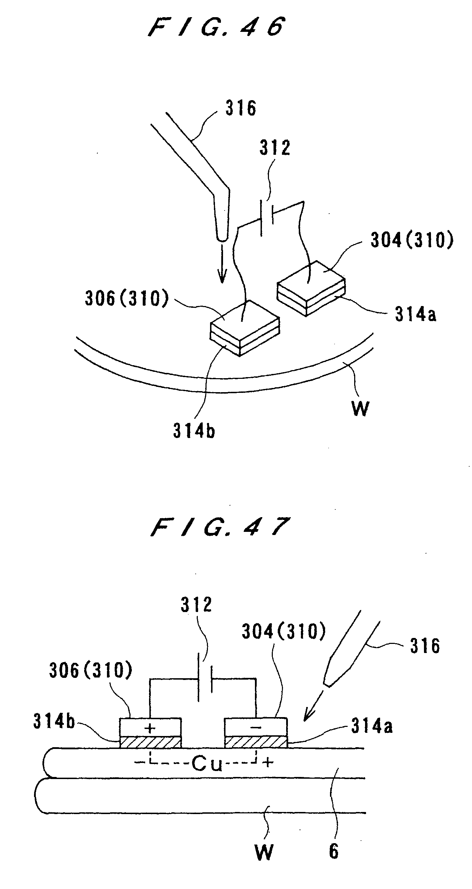

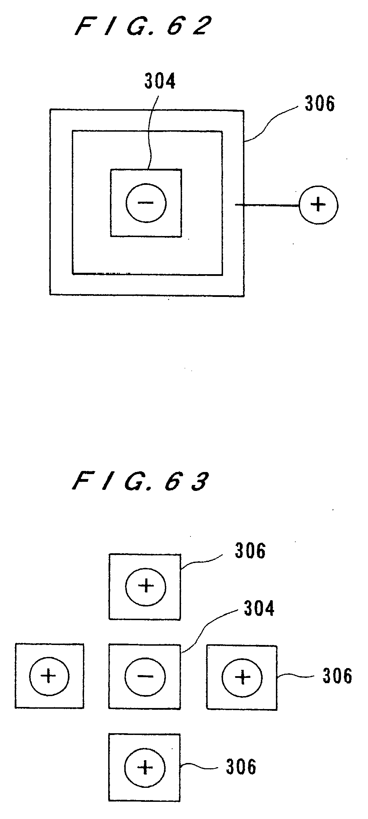

It is also possible to surround a prismatic processing electrode 304 with a rectangular frame-shaped feeding electrode 306 as shown in FIG. 62. Further, as shown in FIG. 63, the prismatic processing electrode 304 may be surrounded with a plurality of prismatic feeding electrodes 306. The above-described example of the shape and the disposition of electrodes shown in FIGS. 46 to 56 and FIGS. 61 to 63 are applicable to the electrolytic processing device in FIG. 45.

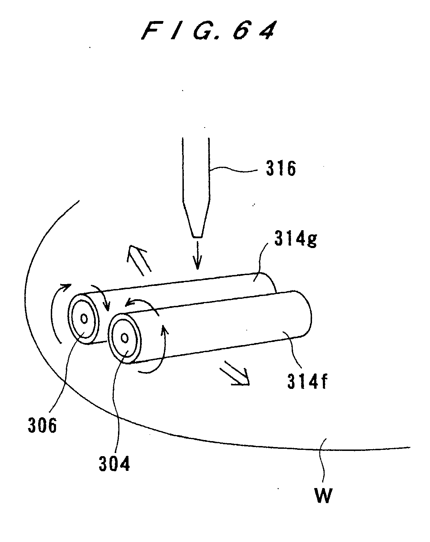

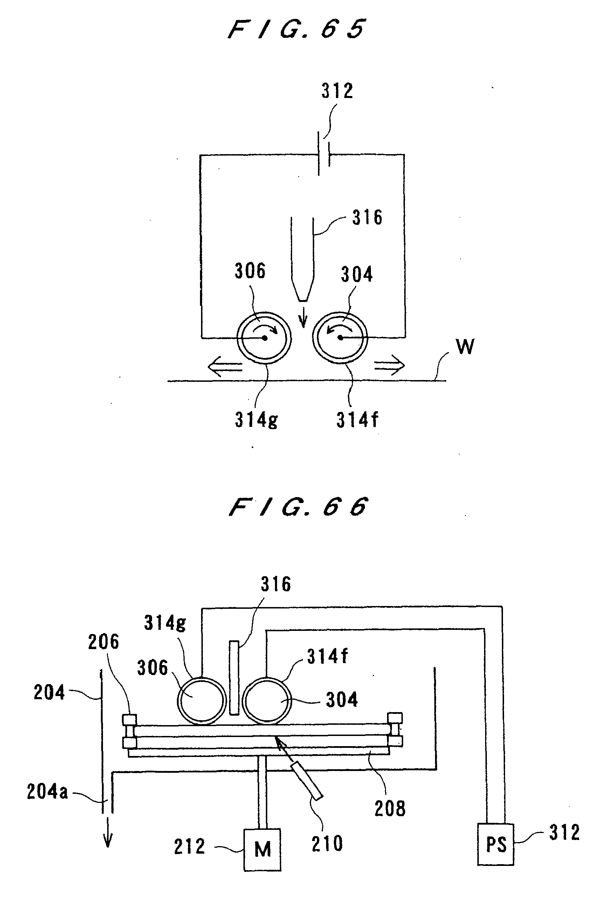

FIGS. 64 and 65 show an electrolytic processing device according to yet another embodiment of the present invention. In this electrolytic processing device, the processing electrode 304 and the feeding electrode 306 are both in the shape of a column, and ion exchangers 314f, 314g are mounted on the peripheral surface of the processing electrode 304 and on the peripheral surface of the feeding electrode 306, respectively. The processing electrode 304 and the feeding electrode 306 are disposed in parallel at a given distance such that their central axes are parallel to the substrate W. In operation, pure water or ultrapure water is supplied from the pure water nozzle 316 between the processing electrode 304 and the feeding electrode 306, while the processing electrode 304 and the feeding electrode 306 are allowed to rotate in such opposite directions that the rotating electrodes enwind the pure water or ultrapure water supplied from the pure water nozzle 316.

According to this embodiment, electrolytic processing is carried out by rotating a substrate W, which is in contact with or close to the ion exchangers 314f, 314g, and, at the same time, rotating the processing electrode 304 and the feeding electrode 306 around their own central axes, while supplying pure water or ultrapure water between the processing electrode 304 and the feeding electrode 306, and applying a given voltage between the processing electrode 304 and the feeding electrode 306. In the electrolytic processing, reaction products of the electrode reaction or electrochemical reaction can accumulate with the progress of reaction and impede the useful reaction. According to this embodiment, however, a flow of pure water or ultrapure water on the surface of the substrate can be produced by supplying pure water or ultrapure water between the column-shaped electrodes 304, 306 rotating in such opposite directions that the electrodes enwind the supplied water, and the flow of pure water or ultrapure water can effectively discharge the unnecessary products. Further, the use of the column-shaped electrodes 304, 306 disposed in the above manner allows a linear contact or proximity between the electrodes 304, 306 and the substrate W, which can enhance the flatness of the processed surface.

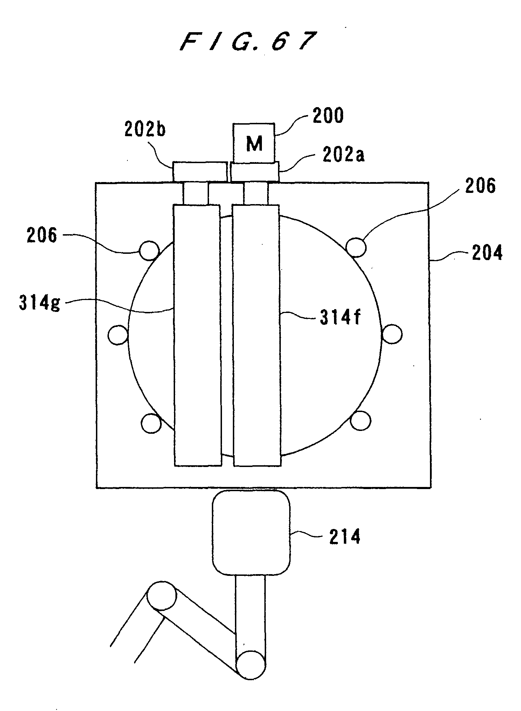

FIGS. 66 and 67 show a variation of the above electrolytic processing device shown in FIGS. 64 and 65. In this electrolytic processing device, electrodes with a length substantially equal to the diameter of a substrate W are used as the column-shaped processing electrode 304 and feeding electrode 306, and the processing electrode 304 and the feeding electrode are allowed to rotate in the opposite directions through a motor 200 and a pair of spur gears 202a, 202b that engage each other. Further, this electrolytic processing device includes a bottomed, cylindrical waterproof cover 204 having a drain 204a and, provided in its inside, a substrate holder 208 for holding the substrate W by spin chucks 206 which engage the substrate W at certain points in the periphery region of the substrate W and rotating the substrate W horizontally with its front surface upward, and a back surface nozzle 210 which is oriented towards almost the center of the back surface of the substrate W. The substrate holder 208 is connected directly to the motor 212. The substrate W is loaded and unloaded by a substrate transport arm 214. The other construction is the same as shown in FIGS. 64 and 65.

According to this embodiment, electrolytic processing of the surface of the substrate W is conducted while rotating the substrate holder 208 to thereby rotate the substrate W and, at the same time, rotating the processing electrode 304 and the feeding electrode 306 around their own central axes; and simultaneously therewith, rinsing (cleaning) of the back surface of the substrate W can be conducted by supplying pure water from the back surface nozzle 210 to the back surface of the substrate W.

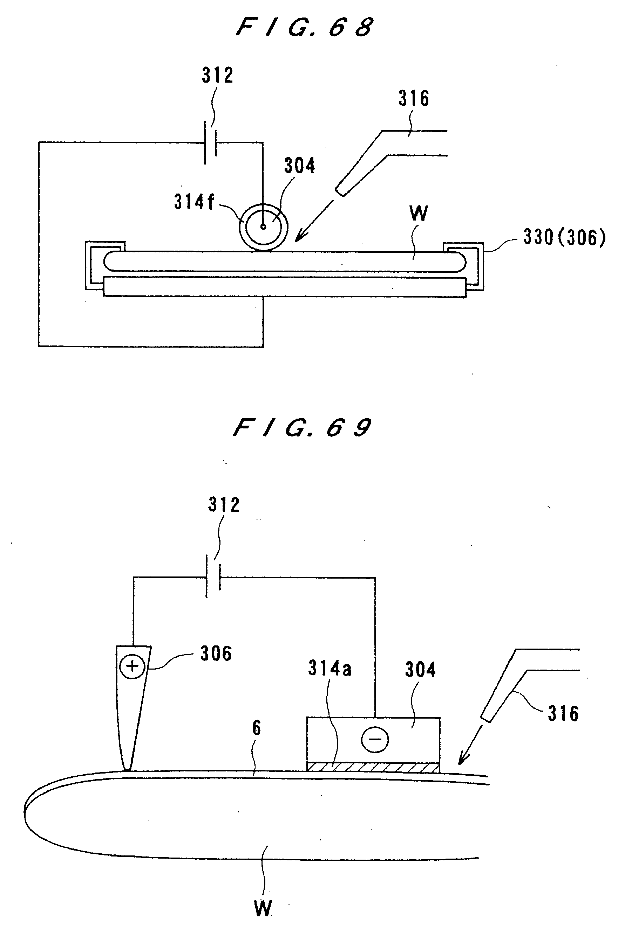

FIG. 68 shows an electrolytic processing device according to yet another embodiment of the present invention. In this electrolytic processing device, a column-shaped electrode that can rotate about its central axis, the axis being parallel to the substrate W, is used as the processing electrode 304. An ion exchanger 314f is mounted on the outer peripheral surface of the processing electrode 304. Pure water or ultrapure water is supplied from the pure water nozzle 316 between the processing electrode 304 and the substrate W. Further, a feeding chuck 330 for supplying electricity, which directly contacts a conductor film formed in the surface of the substrate to supply electricity thereto, is used as the feeding electrode 306. The feeding chuck 330 connects a feeding electrode positioned beneath the back surface of the substrate W to the conductor film of the substrate W. Even when the back surface of the substrate W is composed of an insulator film such as a SiO₂ film, supply of the electricity from the back surface side becomes possible by using the feeding chuck 330.

FIG. 69 shows an electrolytic processing device according to yet another embodiment of the present invention. In this electrolytic processing device, an electrode in the shape of a flat rectangular plate is used as the processing electrode 304. The ion exchanger 314a is mounted on the surface of the electrode facing a substrate W. Pure water or ultrapure water is supplied from the pure water nozzle 316 between the processing electrode 304 and the substrate W. Further a contact pin-like electrode, which directly contacts a conductor film (portion to be processed) such as the copper film 6 (see FIG. 85B) formed in the surface of the substrate W to supply electricity thereto, is used as the feeding electrode 306. The feeding electrode 306 should preferably have such a contact area that does not leave its trace on the conductor film after the direct contact between the feeding electrode 306 and the conductor film. It is possible to bring the feeding electrode 306 into contact with a conductor film such as the copper film 6 formed in the bevel portion of the substrate W, thereby removing the conductor film formed in the bevel portion of the substrate W in the later bevel-etching step.

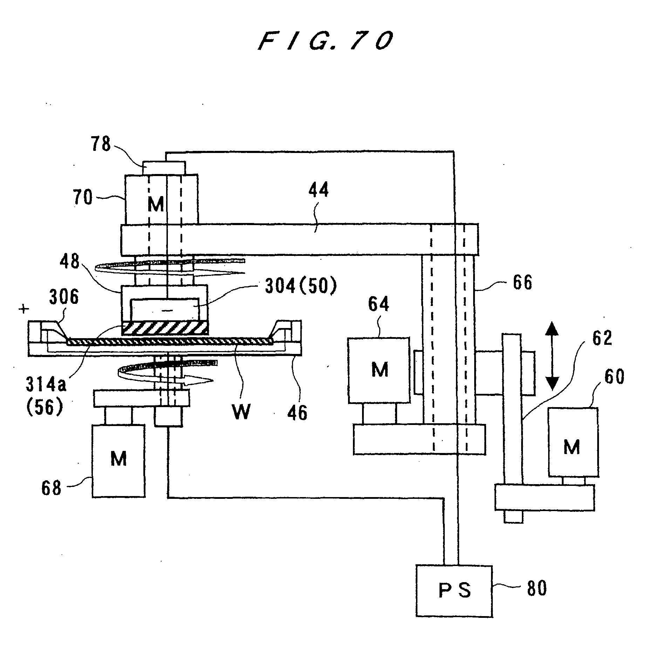

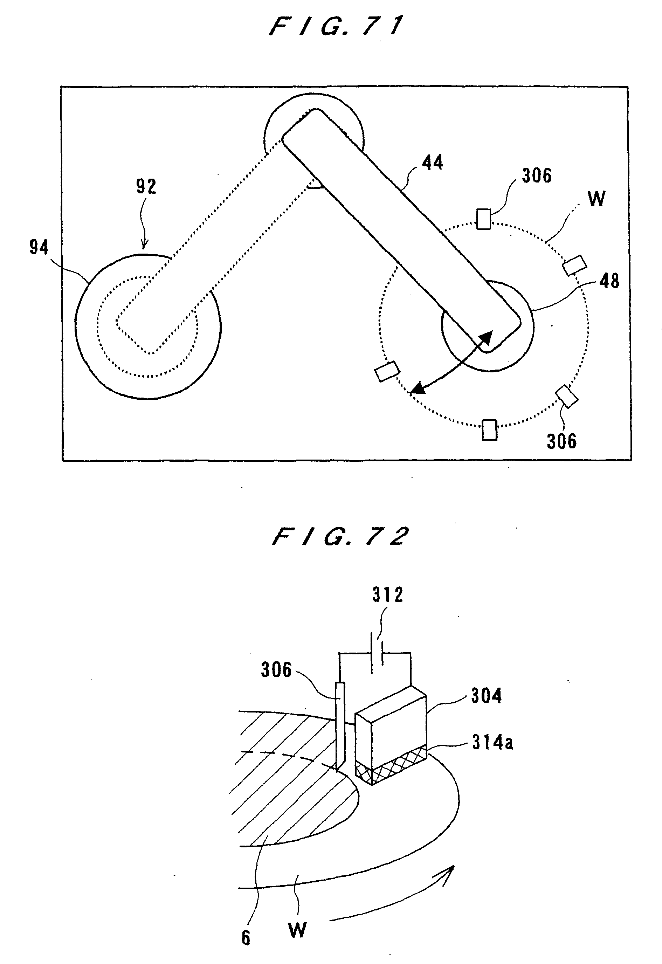

FIGS. 70 and 71 show another embodiment of an electrolytic processing device according to the present invention in which electricity is supplied from the front surface side of the bevel portion. This electrolytic processing device differs from the electrolytic processing device shown in FIGS. 28 and 29 in the following points:

The substrate holder 46, disposed below the electrode section 48, is designed to hold a substrate W with its front surface upward and rotate by the actuation of the motor 68, and is provided with feeding electrodes 306, which contact the peripheral portion of the substrate W placed on the substrate holder 46, in certain positions along the circumferential direction of the substrate holder 46. The feeding electrodes 306 are connected to an anode extending from the power source 80.

On the other hand, the vertically movable, swingable and rotatable electrode section 48 is provided with a processing electrode 304 (50) which is connected to a cathode extending from the power source 80 through the hollow portion formed in the drive shaft 66 to the slip ring 78, and further extending from the slip ring 78 through the hollow portion of the hollow motor 70. An ion exchanger 314a (56) is mounted on the surface (lower surface) of the processing electrode 304 (50). The other construction is the same as shown in FIGS. 28 and 29.

According to this embodiment, the electrode holder 48 is lowered so as to bring the ion exchanger 314a (56) into contact with or close to the surface of the substrate W held by the substrate holder 46. While supplying pure water or ultrapure water to the upper surface of the substrate, a given voltage is applied through the power source 80 between the processing electrode 304 (50) and the feeding electrode 306, the substrate holder 46 and the electrode section are rotated and at the same time, the swingable arm 44 is swung to move the electrode section along the upper surface of the substrate W, thereby effecting electrolytic processing of the surface of the substrate W.

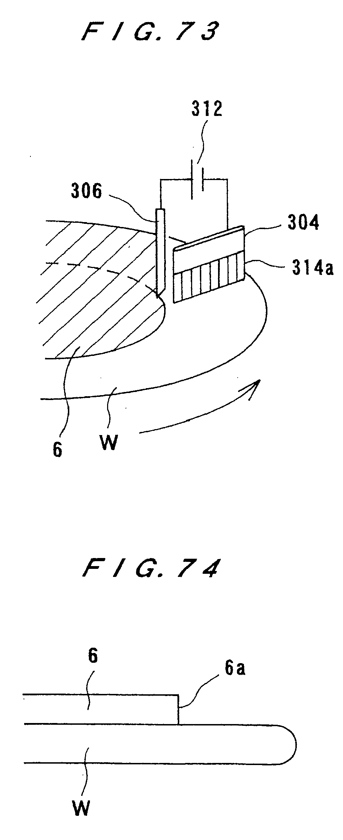

FIGS. 72 and 73 show an electrolytic processing device according to yet another embodiment of the present invention which is used as a bevel-etching device. The construction of this electrolytic processing device is basically the same as the above-described electrolytic processing device shown in FIG. 69. In this electrolytic processing device, the ion exchanger 314a mounted on the processing electrode 304 contacts or gets close to the bevel portion of the substrate W, and the feeding electrode 306 directly contacts a conductor film (portion to be processed) such as the copper film 6 formed in the surface of the substrate W. The processing electrode 304 may either be a thick one as shown in FIG. 72, or a thin one as shown in FIG. 73. The bevel-etching processing can obtain the conductor layer such as the copper 6 with a sharp profile (step) 6a, as shown in FIG. 74.

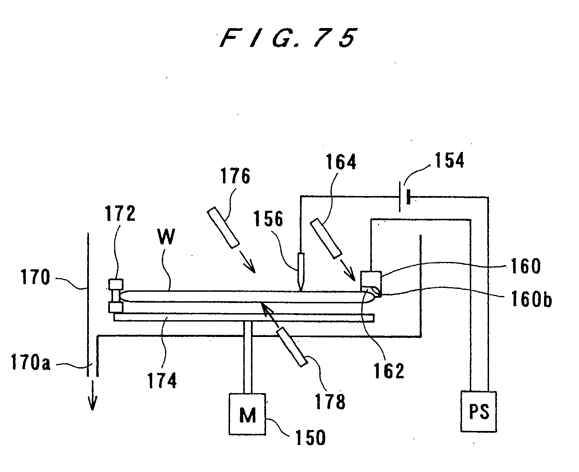

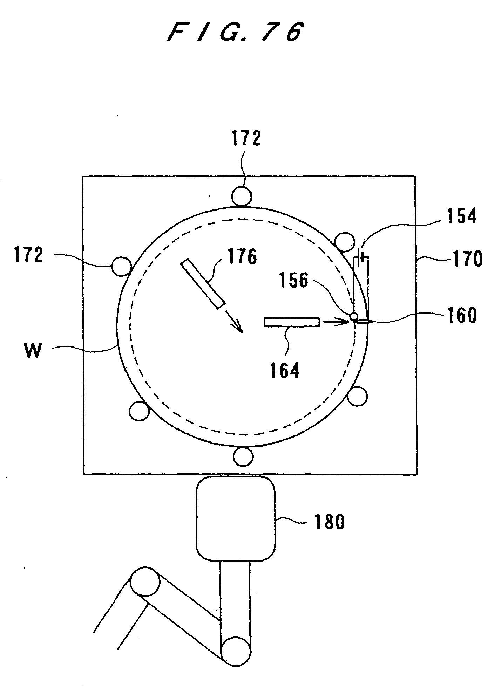

FIGS. 75 and 76 show an electrolytic processing device according to yet another embodiment of the present invention which is used as a bevel-etching device. This electrolytic processing device differs from the electrolytic processing device shown in FIGS. 42 and 43 in that: In this electrolytic processing device, an non-rotatable flat plate-shaped electrode, having in the lower surface a curved portion 160b conforming to the configuration of the upper half of the bevel portion of a substrate W, is used as the processing electrode 160, and a contact pin-like electrode is used as the feeding electrode 156. The ion exchanger 162 is mounted on the lower surface of the processing electrode 160. The ion exchanger 162 is brought into contact with or close to the bevel portion of the substrate W, thereby electrolytically processing the upper half of the bevel portion of the substrate W. The other construction is the same as shown in FIGS. 42 and 43. According to this embodiment, simultaneously with the electrolytic polishing of the upper half of the bevel portion, rinsing (cleaning) of the front and back surfaces of the substrate can be carried out.

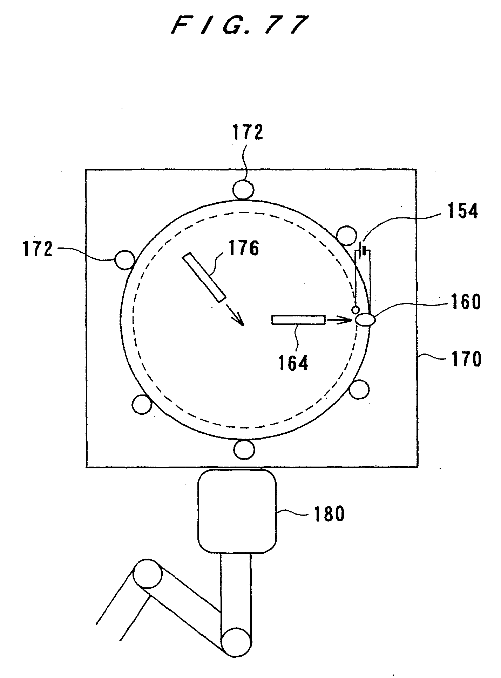

FIG. 77 shows a variation of the above electrolytic processing device. This electrolytic processing device differs from the above electrolytic processing device shown in FIGS. 75 and 76 in the use of a thicker processing electrode 160. The other construction is the same as shown in FIGS. 75 and 76.

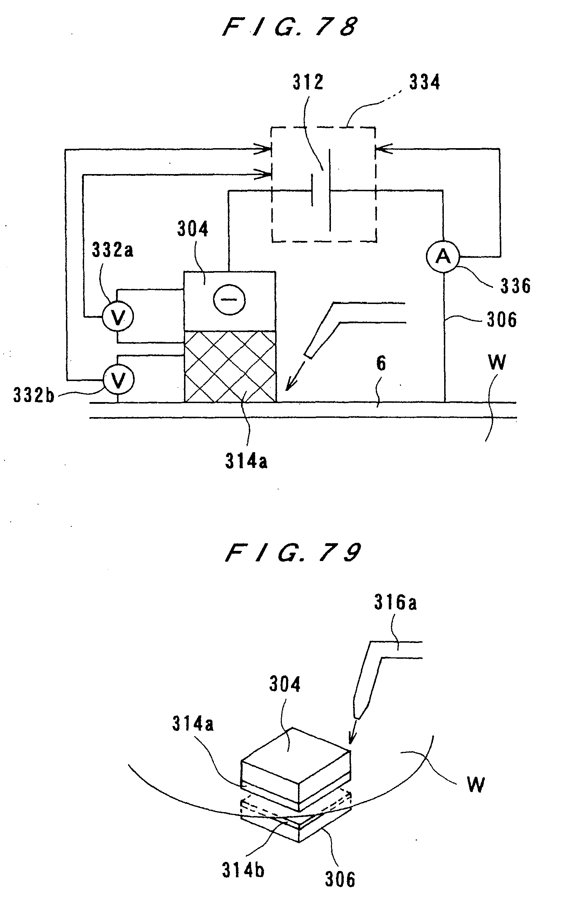

As shown in FIG. 78, it is preferred to monitor with voltmeters 332a, 332b the voltage between the processing electrode 304 and the ion exchanger 314a and the voltage between the ion exchanger 314a and the conductor film (portion to be processed) such as the copper film 6 (see FIG. 85B), and feed back the monitored values to a controller 334 so as to keep the voltages constant, and also to monitor with an ammeter 336 the electric current flowing between the processing electrode 304 and the feeding electrode 306, and feed back the monitored values to the controller 334 so as to allow a constant current to flow between the processing electrode 304 and the feeding electrode 306. This makes it possible to restrain side reactions on the surface of the electrode or on the surface of the conductor film such as copper film to thereby prevent the formation of impurities. If impurities are formed on the surface of the electrode, a decrease in the processing rate can be avoided by keeping a constant electric current.

When electrolytic processing of a substrate W, for example the substrate W of FIG. 85B having the copper film 6 formed in the surface, is conducted at a controlled constant current value, the current density (current value per unit area) increases upon the decrease in processing area at the time of exposure of the interconnect pattern composed of copper layer 6 (as shown in FIG. 85C, copper is present only in the trench), whereby the removal processing rate inevitably increases. With the electrolytic processing of the substrate at a controlled constant current, the removal processing rate thus varies before and after the exposure of interconnect pattern, making the processing control in the vicinity of such exposure difficult. Further, upon processing of the copper film 6 on the interconnect pattern, the voltage applied increases with the decrease in film thickness. Too high an applied voltage can cause electric discharge. Also from the viewpoint of power consumption, a low voltage is preferred.

When the processing is conducted at a controlled constant voltage, on the other hand, the current value decreases with the exposure of interconnect pattern, whereby it becomes possible to suppress the rise of current density. Further, because of constancy of voltage, there is no fear of electric discharge. Furthermore, since the current value decreases with the decrease of film thickness, there is no increase of power consumption. However, since the current value charges, the processing rate changes with time. When the current value becomes too low, the mode of processing can change from removal processing to oxide film formation.

When the processing is conducted at a controlled constant current density, the processing rate does not change before and after the exposure of interconnect pattern, thus enabling removal processing at a constant processing rate. In order to make this control, however, it is necessary to grasp beforehand the area of the exposed interconnect pattern, and make a control of changing (virtually decreasing) the current value at a particular moment. It would therefore be difficult to respond to the variety of interconnect patterns.

In view of the above and making use of the advantages of the above controlling methods, it may be consider to first make the constant-current control until the vicinity of the exposure of interconnect pattern in view of the easy processing control because of the constant processing rate, and then change it to the constant-voltage control which is free from the fear of a rise in voltage and which can suppress the rise of current density.

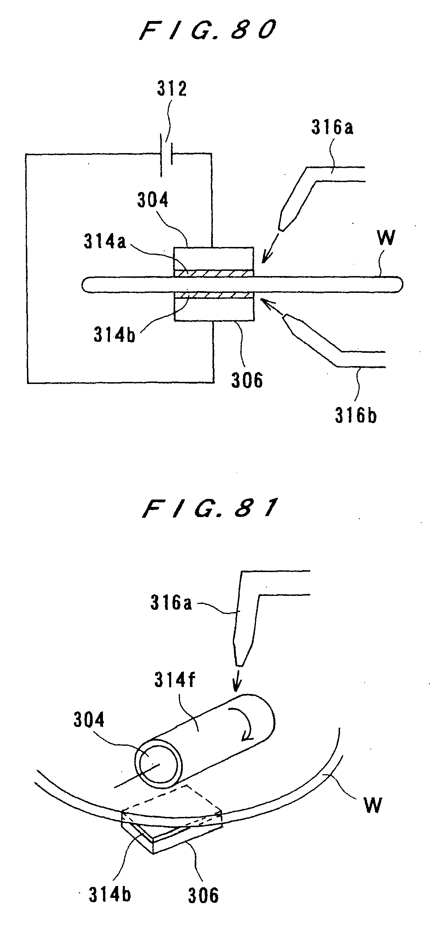

FIGS. 79 and 80 show an electrolytic processing device according to yet another embodiment of the present invention, which is adapted for electrolytic processing of a substrate W in which a conductor film (portion to be processed) such as a copper film is formed over the entire.peripheral surface. In this electrolytic processing device, a processing electrode 304 and a feeding electrode 306, both in the shape of a flat rectangular plate, are disposed in the opposite positions across the substrate W. Thus, in this embodiment, the electrode plate located on the upper surface side of the substrate W and connected to the cathode of a power source 312 functions as the processing electrode 304, and the electrode plate located on the lower surface side of the substrate W and connected to the anode functions as the feeding electrode 306. Ion exchangers 314a, 314b are mounted on the surface of the processing electrode 304 facing the substrate W and on the surface of the feeding electrode 306 facing the substrate W, respectively. A pure water nozzle 316a for supplying pure water or ultrapure water between the processing electrode 304 and the substrate W is provided on the upper surface side of the substrate W, and a pure water nozzle 316a for supplying pure water or ultrapure water between the feeding electrode 306 and the substrate W is provided on the lower surface side of the substrate W.

In operation, the ion exchangers 314a, 314b, respectively mounted on the processing electrode 304 and on the feeding electrode 306, are brought into contact with or close to the substrate W, and pure water or ultrapure water is supplied from the pure water nozzle 316a between the processing electrode 304 and the substrate W, and from the pure water nozzle 316b between the feeding electrode 306 and the substrate W, thereby electrolytic processing the part of the substrate W facing the processing electrode 304; and either one or both of the substrate W and the processing electrode 304 are allowed to move so as to effect electrolytic processing of the entire surface of the substrate W on the side of the processing electrode 304. The feeding electrode 306 may be connected directly to the substrate W. Further, as with the preceding embodiments, an electrolytic solution or a liquid having an electric conductively of not more than 500 µS/cm may be used instead of pure water or ultrapure water.

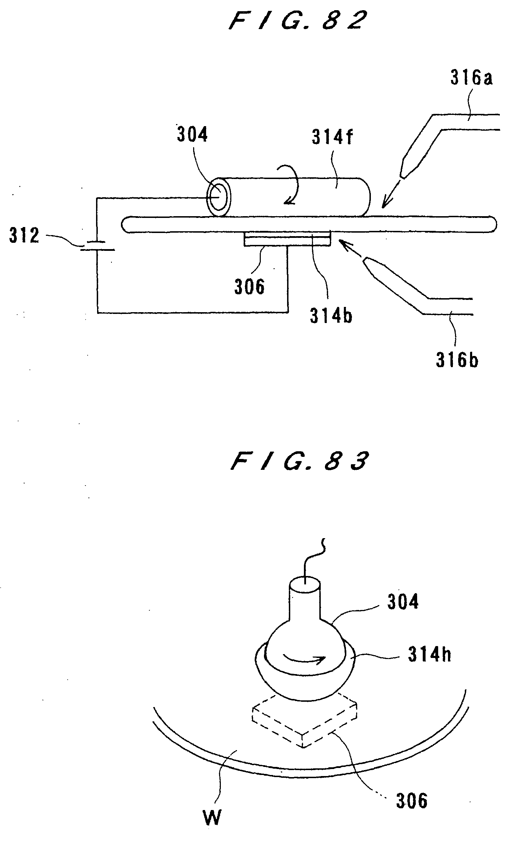

FIGS. 81 and 82 show an electrolytic processing device according to yet another embodiment of the present invention. This electrolytic processing device employs, as the processing electrode 304, a column-shaped one whose peripheral surface is covered with an ion exchanger 314f and which can rotate about its central axis, the central axis being parallel to the substrate W. The other construction is the same as shown in FIGS. 79 and 80. The use of such a column-shaped rotatable processing electrode 304 allows the processing electrode 304 to linearly contact or get close to the substrate W, whereby the flatness of the process surface can be enhanced.

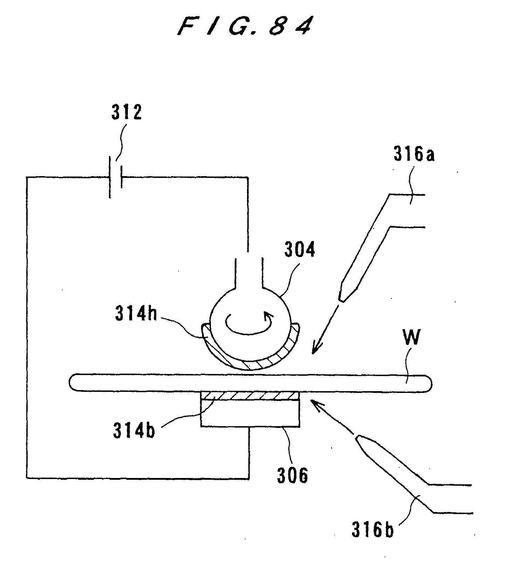

FIGS. 83 and 84 show an electrolytic processing device according to yet another embodiment of the present invention. This electrolytic processing device uses, as the processing electrode 304, an electrode in a spherical or oval spherical shape that can rotate about its central axis, the central axis being perpendicular to the substrate W. The lower half of the processing electrode 304 is covered with an ion exchanger 314h. The other construction is the same as shown in FIGS. 79 and 80. The use of such a spherical or oval spherical processing electrode 304, which allows the ion exchanger 314h to contact or get close to the substrate W at a point, enables processing at a point or of a curved surface. Further, the uniformity of the processed surface can be enhanced by rotating the spherical processing electrode. Of course, such a spherical processing electrode may be used also in the preceding embodiments and, in addition, it is also possible to use a spherical or over spherical form of feeding electrode.

According to the present invention, as described hereinabove, electrolytic processing of a workpiece, such as a substrate, can be effected through electrochemical action, in the place of CMP treatment, for example, without causing any physical defects in the workpiece that would impair the properties of the workpiece. The present electrolytic processing device can effectively remove (clean) matter adhering to the surface of the workpiece such as a substrate. Accordingly, the present invention can omit a CMP treatment entirely or at least reduce a load upon CMP. Furthermore, the electrolytic processing of a substrate can be effected even by solely using pure water or ultrapure water. This obviates the possibility that impurities such as an electrolyte will adhere to or remain on the surface of the substrate, can simplify a cleaning process after the removal processing, and can remarkably reduce a load upon waste liquid disposal.

Although certain preferred embodiments of the present invention have been shown and described in detail, it should be understood that various changes and modifications may be made therein without departing from the scope of the appended claims.

### Industrial Applicability

This invention relates to an electrolytic processing device useful for processing a conductive material present in the surface of a substrate, especially a semiconductor wafer, or for removing impurities adhering to the surface of a substrate, and a substrate processing apparatus provided with the electrolytic processing device.

### SUMMARY OF THE INVENTION

1. An electrolytic processing device, comprising:
   a processing electrode brought into contact with or close to a workpiece;
   a feeding electrode for supplying electricity to the workpiece;
   an ion exchanger disposed in at least one of spaces between the workpiece and said processing electrode, and between the workpiece and said feeding electrode;
   a power source for applying a voltage between said processing electrode and said feeding electrode; and
   a liquid supply section for supplying liquid to the space between the workpiece and at least one of said processing electrode and said feeding electrode, in which said ion exchanger is present.
2. The electrolytic processing device according to 1, wherein said liquid is pure water, liquid having electric conductivity of not more than 500 µS/cm.
3. The electrolytic processing device according to 1, wherein said ion exchanger is disposed separately in the space between said processing electrode and the workpiece, and in the space between said feeding electrode and the workpiece.
4. The electrolytic processing device according to 1, wherein said ion exchanger is disposed, as an integrated structure, in both of the spaces between said processing electrode and the workpiece, and between said feeding electrode and the workpiece.
5. The electrolytic processing device according to 1, wherein said ion exchanger covers the surface, to be processed, of the substrate, and is disposed in both of the spaces between said processing electrode and the workpiece, and between said feeding electrode and the workpiece.
6. The electrolytic processing device according to 5, wherein said ion exchanger is stretched between a supply shaft and a rewind shaft, and is taken up sequentially.
7. The electrolytic processing device according to 6, wherein said processing electrode and said feeding electrode are mounted alternately on said ion exchanger at a given pitch along the length of said ion exchanger.
8. The electrolytic processing device according to 1, wherein said ion exchanger has water-absorbing properties.
9. The electrolytic processing device according to 1, wherein said ion exchanger has one or both of an anion-exchange ability and a cation-exchange ability.
10. The electrolytic processing device according to 1, wherein said ion exchanger is covered with a porous body.
11. The electrolytic processing device according to 1, further comprising a regeneration section for regenerating said ion exchanger.
12. An electrolytic processing device comprising:
   a processing electrode brought into contact with or close to a workpiece;
   a feeding electrode for supplying electricity to the workpiece;
   a power source for applying a voltage between said processing electrode and said feeding electrode; and
   a liquid supply section for supplying pure water or a liquid having an electric conductivity of not more than 500 µS/cm between the workpiece and said processing electrode.
13. The electrolytic processing device according to 2 or 12, wherein said pure water is ultrapure water.
14. The electrolytic processing device according to 1 or 12, wherein at least one of said processing electrode and said feeding electrode is in the shape of a flat rectangular plate.
15. The electrolytic processing device according to 1 or 12, wherein at least one of said processing electrode and said feeding electrode is in the shape of a column, and is disposed such that a central axis thereof is parallel to the surface, to be processed, of the workpiece.
16. The electrolytic processing device according to 1 or 12, wherein at least one of said processing electrode and said feeding electrode is in a spherical or oval spherical shape.
17. The electrolytic processing device according to 1 or 12, wherein at least one of said processing electrode and said feeding electrode has a depressed portion or a raised portion conforming to the configuration of the workpiece, and processing of the workpiece is conducted by allowing the workpiece to face said depressed portion or said raised portion.
18. The electrolytic processing device according to 1 or 12, wherein at least one of between said processing electrode and the workpiece, and between said feeding electrode and the workpiece make a relative movement.
19. The electrolytic processing device according to 18, wherein said relative movement is rotation, reciprocation, eccentric rotation or scroll movement, or a combination thereof.
20. The electrolytic processing device according to 1 or 12, wherein said processing electrode and said feeding electrode are disposed such that one of the electrodes surrounds the other.
21. The electrolytic processing device according to 1 or 12, wherein at least one of said processing electrode and said feeding electrode is in the shape of a fan.
22. The electrolytic processing device according to 1 or 12, wherein at least one of said processing electrode and said feeding electrode is disposed linearly or in a circle.
23. A substrate processing apparatus, comprising:
   a substrate carry-in and carry-out section for carrying in and carrying out a substrate;
   an electrolytic processing device; and
   a transport device for transporting the substrate between said substrate carry-in and carry-out section and said electrolytic processing device;
   wherein said electrolytic processing device comprises a processing electrode brought into contact with or close to a workpiece, a feeding electrode for supplying electricity to the workpiece, an ion exchanger disposed in at least one of a spaces between the workpiece and said processing electrode, and between the workpiece and said feeding electrode, a power source for applying a voltage between said processing electrode and said feeding electrode, and a liquid supply section for supplying a liquid to the space between the workpiece and at least one of said processing electrode and said feeding electrode, in which said ion exchanger is present.
24. A substrate processing apparatus, comprising:
   a substrate carry-in and carry-out section for carrying in and carrying out a substrate;
   an electrolytic processing device; and
   a transport device for transporting the substrate between said substrate carry-in and carry-out section and said electrolytic processing device;
   wherein said electrolytic processing device comprises a processing electrode brought into contact with or close to a workpiece, a feeding electrode for supplying electricity to the workpiece, a power source for applying a voltage between said processing electrode and said feeding electrode, and a liquid supply section for supplying pure water or a liquid having an electric conductivity of not more than 500 µS/cm between the workpiece and said processing electrode.
25. The substrate processing apparatus according to 23 or 24, further comprising a cleaning device for cleaning the processed substrate by said electrolytic processing device.
26. The substrate processing apparatus according to 23 or 24, further comprising a CMP device for chemical mechanical polishing the surface of the substrate.
27. The substrate processing apparatus according to 26, further comprising a cleaning device for cleaning the polished substrate by said CMP device.
28. The substrate processing apparatus according to 23 or 24, further comprising a film-forming device for forming a film as a portion to be processed in the surface of the substrate.
29. The substrate processing apparatus according to 28, further comprising at least one of a cleaning device for cleaning the portion to be processed having been formed by said film-forming device and an annealing device for annealing said portion to be processed.
30. The substrate processing apparatus according to 29, further comprising a bevel-etching device for etching the portion to be processed formed in or adhering to a peripheral portion of the substrate.
31. The substrate processing apparatus according to 30, wherein said etching of the portion to be processed in the bevel-etching device is conducted by electrolytic processing.
32. The substrate processing apparatus according to 26, further comprising a film thickness-measuring section for measuring a film thickness of the portion to be processed during or after the polishing in said CMP device.
33. The substrate processing apparatus according to 28, further comprising a film thickness-measuring section for measuring the film thickness of the portion to be processed during or after the film formation in the film-forming device.
34. The substrate processing apparatus according to 28, wherein the film formation in the film-forming device is conducted by plating.
35. The substrate processing apparatus according to 23 or 24, further comprising a monitor for monitoring at least one of electrolytic current and electrolytic voltage when the voltage is applied between said feeding electrode and said processing electrode.
36. The substrate processing apparatus according to 23 or 24, further comprising a drying device for finally drying the processed substrate.
37. The substrate processing apparatus according to 35, wherein said monitor further monitors a change in the state of the substrate being processed to detect the end point of processing.
38. The substrate processing apparatus according to 23 or 24, further comprising a film-thickness detection section for detecting the end point of processing.

## Claims

1. An electrolytic processing apparatus, comprising:
a processing electrode which can come close to or into contact with a workpiece;
a feeding/electrode for feeding electricity to the workpiece;
a laminate of a multi-layer structure disposed in at least one of the space between the workpiece and the processing electrode and the space between the workpiece and the feeding electrode;
a fluid supply section for supplying a fluid to the space between the workpiece and at least one of the processing and feeding electrodes in which the laminate is present; and
a power source for applying a voltage between the processing electrode and the feeding electrode.

2. The electrolytic processing apparatus according to claim 11, wherein said laminate includes in at least one layer an ion exchanger having at least one of a cation-exchange group and an anion-exchange group.

3. The electrolytic processing apparatus according to claim 1, wherein said laminate includes in at least one layer an water-permeable material.

4. The electrolytic processing apparatus according to claim 1, wherein said laminate has in at least one layer a material having a high hardness.

5. The electrolytic processing apparatus according to claim 1, wherein said laminate has a material having a high hardness at least in the outermost layer that contacts the workpiece.

6. The electrolytic processing apparatus according to claim 1, wherein said laminate has a material having a surface smoothness at least in the outermost layer that contacts the workpiece.

7. The electrolytic processing apparatus according to claim 1, wherein said laminate comprises in at least one layer a material selected from a woven cloth, a net, an ion-exchange membrane, and a polishing pad for chemical mechanical polishing.

8. An electrolytic processing method, comprising:
bringing a processing electrode into contact with or close to a workpiece while feeding electricity from a feeding electrode to the workpiece;
disposing a laminate of a multi-layer structure in at least one of the space between the workpiece and the processing electrode and the space between the workpiece and the feeding electrode;
supplying a fluid to.the space between the workpiece and at least one of the processing and feeding electrodes in which the laminate is present; and
applying a voltage between the processing electrode and the feeding electrode, thereby processing the surface of the workpiece.

9. The electrolytic processing method according to claim 8, wherein said laminate includes in at least one layer an ion exchanger having at least one of a cation-exchange group and an anion-exchange group.

10. The electrolytic processing method according to claim 8, wherein said laminate includes in at least one layer a water-permeable material.

11. The electrolytic processing method according to claim 8, wherein said laminate has in at least one layer a material having a high hardness.

12. The electrolytic processing method according to claim 8, wherein said laminate has a material having a high hardness at least in the outermost layer that contacts the workpiece.

13. The electrolytic processing method according to claim 8, wherein said laminate has a material having a surface smoothness at least in the outermost layer that contacts the workpiece.

14. The electrolytic processing method according to claim 8, wherein said laminate comprises in at least one layer a material selected from a woven Cloth, a net, an ion-exchange membrane, and a polishing pad for chemical mechanical polishing.
